(19) **Europäisches Patentamt European Patent Office Office européen des brevets**

(11) **EP 4 648 040 A1**

(12) **EUROPEAN PATENT APPLICATION**
published in accordance with Art. 153(4) EPC

(43) Date of publication:
**12.11.2025 Bulletin 2025/46**

(51) International Patent Classification (IPC):
**G09G 3/3225** (2016.01)

(21) Application number: **24810117.2**

(22) Date of filing: **19.04.2024**

(52) Cooperative Patent Classification (CPC):
**G09F 9/30; G09F 9/33; G09G 3/32; G09G 3/3225; H10K 59/12; H10K 59/131**

(86) International application number:
**PCT/CN2024/088817**

(87) International publication number:
**WO 2024/239870 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.05.2023 CN 202310582804**

(71) Applicants:
• **Boe Technology Group Co., Ltd.**
**Beijing 100015 (CN)**
• **Beijing BOE Technology Development Co., Ltd.**
**Beijing 100176 (CN)**

(72) Inventors:
• **ZHAO, Donghui**
**Beijing 100176 (CN)**
• **XU, Pan**
**Beijing 100176 (CN)**

• **HAN, Ying**
**Beijing 100176 (CN)**
• **ZHANG, Xing**
**Beijing 100176 (CN)**
• **LUO, Chengyuan**
**Beijing 100176 (CN)**
• **LV, Guangshuang**
**Beijing 100176 (CN)**
• **XU, Cheng**
**Beijing 100176 (CN)**
• **WANG, Hongli**
**Beijing 100176 (CN)**
• **WU, Tong**
**Beijing 100176 (CN)**
• **ZHOU, Dandan**
**Beijing 100176 (CN)**

(74) Representative: **Durán-Corretjer, S.L.P.**
**Còrsega, 329**
**(Paseo de Gracia/Diagonal)**
**08037 Barcelona (ES)**

(54) **DISPLAY SUBSTRATE AND DISPLAY APPARATUS**

(57) A display substrate and a display apparatus. The display substrate comprises: a substrate; the substrate comprises: a display area and a non-display area; the display area comprises: M sub-display areas, and the non-display area comprises: a circuit area and a fan-out area which are arranged in a second direction; the fan-out area comprises: M sub-fan-out areas. The display substrate further comprises: a plurality of sub-pixels and a first signal line which are located in the display area, a gate driver circuit and M initial signal lines located in the circuit area, and a fan-out wire located in the fan-out area. The gate driver circuit comprises: M driver circuits. The first signal line is electrically connected to gate electrodes of at least some transistors. The i-th drive circuit is electrically connected to the i-th initial signal line and a fan-out wire located in the i-th sub-fan-out area, and the fan-out wire located in the i-th sub-fan-out area is electrically connected to a first signal line located in the i-th sub-display area.

**(Cont. next page)**

EP 4 648 040 A1

200  100

202  201

DUGOA1

GOA1 { SGOA1  Fanout1  AA1

FL

SL

DDGOA1

DUGOA2

GOA2 { SGOA2  Fanout2  AA2

DDGOA2

......

DUGOA9

GOA9 { SGOA9  Fanout9  AA9

DDGOA9

D2

D1

FIG. 1

## Description

The present application claims the priority to Chinese Patent Application No. 202310582804.6, filed to the CNIPA on May 22, 2023 and entitled "Display Substrate and Display Apparatus", contents of which should be understood to be incorporated into the present application by reference.

Technical Field

The present disclosure relates to, but is not limited to, the field of display technologies, and particularly to a display substrate and a display apparatus.

Background

An Organic Light Emitting Diode (OLED for short) and a Quantum dot Light Emitting Diode (QLED for short) are active light emitting display devices and have advantages of self-illumination, a wide viewing angle, a high contrast ratio, low power consumption, an extremely high reaction speed, lightness and thinness, flexibility, and a low cost, etc. With constant development of display technologies, a flexible display apparatus (Flexible Display) in which an OLED or a QLED is used as a light emitting device and signal control is performed through a Thin Film Transistor (TFT for short) has become a mainstream product in the field of display at present.

Summary

The following is a summary of subject matter described in the present disclosure in detail. This summary is not intended to limit the protection scope of claims.

In a first aspect, the present disclosure provides a display substrate including: a base substrate, wherein the base substrate includes: a display region and a non-display region located on at least one side of the display region, the display region includes M sub-display regions, a first sub-display region to an M-th sub-display region are arranged sequentially along a first direction, and the non-display region includes a circuit region and a fanout region which are arranged along a second direction, the circuit region is located on a side of the fanout region away from the display region, the fanout region includes M sub-fanout regions, a first sub-fanout region to an M-th sub-fanout region are arranged sequentially along the first direction, the first direction intersects with the second direction, and M>1; the display substrate further includes: a plurality of sub-pixels and a first signal line which are located in the display region, a gate drive circuit and M initial signal lines which are located in the circuit region, and a fanout trace located in the fanout region, wherein the gate drive circuit includes M drive circuits, a first drive circuit to an M-th drive circuit are arranged sequentially along the first direction, the first signal line extends along the second direction, the initial signal lines extend along the first direction, and the fanout trace extends at least partially along the second direction; a sub-pixel includes: a pixel drive circuit including a plurality of transistors, and the first signal line is electrically connected with gate electrodes of at least some transistors; an i-th drive circuit is respectively electrically connected with an i-th initial signal line and a fanout trace located in an i-th sub-fanout region, and the fanout trace located in the i-th sub-fanout region is electrically connected with a first signal line located in an i-th sub-display region, wherein $1 \leq i \leq M$.

In an exemplary implementation mode, the sub-pixel includes: a first color sub-pixel, a second color sub-pixel, and a third color sub-pixel; wherein a sub-pixel in a (3m-2)-th row is a first color sub-pixel, a sub-pixel in a (3m-1)-th row is a second color sub-pixel, a sub-pixel in a 3m-th row is a third color sub-pixel, $1 \leq m \leq N/3$, and N is a total number of rows of sub-pixels in the display region.

In an exemplary implementation mode, at least one drive circuit includes: a first dummy drive circuit, an output drive circuit, and a second dummy drive circuit arranged sequentially along the first direction; a first dummy drive circuit of a j-th drive circuit is located on a side of an output drive circuit of the j-th drive circuit close to a (j-1)-th drive circuit, wherein $1<j \leq M$.

In an exemplary implementation mode, the first dummy drive circuit includes a plurality of cascaded first dummy shift registers, the output drive circuit includes a plurality of cascaded output shift registers, and the second dummy drive circuit includes a plurality of cascaded second dummy shift registers, and a first dummy shift register, an output shift register, and a second dummy shift register each includes an input terminal and an output terminal; for the i-th drive circuit, an input terminal of at least one stage first dummy shift register is electrically connected with the i-th initial signal line, an input terminal of at least one stage output shift register is electrically connected with an output terminal of the at least one stage first dummy shift register, and an output terminal of the at least one stage output shift register is electrically connected with an input terminal of at least one stage second dummy shift register.

In an exemplary implementation mode, for the i-th drive circuit, a quantity of the first dummy shift registers is Ri, a quantity of the output shift registers is Si, and a quantity of the second dummy shift registers is Ti; $Ri<Si$, $Ti<Si$, $Si=2Mi$,

wherein Mi is a quantity of rows of sub-pixels in the i-th sub-display region.

In an exemplary implementation mode, 4K clock signal lines located in the circuit region are further included, wherein K≥4, and K is an even number; the clock signal lines extend along the first direction, and the 4K clock signal lines are arranged along the second direction; Ri=4K or 12K, Ti=4K or 12K.

In an exemplary implementation mode, for the i-th drive circuit, for the i-th drive circuit, an output clock signal terminal of a (6p+1+4K*L)-th stage output shift register is electrically connected with a (2p+1)-th clock signal line, an output clock signal terminal of a (6p+3+4K*L)-th stage output shift register is electrically connected with a (2K+2p+1)-th clock signal line or a (2p+1-2K)-th clock signal line, an output clock signal terminal of a (6p+5+4K*L)-th stage output shift register is electrically connected with the (2p+1)-th clock signal line, an output clock signal terminal of a (6p+2+4K*L)-th stage output shift register is electrically connected with a (2p+2)-th clock signal line, an output clock signal terminal of a (6p+4+4K*L)-th stage output shift register is electrically connected with a (2K+2p+2)-th clock signal line or a (2p+2-2K)-th clock signal line, an output clock signal terminal of a (6p+6+4K*L)-th stage output shift register is electrically connected with the (2p+2)-th clock signal line, wherein 0≤L≤(Si/4K)-1, and 0≤p≤2K-1; when 2p+1<2K, the output clock signal terminal of the (6p+3+4K*L)-th stage output shift register is electrically connected with the (2K+2p+1)-th clock signal line, and an output clock signal terminal of a (6p+4)-th stage output shift register is electrically connected with the (2K+2p+2)-th clock signal line; and when 2p+1>2K, an output clock signal terminal of a (6p+3)-th stage output shift register is electrically connected with the (2p+1-2K)-th clock signal line, and an output clock signal terminal of a (6p+4)-th stage output shift register is electrically connected with the (2p+2-2K)-th clock signal line.

In an exemplary implementation mode, when Ri=4K, an output clock signal terminal of an r-th stage first dummy shift register is electrically connected with an r-th clock signal line, wherein 1≤r≤4K; when Ri=12K, an output clock signal terminal of a (6p+1)-th stage first dummy shift register is electrically connected with the (2p+1)-th clock signal line, an output clock signal terminal of a (6p+3)-th stage first dummy shift register is electrically connected with the (2K+2p+1)-th clock signal line or the (2p+1-2K)-th clock signal line, an output clock signal terminal of a (6p+5)-th stage first dummy shift register is electrically connected with the (2p+1)-th clock signal line, an output clock signal terminal of a (6p+2)-th stage first dummy shift register is electrically connected with the (2p+2)-th clock signal line, an output clock signal terminal of a (6p+4)-th stage first dummy shift register is electrically connected with the (2K+2p+2)-th clock signal line or the (2p+2-2K)-th clock signal line, and an output clock signal terminal of a (6p+6)-th stage first dummy shift register is electrically connected with the (2p+2)-th clock signal line; when 2p+1<2K, the output clock signal terminal of the (6p+3)-th stage first dummy shift register is electrically connected with the (2K+2p+1)-th clock signal line, and the output clock signal terminal of the (6p+4)-th stage first dummy shift register is electrically connected with the (2K+2p+2)-th clock signal line; when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

In an exemplary implementation mode, when Ti=4K, an output clock signal terminal of a t-th second dummy shift register is electrically connected with a t-th clock signal line, wherein 1≤t≤4K; when Ti=12K, an output clock signal terminal of a (6p+1)-th stage second dummy shift register is electrically connected with the (2p+1)-th clock signal line, an output clock signal terminal of a (6p+3)-th second dummy shift register is electrically connected with the (2K+2p+1)-th clock signal line or the (2p+1-2K)-th clock signal line, an output clock signal terminal of a (6p+5)-th stage second dummy shift register is electrically connected with the (2p+1)-th clock signal line, an output clock signal terminal of a (6p+2)-th stage second dummy shift register is electrically connected with the (2p+2)-th clock signal line, an output clock signal terminal of a (6p+4)-th second dummy shift register is electrically connected with the (2K+2p+2)-th clock signal line or the (2p+2-2K)-th clock signal line, and an output clock signal terminal of a (6p+6)-th second dummy shift register is electrically connected with the (2p+2)-th clock signal line; when 2p+1<2K, the output clock signal terminal of the (6p+3)-th stage second dummy shift register is electrically connected with the (2K+2p+1)-th clock signal line, and the output clock signal terminal of the (6p+4)-th stage second dummy shift register is electrically connected with the (2K+2p+2)-th clock signal line; when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

In an exemplary implementation mode, the first dummy shift register, the output shift register, and the second dummy shift register further includes an output clock signal terminal, the output clock signal terminal is configured to provide an output signal to the output terminal, and for the i-th drive circuit, the output drive circuit includes a first output drive circuit and a second output drive circuit; the first output drive circuit includes odd-numbered output shift registers arranged sequentially along the first direction, and output shift registers located in the first output drive circuit are cascaded with each other; the second output drive circuit includes even-numbered output shift registers arranged sequentially along the first direction, and output shift registers located in the second output drive circuit are cascaded with each other.

In an exemplary implementation mode, for the i-th drive circuit, a first stage output shift register to an Si-th output shift register are sequentially arranged along the first direction, a first stage first dummy shift register to an Ri-th first dummy shift register are sequentially arranged along the first direction, a first stage second dummy shift register to a Ti-th second dummy shift register are sequentially arranged along the first direction, and a first clock signal line to a 4K-th shift register are sequentially arranged along the second direction and are located on a side of the drive circuit away from the display region.

In an exemplary implementation mode, for the i-th drive circuit, an odd-number-th clock signal line is located on a side of the first output drive circuit away from the display region, and an even-number-th clock signal line is located on a side of the second output drive circuit away from the display region; when the first output drive circuit is located on the side of the second output drive circuit away from the display region, the even-number-th clock signal line is located between the first output drive circuit and the second output drive circuit; and when the second output drive circuit is located on the side of the first output drive circuit away from the display region, the odd-number-th clock signal line is located between the first output drive circuit and the second output drive circuit.

In an exemplary implementation mode, a display mode of a sub-display region includes a first display mode, a second display mode, and a third display mode, wherein a resolution of the first display mode is greater than a resolution of the second display mode, and the resolution of the second display mode is greater than a resolution of the third display mode; a clock signal of any one clock signal line includes a plurality of pulse signals, durations of pulse signals of any two clock signal lines are the same, periods of clock signals of any two clock signal lines are the same, and an occurrence time period of a pulse signal of a k-th clock signal line is overlapped with an occurrence time period of a pulse signal of a (k+1)-th clock signal line, wherein $1 \leq k \leq 4K$.

In an exemplary implementation mode, when the display mode of the sub-display region is the first display mode, there is no overlap between occurrence time periods of pulse signals of any two clock signal lines of all odd-numbered clock signal lines located on a side of a (2K+1)-th clock signal line away from the display region, there is no overlap between occurrence time periods of pulse signals of any two clock signal lines of all odd-numbered clock signal lines located on a side of a (2K-1)-th clock signal line close to the display region, there is no overlap between occurrence time periods of pulse signals of any two clock signal lines of all even-numbered clock signal lines located on a side of a (2K+2)-th clock signal line away from the display region, and there is no overlap between occurrence time periods of pulse signals of any two clock signal lines of all even-numbered clock signal lines located on a side of a 2K-th clock signal line close to the display region; when the display mode of the sub-display region is the second display mode, occurrence time periods of pulse signals of first K/2 clock signal lines of the all odd-numbered clock signal lines located on the side of the (2K+1)-th clock signal line away from the display region coincide, occurrence time periods of pulse signals of last K/2 clock signal lines of the all odd-numbered clock signal lines located on the side of the (2K+1)-th clock signal line away from the display region coincide, there is no overlap between occurrence time periods of pulse signals of a first clock signal line and the (K+1)-th clock signal line, occurrence time periods of pulse signals of first K/2 clock signal lines of the all odd-numbered clock signal lines located on the side of the (2K-1)-th clock signal line close to the display region coincide, occurrence time periods of pulse signals of last K/2 clock signal lines of the all odd-numbered clock signal lines located on the side of the (2K-1)-th clock signal line close to the display region coincide, there is no overlap between occurrence time periods of pulse signals of the (2K+1)-th clock signal line and a (3K+1)-th clock signal line, occurrence time periods of pulse signals of first K/2 clock signal lines of the all even-numbered clock signal lines located on the side of the (2K+2)-th clock signal line away from the display region coincide, occurrence time periods of pulse signals of last K/2 clock signal lines of the all even-numbered clock signal lines located on the side of the (2K+2)-th clock signal line away from the display region coincide, there is no overlap between occurrence time periods of pulse signals of a second clock signal line and a (K+2)-th clock signal line, and occurrence time periods of pulse signals of first K/2 clock signal lines of the all even-numbered clock signal lines located on the side of the 2K-th clock signal line close to the display region coincide, occurrence time periods of pulse signals of last K/2 clock signal lines of the all even-numbered clock signal lines located on the side of the 2K-th clock signal line close to the display region coincide, there is no overlap between occurrence time periods of pulse signals of the (2K+2)-th clock signal line and a (3K+2)-th clock signal line; when the display mode of the sub-display region is the third display mode, occurrence time periods of pulse signals of any two clock signal lines of the all odd-numbered clock signal lines located on the side of the (2K+1)-th clock signal line away from the display region coincide, occurrence time periods of pulse signals of any two clock signal lines of the all odd-numbered clock signal lines located on the side of the (2K-1)-th clock signal line close to the display region coincide, occurrence time periods of pulse signals of any two clock signal lines of the all even-numbered clock signal lines located on the side of the (2K+2)-th clock signal line away from the display region coincide, occurrence time periods of pulse signals of any two clock signal lines of the all even-numbered clock signal lines located on the side of the 2K-th clock signal line close to the display region coincide, and there is no overlap between an occurrence time period of a pulse signal of a y-th clock signal line and an occurrence time period of a pulse signal of a (2K+y)-th clock signal line, wherein $1 \leq y \leq 2K$.

In an exemplary implementation mode, quantities of rows of sub-pixels included in any two sub-display regions are the same; when display modes of the i-th sub-display region and an (i+1)-th sub-display region are both the first display mode, a start time $STU_i$ of a signal of an i-th initial signal line and a start time $STU_{i+1}$ of a signal of an (i+1)-th initial signal line satisfy a following relational expression: $STU_{i+1} = STU_i + (N/M)*T*ovl$; when the display modes of the i-th sub-display region and the (i+1)-th sub-display region are both the second display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/(M*A/B))*T*ovl$; when the display modes of the i-th sub-display region and the (i+1)-th sub-display region are both the third display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/(M*A/C))*T*ovl$; when a display mode of the i-th sub-display region is the first display mode and a display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/M)*T*ovl+(T1-T2)$; when the display mode of the i-th sub-display region is the first display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/M)*T*ovl+(T1-T3)$; when the display mode of the i-th sub-display region is the second display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/(M*A/B))*T*ovl-(T1-T2)$; when the display mode of the i-th sub-display region is the second display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/(M*A/B))*T*ovl+(T2-T3)$; when the display mode of the i-th sub-display region is the third display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression: $STU_{i+1}=STU_i+(N/(M*A/C))*T*ovl-(T1-T3)$; when the display mode of the i-th sub-display region is the third display mode and the display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression: $STU_{i+1}=STUi+(N/(M*A/C))*T*ovl-(T2-T3)$; wherein T is a duration of a pulse signal of any one clock signal line, ovl is an overlapping time of pulse signals of two adjacent clock signal lines, A is a quantity of clock signal lines with different signals in the first display mode, B is a quantity of clock signal lines with different signals in the second display mode, B<A, C is a quantity of clock signal lines with different signals in the third display mode, C<A, T1 is a period of a pulse signal of any one clock signal line in the first display mode, T2 is a period of a pulse signal of any one clock signal line in the second display mode, and T3 is a period of a pulse signal of any one clock signal line in the third display mode.

In an exemplary implementation mode, an occurrence time of an output signal of an output shift register connected with a last row of sub-pixels in the i-th sub-display region is overlapped with an occurrence time of an output signal of an output shift register connected with a first row of sub-pixels in the (i+1)-th sub-display region, and an overlapping time is half of a duration of the output signal of the output shift register connected with the last row of sub-pixels in the i-th sub-display region.

In an exemplary implementation mode, the first signal line includes a light emitting signal line, and for a same sub-display region, when u is a constant value, occurrence times when light emitting signal lines connected with pixel drive circuits of K rows of sub-pixels, in which K satisfies 3(u+*l*)+1, have effective level signals coincide, wherein u is an integer multiple of K, and $0\leq l\leq K-1$; when u is a constant value, occurrence times when light emitting signal lines connected with pixel drive circuits of K rows of sub-pixels, in which K satisfies 3(u+*l*)+2, have effective level signals coincide; when u is a constant value, occurrence times when light emitting signal lines connected with pixel drive circuits of K rows of sub-pixels, in which K satisfies 3(u+*l*)+3, have effective level signals coincide; an occurrence time when a light emitting signal line connected with a pixel drive circuit of a sub-pixel in a (3u+1)-th row has an effective level signal is earlier than an occurrence time when a light emitting signal line connected with a pixel drive circuit of a sub-pixel in a (3u+2)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3)-th row has an effective level signal, the occurrence time when the light emitting signal line connected with the pixel drive circuit of the sub-pixel in the (3u+1)-th row has the effective level signal is earlier than an occurrence time when a light emitting signal line connected with a pixel drive circuit of a sub-pixel in a (3u+3K+1)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3K+2)-th row has an effective level signal, and the occurrence time when the light emitting signal line connected with the pixel drive circuit of the sub-pixel in the (3u+3)-th row has the effective level signal is earlier than an occurrence time when a light emitting signal line connected with a pixel drive circuit of a sub-pixel in a (3u+3K+3)-th row has an effective level signal.

In an exemplary implementation mode, the first signal line includes a first scan signal line, a second scan signal line, a third scan signal line, and a light emitting signal line; pixel drive circuits of sub-pixels located in a same row are connected with a same second scan signal line, a same third scan signal line, and a same light emitting signal line, and the pixel drive circuits of the sub-pixels located in the same row are electrically connected with two first scan signal lines, a pixel drive circuit of a sub-pixel located in an n-th row and an s-th column is connected with a first first scan signal line, a pixel drive circuit of a sub-pixel located in the n-th row and an (s+1)-th column is connected with a second first scan signal line, an odd-number-th stage output shift register is electrically connected with the first scan signal line, and an even-number-th stage output shift register is electrically connected with the second first scan signal line, wherein 1≤n≤N, 1≤s≤S, and S is a total number of columns of sub-pixels in the display region.

In an exemplary implementation mode, a reference signal line, an initial signal line, and a first power supply line at least partially located in the display region are further included, wherein the reference signal line, the initial signal line, and the first power supply line extend along the second direction, and are electrically connected with first electrodes or second electrodes of some transistors in the pixel drive circuit; for a sub-pixel in an n-th row, a reference signal line, a second scan signal line, an initial signal line, a third scan signal line, a light emitting signal line, a first power supply line, a first scan signal line, and a second first scan signal line are sequentially arranged along the first direction, and the reference signal line is located on a side of the second scan signal line close to a sub-pixel in an (n-1)-th row.

In an exemplary implementation mode, a second signal line is further included, the second signal line is electrically connected with the pixel drive circuit, wherein the second signal line extends along the first direction; the second signal line includes a data signal line, a power supply connection line, a reference connection line, and an initial connection line, wherein the power supply connection line is electrically connected with the first power supply line, the reference connection line is electrically connected with the reference signal line, and the initial connection line is electrically connected with the initial signal line.

In an exemplary implementation mode, at least one fanout trace includes a first fanout connection portion, a second fanout connection portion, and a third fanout connection portion; wherein the first fanout connection portion, the second fanout connection portion, and the third fanout connection portion are sequentially arranged along the second direction, and the first fanout connection portion and the third fanout connection portion extend along the second direction; for an i-th sub-fanout region, the first fanout connection portion is respectively electrically connected with an output terminal of an output drive circuit of the i-th drive circuit and the second fanout connection portion, and the third fanout connection portion is respectively electrically connected with the first signal line of the i-th sub-display region and the second fanout connection portion; at least one sub-fanout region includes a first region and a second region arranged sequentially along the first direction, and an extension direction of a second fanout connection portion of a fanout trace located in the first region intersects with an extension direction of a second fanout connection portion of a fanout trace located in the second region; the fanout trace includes a first fanout trace, a second fanout trace, a third fanout trace, a fourth fanout trace, and a fifth fanout trace arranged along the first direction; the first fanout trace is electrically connected with a first first scan signal line, the second fanout trace is electrically connected with a second first scan signal line, the third fanout trace is electrically connected with a second scan signal line, the fourth fanout trace is electrically connected with a third scan signal line, and the fifth fanout trace is electrically connected with a light emitting signal line.

In an exemplary implementation mode, a reference signal electrical power supply line and a first power source electrical power supply line located in the fanout region are further included, wherein the first power source electrical power supply line is located on a side of the reference signal electrical power supply line close to the display region, and the reference signal electrical power supply line and the first power source electrical power supply line extend along the first direction; an orthographic projection of the reference signal electrical power supply line on the base substrate is at least partially overlapped with an orthographic projection of the third fanout connection portion of the at least one fanout trace on the base substrate, and an orthographic projection of the first power source electrical power supply line on the base substrate is at least partially overlapped with the orthographic projection of the third fanout connection portion of the at least one fanout trace on the base substrate.

In an exemplary implementation mode, the reference signal electrical power supply line includes: a first sub-reference signal electrical power supply line and a second sub-reference signal electrical power supply line disposed in different layers and electrically connected with each other; an orthographic projection of the first sub-reference signal electrical power supply line on the base substrate is at least partially overlapped with an orthographic projection of the second sub-reference signal electrical power supply line on the base substrate; the first sub-reference signal electrical power supply line is provided with a plurality of first openings, the second sub-reference signal electrical power supply line is provided with a plurality of second openings, and the first power source electrical power supply line is provided with a plurality of third openings; an orthographic projection of at least one of a first opening and a second opening on the base substrate is at least partially overlapped with the orthographic projection of the third fanout connection portion on the base substrate, and an orthographic projection of a third opening on the base substrate is at least partially overlapped with the orthographic projection of the third fanout connection portion on the base substrate.

In an exemplary implementation mode, a circuit structure layer disposed on the base substrate is further included, wherein the circuit structure layer includes a first conductive layer, a second conductive layer, a third conductive layer, and a fourth conductive layer, wherein the pixel drive circuit further includes a capacitor, and the capacitor includes a first electrode plate and a second electrode plate; the first conductive layer at least includes gate electrodes of the plurality of transistors and the first electrode plate of the capacitor; the second conductive layer at least includes the second electrode plate of the capacitor and the first sub-reference electrical power supply line; the third conductive layer at least includes the first scan signal line, the second scan signal line, the third scan signal line, the light emitting signal line, the initial signal line, the reference signal line, the first power supply line, the second sub-reference electrical power supply line, and the first power source electrical power supply line; the fourth conductive layer at least includes the data signal line, the fanout trace, the power supply connection line, the reference connection line, and the initial connection line.

In a second aspect, the present disclosure also provides a display apparatus, including: the display substrate described above.

Other aspects may be comprehended after drawings and detailed description are read and understood.

Brief Description of Drawings

Accompanying drawings are used to provide understanding of technical solutions of the present disclosure, and form a part of the specification. The accompanying drawings, together with embodiments of the present disclosure, are used to explain the technical solutions of the present disclosure, and do not form limitations on the technical solutions of the present disclosure.

FIG. 1 is a schematic diagram of a structure of a display substrate provided in an embodiment of the present disclosure.
FIG. 2 is a schematic diagram of partitions of the display substrate provided in FIG. 1.
FIG. 3 is a schematic diagram of an arrangement of sub-pixels in a display substrate.
FIG. 4A is an equivalent circuit diagram of a pixel drive circuit.
FIG. 4B is a working timing diagram of the pixel drive circuit provided in FIG. 4A.
FIG. 5A is an equivalent circuit diagram of a shift register.
FIG. 5B is a working timing diagram of the shift register provided in FIG. 5A.
FIG. 6 is a first schematic diagram of a structure of an output drive circuit of an i-th drive circuit.
FIG. 7 is a second schematic diagram of a structure of an output drive circuit of an i-th drive circuit.
FIG. 8 is a first schematic diagram of a structure of a first dummy drive circuit.
FIG. 9 is a first schematic diagram of a structure of a second dummy drive circuit.
FIG. 10 is a second schematic diagram of a structure of a first dummy drive circuit.
FIG. 11 is a second schematic diagram of a structure of a second dummy drive circuit.
FIG. 12 is a third schematic diagram of a structure of a first dummy drive circuit.
FIG. 13 is a third schematic diagram of a structure of a second dummy drive circuit.
FIG. 14 is a fourth schematic diagram of a structure of a first dummy drive circuit.
FIG. 15 is a fourth schematic diagram of a structure of a second dummy drive circuit.
FIG. 16 is a schematic diagram of signals of a plurality of clock signal lines in a sub-display region in a first display mode.
FIG. 17 is a schematic diagram of signals of a plurality of clock signal lines in a sub-display region in a second display mode.
FIG. 18 is a schematic diagram of signals of a plurality of clock signal lines in a sub-display region in a third display mode.
FIG. 19 is a first schematic diagram of comparison between output signals of output shift registers connected with last eight rows of sub-pixels in an i-th sub-display region and output signals of output shift registers connected with first eight rows of sub-pixels in an (i+1)-th sub-display region.
FIG. 20 is a second schematic diagram of comparison between the output signals of output shift registers connected with the last eight rows of sub-pixels in the i-th sub-display region and the output signals of output shift registers connected with the first eight rows of sub-pixels in the (i+1)-th sub-display region.
FIG. 21 is a third schematic diagram of comparison between the output signals of output shift registers connected with the last eight rows of sub-pixels in the i-th sub-display region and the output signals of output shift registers connected with the first eight rows of sub-pixels in the (i+1)-th sub-display region.
FIG. 22 is a fourth schematic diagram of comparison between the output signals of output shift registers connected with the last eight rows of sub-pixels in the i-th sub-display region and the output signals of output shift registers connected with the first eight rows of sub-pixels in the (i+1)-th sub-display region.
FIG. 23 is a fifth schematic diagram of comparison between the output signals of output shift registers connected with the last eight rows of sub-pixels in the i-th sub-display region and the output signals of output shift registers connected with the first eight rows of sub-pixels in the (i+1)-th sub-display region.
FIG. 24 is a sixth schematic diagram of comparison between the output signals of output shift registers connected with the last eight rows of sub-pixels in the i-th sub-display region and the output signals of output shift registers connected with the first eight rows of sub-pixels in the (i+1)-th sub-display region.
FIG. 25 is a seventh schematic diagram of comparison between the output signals of output shift registers connected with the last eight rows of sub-pixels in the i-th sub-display region and the output signals of output shift registers connected with the first eight rows of sub-pixels in the (i+1)-th sub-display region.

FIG. 26 is a first partial schematic diagram of a display region.

FIG. 27 is a schematic diagram of a part of a film layer of a display region.

FIG. 28 is a schematic diagram of a structure of a fanout trace.

FIG. 29 is a schematic diagram of a structure of a non-display region.

FIG. 30 is a first schematic diagram of a part of a film layer of a non-display region.

FIG. 31 is a second schematic diagram of a part of a film layer of a non-display region.

Detailed Description

To make objectives, technical solutions, and advantages of the present disclosure clearer, the embodiments of the present disclosure will be described in detail below with reference to the accompanying drawings. It is to be noted that implementation modes may be implemented in multiple different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments in the present disclosure may be randomly combined with each other if there is no conflict. In order to keep following description of the embodiments of the present disclosure clear and concise, detailed description of part of known functions and known components are omitted in the present disclosure. The drawings of the embodiments of the present disclosure only involve structures involved in the embodiments of the present disclosure, and for other structures, reference may be made to conventional designs.

In the accompanying drawings, a size of each constituent element, a thickness of a layer, or a region may be exaggerated sometimes for clarity. Therefore, one mode of the present disclosure is not necessarily limited to the size, and a shape and a size of each component in the drawings do not reflect an actual scale. In addition, the accompanying drawings schematically illustrate ideal examples, and one mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that a referred apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a connection at a constant value, or a detachable connection, or an integrated connection; it may be a mechanical connection, or an electrical connection; it may be a direct connection, or indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulation film" may be replaced with an "insulation layer" sometimes.

In the specification, "disposed in a same layer" adopted refers to a structure formed by patterning two (or more than two) structures through a same patterning process, and their materials may be the same or different. For example, materials of precursors for forming multiple structures disposed in a same layer are the same, and final materials may be the same or different.

A triangle, rectangle, trapezoid, pentagon, or hexagon, etc. in the specification is not strictly defined, and it may be an approximate triangle, rectangle, trapezoid, pentagon, or hexagon, etc. There may be some small deformations caused by tolerance, and there may be a chamfer, an arc edge, deformation, etc.

In the present disclosure, "about" means that a boundary is not defined so strictly and numerical values within process and measurement error ranges are allowed.

Ultra-high resolution display products may realize three-dimensional display, which makes visual perception more abundant and has a wide range of applications. At present, ultra-high resolution display products are unable to switch clarity, resulting in a relatively simple visual perception.

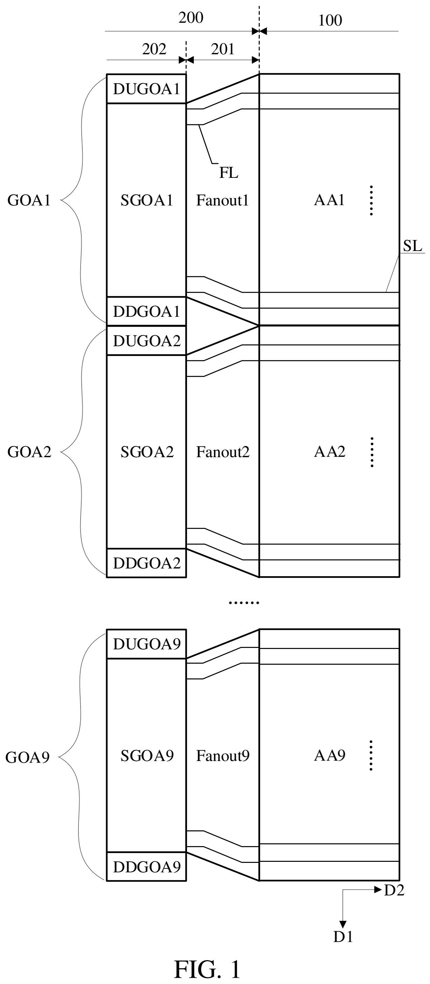

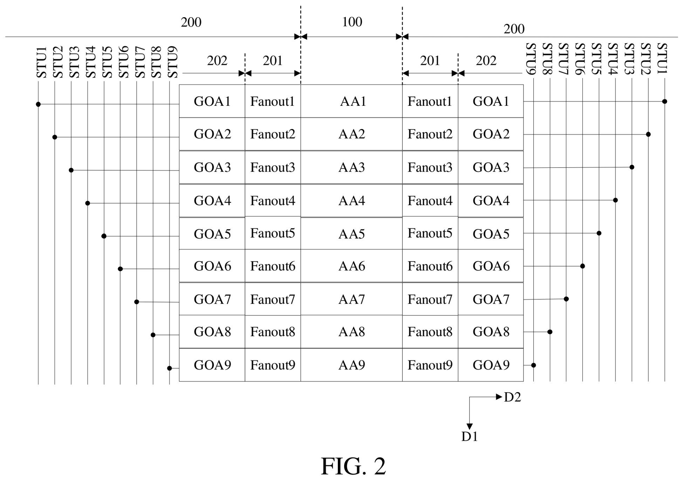

FIG. 1 is a schematic diagram of a structure of a display substrate provided in an embodiment of the present disclosure, and FIG. 2 is a schematic diagram of partitions of the display substrate provided in FIG. 1. As shown in FIGs. 1 and 2, the display substrate provided in the embodiment of the present disclosure may include a base substrate including a display region 100 and a non-display region 200 located on at least one side of the display region 100, wherein the display region 100 includes M sub-display regions, a first sub-display region AA1 to an M sub-display region AAM arranged sequentially along a first direction D1, and the non-display region 200 includes a fanout region 201 and a circuit region 202 arranged along a second direction D2, wherein the circuit region 202 is located on a side of the fanout region 201 away from the display region 100, the fanout region 201 includes M sub-fanout regions, a first sub-fanout region Fanout1 to an M-th sub-fanout region FanoutM are arranged sequentially along the first direction D1, the first direction D1 intersects with the second direction D2, and M>1. FIGs. 1 and 2 are illustrated by taking M=9 as an example, and the present disclosure is not limited thereto.

In an exemplary implementation mode, as shown in FIGs. 1 and 2, the display substrate further includes a plurality of sub-pixels and a first signal line SL located in the display region 100, a gate drive circuit and M initial signal lines located in the circuit region 202, and a fanout trace FL located in the fanout region 201, wherein the gate drive circuit includes M drive circuits, a first drive circuit GOA1 to an M-th drive circuit GOAM are arranged sequentially along the first direction D1, the first signal line SL extends along the second direction D2, the initial signal lines extend along the first direction D1, and the fanout trace FL extends at least partially along the second direction D2. FIG. 2 is illustrated by taking initial signal lines STU1 to STU9 as an example.

In an exemplary implementation mode, a sub-pixel may include a pixel drive circuit including a plurality of transistors, and the first signal line is electrically connected with gate electrodes of at least some of the transistors.

In an exemplary implementation mode, an i-th drive circuit GOAi is respectively electrically connected with an i-th initial signal line STUi, a fanout trace FL located in an i-th sub-fanout region Fanouti, and is connected with a first signal line SL located in an i-th sub-display region AAi, wherein 1≤i≤M.

In an exemplary implementation mode, the display substrate may be an OLED display substrate.

In an exemplary implementation mode, the base substrate may be a rigid base substrate or a flexible base substrate, wherein the rigid base substrate may be, but is not limited to, one or more of glass and conductive foil. The flexible base substrate may be, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber.

In an exemplary implementation mode, a shape of the display region may be a square or a rounded rectangle, or may also be other shapes, which is not limited in the present disclosure.

In an exemplary implementation mode, a quantity of rows of sub-pixels included in different sub-display regions may be the same or different, the present disclosure is not limited thereto.

In an exemplary implementation mode, the display region 100 includes a first side and a second side disposed opposite to each other, and the first side and the second side are arranged along the second direction, and the gate drive circuit may be located on at least one of the first side and the second side. FIG. 2 is illustrated by taking an example in which the gate drive circuit is located on the first side and the second side.

In the present disclosure, the i-th drive circuit GOAi, is electrically connected with the i-th initial signal line STUi, and is electrically connected with the first signal line SL located in the i-th sub-display region AAi through the fanout trace FL located in the i-th sub-fanout region Fanouti, that is, different drive circuits are connected with different initial signal lines, and different drive circuits are not cascaded, thereby realizing separate control of different sub-display regions. An arrangement of a fanout region and a fanout trace may play a role of connecting the gate drive circuit and a sub-display region.

In an exemplary implementation mode, an ultra-high resolution display product includes X rows and Y columns of pixel units, and at least one pixel unit may include a first pixel, a second pixel, and a third pixel arranged along the first direction, and each pixel includes Z sub-pixels arranged along the second direction, that is to say, the ultra-high resolution display product includes 3X rows of sub-pixels and Y*Z columns of sub-pixels. Exemplarily, when X=2160, Y=3840, Z=11, $2160 \times 3$ rows and $3840 \times 11$ columns of sub-pixels are included in the ultra-high resolution display product. Among them, when Z is greater than 1, the ultra-high resolution display product may realize three-dimensional display.

The display substrate provided in the embodiment of the present disclosure includes: a base substrate, wherein the base substrate includes: a display region and a non-display region located on at least one side of the display region, the display region includes M sub-display regions, a first sub-display region to an M-th sub-display region are arranged sequentially along a first direction, and the non-display region includes a circuit region and a fanout region arranged along a second direction, the circuit region is located on a side of the fanout region away from the display region, the fanout region includes M sub-fanout regions, a first sub-fanout region to an M-th sub-fanout region are arranged sequentially along the first direction, the first direction intersects with the second direction, and M>1; the display substrate further includes: a plurality of sub-pixels and a first signal line located in the display region, a gate drive circuit and M initial signal lines located in the circuit region, and a fanout trace located in the fanout region, wherein the gate drive circuit includes M drive circuits, a first drive circuit to an M-th drive circuit are arranged sequentially along the first direction, the first signal line extends along the second direction, the initial signal lines extend along the first direction, and the fanout trace extends at least partially along the second direction; a sub-pixel includes: a pixel drive circuit including a plurality of transistors, and the first signal line is electrically connected with gate electrodes of at least some of the transistors; an i-th drive circuit is respectively electrically connected with an i-th initial signal line and a fanout trace located in an i-th sub-fanout region, and the fanout trace located in the i-th sub-fanout region is electrically connected with a first signal line located in an i-th sub-display region, wherein $1 \leq i \leq M$. In the present disclosure, different initial signal lines are connected through different drive circuits to realize separate control of different sub-display regions, and local definition switching of the display substrate may be realized. In addition, an arrangement of a fanout region and a fanout trace may connect a gate drive circuit and a display region when a dummy shift register is included in the gate drive circuit.

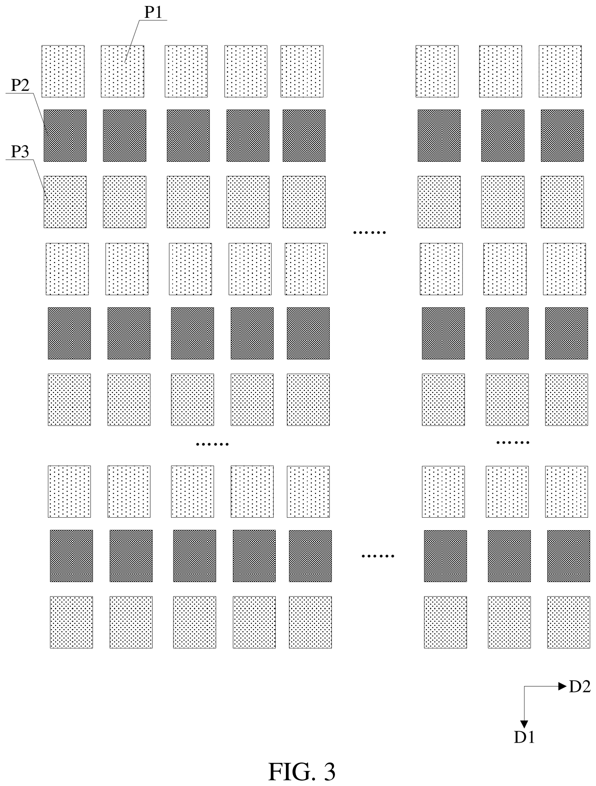

In an exemplary implementation mode, FIG. 3 is a schematic diagram of an arrangement of sub-pixels in a display substrate. As shown in FIG. 3, the sub-pixels may include first color sub-pixels P1, second color sub-pixels P2, and third color sub-pixels P3. Herein, sub-pixels of a (3m-2)-th row are first color sub-pixels P1, sub-pixels of a (3m-1)-th row are second color sub-pixels P2, sub-pixels of a 3m-th row are third color sub-pixels P3, $1 \leq m \leq N/3$, and N is a total number of rows of sub-pixels in the display region. Exemplarily, sub-pixels of a first row, sub-pixels of a fourth row, sub-pixels of a seventh row, sub-pixels of a tenth row, and the like are first color sub-pixels. Sub-pixels of a second row, sub-pixels of a fifth row, sub-pixels of an eighth row, sub-pixels of an eleventh row, and the like are second color sub-pixels. And sub-pixels of a third row, sub-pixels of a sixth row, sub-pixels of a ninth row, sub-pixels of a twelfth row, and the like are third color sub-pixels.

In an exemplary implementation mode, a first color, a second color, and a third color are different colors and are one of red, blue, and green. The first color may be red, the second color may be blue, and the third color may be green, and the present disclosure is not limited thereto.

In an exemplary implementation mode, a sub-pixel may be in a shape of a rectangle, a rhombus, a pentagon, or a hexagon. Three sub-pixels may be arranged side by side horizontally, side by side vertically, or in a manner of a Chinese character "品", the present disclosure is not limited thereto.

In an exemplary implementation mode, the sub-pixel further includes a light emitting device electrically connected with a pixel drive circuit. The pixel drive circuit is configured to drive the light emitting device to emit light.

In an exemplary implementation mode, the light emitting device may be an Organic Light Emitting Diode (OLED), including a first electrode (anode), an organic emitting layer, and a second electrode (cathode), which are stacked.

In an exemplary implementation mode, the organic emitting layer may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL) that are stacked. In an exemplary implementation mode, hole injection layers of all sub-pixels may be connected together to be a common layer, electron injection layers of all the sub-pixels may be connected together to be a common layer, hole transport layers of all the sub-pixels may be connected together to be a common layer, electron transport layers of all the sub-pixels may be connected together to be a common layer, hole block layers of all the sub-pixels may be connected together to be a common layer, emitting layers of adjacent sub-pixels may be overlapped slightly or may be isolated, and electron block layers of adjacent sub-pixels may be overlapped slightly or may be isolated.

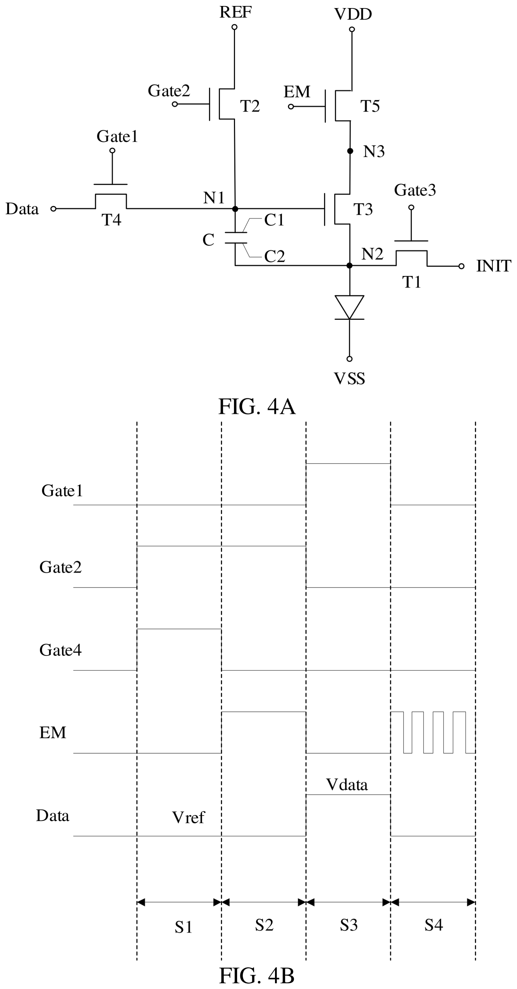

FIG. 4A is an equivalent circuit diagram of a pixel drive circuit. In an exemplary implementation mode, the pixel drive circuit may have a structure of 3T1C, 4T1C, 5T1C, 5T2C, 6T1C, 7T1C, or 8T1C. As shown in FIG. 4A, the pixel circuit may include five transistors (a first transistor T1 to a fifth transistor T5), and one capacitor C. Herein, the capacitor C may include a first electrode plate C1 and a second electrode plate C2.

In an exemplary implementation mode, as shown in FIG. 4A, a gate electrode of the first transistor T1 is electrically connected with a third scan signal line Gate3, a first electrode of the first transistor T1 is electrically connected with an initial signal line INIT, and a second electrode of the first transistor T1 is electrically connected with a second node N2; a gate electrode of the second transistor T2 is electrically connected with a second scan signal line Gate2, a first electrode of the second transistor T2 is electrically connected with a reference signal line REF, and a second electrode of the second transistor T2 is electrically connected with a first node N1; a gate electrode of a third transistor T3 is electrically connected with the first node N1, a first electrode of the third transistor T3 is electrically connected with the second node N2, and a second electrode of the third transistor T3 is electrically connected with a third node N3; a gate electrode of a fourth transistor T4 is electrically connected with a first scan signal line Gate1, a first electrode of the fourth transistor T4 is electrically connected with a data signal line Data, and a second electrode of the fourth transistor T4 is electrically connected with the first node N1; a gate electrode of the fifth transistor T5 is electrically connected with a light emitting signal line EM, a first electrode of the fifth transistor T5 is electrically connected with a first power supply line VDD, and a second electrode of the fifth transistor T5 is electrically connected with the third node N3; the first electrode plate C1 of the capacitor C is electrically connected with the first node N1, and the second electrode plate C2 of the capacitor C is electrically connected with the second node N2.

In an exemplary implementation mode, a light emitting device L may be electrically connected with the second node N2 and a second power supply line VSS, respectively. Herein, a first electrode of the light emitting device L is electrically connected with the second node N2, and a second electrode of the light emitting device L is electrically connected with the second power supply line VSS.

In an exemplary implementation mode, for the light emitting device, which includes a current-driven device, a current-type light emitting diode, such as a micro Light Emitting Diode (Micro LED), or a mini Light Emitting Diode (Mini LED), or an Organic Light Emitting Diode (OLED), or a Quantum dot Light Emitting Diode (QLED) may be adopted. A typical size (e.g., length) of a Micro LED may be less than 100 $\mu$m, e.g., 10 $\mu$m to 50 $\mu$m. A typical size (e.g., length) of a Mini LED may be about 100 $\mu$m to 300 $\mu$m, e.g., 120 $\mu$m to 260 $\mu$m.

In an exemplary implementation mode, the first transistor T1 may be referred to as an anode reset transistor, and when a signal of the third scan signal line Gate3 is an effective level signal, an initial signal of the initial signal line INIT is written into the first electrode of the light emitting device L, so as to initialize the first electrode of the light emitting device L.

In an exemplary implementation mode, the second transistor T2 may be referred to as a node reset transistor, and when a signal of the second scan signal line Gate2 is an effective level signal, a signal of the reference signal line REF is written into the first node N1, so as to initialize a signal of the first node N1.

In an exemplary implementation mode, the third transistor T3 may be referred to as a drive transistor, and the third transistor T3 determines a drive current flowing between the first power supply line VDD and the second power supply line VSS according to a potential difference between the gate electrode and the second electrode of the third transistor T3.

In an exemplary implementation mode, the fourth transistor T4 may be referred to as a writing transistor, which writes an initial signal of the data signal line Data into the second node N2 when a signal of the first scan signal line Gate1 is an effective level signal.

In an exemplary implementation mode, the fifth transistor T5 may be referred to as a light emitting transistor. When a signal of the light emitting signal line EM is an effective level signal, the fifth transistor T5 enables the light emitting device to emit light by forming a drive current path between the first power supply line VDD and the second power supply line VSS.

Transistors may be classified as N-type transistors and P-type transistors according to characteristics of the transistors. When a transistor is a P-type transistor, a turn-on voltage is a low-level voltage (e.g., 0 V, -5 V, -10 V, or another suitable voltage), and a turn-off voltage is a high-level voltage (e.g., 5 V, 10 V, or another suitable voltage). When a transistor is an N-type transistor, a turn-on voltage is a high-level voltage (e.g., 5 V, 10 V, or another suitable voltage), and a turn-off voltage is a low-level voltage (e.g., 0 V, -5 V, -10 V, or another suitable voltage).

In an exemplary implementation mode, for the first transistor T1 to the fifth transistor T5, low temperature poly silicon thin film transistors may be adopted, or oxide thin film transistors may be adopted, or both a low temperature poly silicon thin film transistor and an oxide thin film transistor may be adopted. An active layer of a low temperature poly silicon thin film transistor is made of Low Temperature Poly Silicon (LTPS for short), and an active layer of an oxide thin film transistor is made of an oxide semiconductor (Oxide). The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display substrate to form a LTPS + Oxide (LTPO) display substrate, and advantages of both the low temperature poly silicon thin film transistor and the oxide thin film transistor may be utilized, which may achieve low frequency drive, reduce power consumption, and improve display quality.

In an exemplary implementation mode, transistors of the first transistor T1 to the fifth transistor T5 may be N-type transistors.

In an exemplary implementation mode, the first power supply line VDD continuously provides a high-level signal, which is a constant voltage signal, the second power supply line VSS continuously provides a low-level signal, and the initial signal line INIT provides a constant voltage signal.

In an exemplary implementation mode, a voltage value of a signal of the initial signal line INIT may be smaller than a voltage value of a signal of the second power supply line VSS, which may avoid false light emission of the light emitting device.

FIG. 4B is a working timing diagram of the pixel drive circuit provided in FIG. 4A. An exemplary embodiment of the present disclosure is described below through a working process of the pixel drive circuit illustrated in FIG. 4A in a display phase. FIG. 4B is illustrated by taking a case that the first transistor T1 to the fifth transistor T5 are N-type transistors as an example, and the pixel drive circuit in FIG. 4B includes the first transistor T1 to the fifth transistor T5, one capacitor C, and eight signal lines (a data signal line Data, a first scan signal line Gate1, a second scan signal line Gate2, a third scan signal line Gate3, an initial signal line INIT, a reference signal line REF, a light emitting signal line EM, and a first power supply line VDD).

In conjunction with FIGs. 4A and 4B, the working process of the pixel drive circuit may include following phases.

In a first phase P1, referred to as an initialization phase, signals of the second scan signal line Gate2 and the third scan signal line Gate3 are high-level signals, and signals of the first scan signal line Gate1 and the light emitting signal line EM are low-level signals. A signal of the second scan signal line Gate2 is a high-level signal, the second transistor T2 is turned on, and a signal of the reference signal line REF is written into the first node N1 through the turned-on second transistor T2, so as to initialize a signal of the first node N1. At this time, a voltage value of the signal of the first node N1 is V1=Vref, and Vref is a voltage value of the signal of the reference signal line REF. A signal of the third scan signal line Gate3 is a high-level signal, the first transistor T1 is turned on, and a signal of the initial signal line INIT is written into the second node N2, so as to initialize (reset) the first electrode of the light emitting device L, empty a pre-stored voltage inside the light emitting device L to complete initialization. At this time, a voltage value of a signal of the second node N2 is V2=Vinit, and Vinit is a voltage value of a signal of the initial signal line INIT. In this phase, since the voltage value of the signal of the initial signal line INIT may be smaller than a voltage value of a signal of the second power supply line VSS, the light emitting device L does not emit light.

In a second phase P2, referred to as a threshold compensation phase, signals of the second scan signal line Gate2 and the light emitting signal line EM are high-level signals, and signals of the first scan signal line Gate1 and the third scan signal line Gate3 are low-level signals. A signal of the second scan signal line Gate2 is a high-level signal, the second transistor T2 is turned on, and a signal of the reference signal line REF is continuously written into the first node N1 through the turned-on second transistor T2. At this time, a voltage value of a signal of the first node N1 is V1=Vref. A signal of the light emitting signal line EM is a high-level signal, the fifth transistor T5 is turned on, a signal of the first power supply line VDD is written into the second node N2 through the turned-on fifth transistor T5, the third node N3, and the turned-on third transistor T3 until a voltage of a signal of the second node N2 is V2=Vref-Vth, Vth is a threshold voltage of the third transistor T3. At this time, a voltage value of a signal of the third node N3 is V3=Vvdd, Vvdd is a voltage value of the signal of the first power supply line VDD, and the capacitor C stores a voltage difference Vth of signals of the first node N1 and the second node N2. The light emitting device L does not emit light in this phase.

In a third phase S3, referred to as a data writing phase, a signal of the first scan signal line Gate1 is a high-level signal, signals of the second scan signal line Gate2, the third scan signal line Gate3, and the light emitting signal line EM are low-level signals, and the data signal line Data outputs a data signal. A signal of the first scan signal line Gate1 is a high-level signal, the fourth transistor T4 is turned on, and a data signal of the data signal line Data is written into the first node N1 through the turned-on fourth transistor T4. At this time, a voltage value of the signal of the first node N1 is V1=Vdata, Vdata is a voltage value of the data signal, and the signal of the first node N1 jumps from the voltage value of a present phase to the voltage value of a previous phase, so that the signal of the second node N2 also jumps under an action of the capacitor C. At this time, a voltage value of the signal of the second node N2 is V2=Vref-Vth+$\alpha$(Vdata-Vref). The light emitting device L does not emit light in this phase.

In a fourth phase S4, referred to as a light emitting phase, a signal of the light emitting signal line EM is a high-level signal, and signals of the first scan signal line Gate1, the second scan signal line Gate2, and the third scan signal line Gate3 are low-level signals. The signal of the light emitting signal line EM is a high-level signal, the fifth transistor T5 is turned on, and a signal of the first power supply line VDD provides a drive current to the first electrode of the light emitting device L through the turned-on fifth transistor T5, the third node N3, and the turned-on third transistor T3, so as to drive the light emitting device L to emit light.

In a driving process of the pixel drive circuit, the drive current flowing through the third transistor T3 (the drive transistor) is determined by a voltage difference between the gate electrode (also the first node N1) and the second electrode (also the second node N2). Since the voltage value of the signal of the first node N1 is V1=Vdata, and the voltage value of the signal of the second node N2 is V2=Vref-Vth+$\alpha$(Vdata-Vref), the drive current of the third transistor T3 is as

follows.

$$I=K*(Vgs-Vth)^2=K*[(Vdata-Vref+Vth-\alpha(Vdata-Vref))-Vth]^2=K*[(1-\alpha)(Vdata-Vref)]^2$$

Herein, I is the drive current flowing through the third transistor T3, that is, a drive current for driving the light emitting device L, K is a constant, and Vgs is the voltage difference between the gate electrode and the second electrode of the third transistor T3.

In an exemplary implementation mode, the signal of the light emitting signal line EM may be a high-level signal or may be a low-level signal in the third phase. FIG. 4B is illustrated by taking a case that the signal of the light emitting signal line EM is a low-level signal in the third phase as an example. When a data signal line is used by a pixel drive circuit alone, the signal of the light emitting signal line EM may be a high-level signal or a low-level signal in the third phase. When the data signal line is common to adjacent pixel drive circuits, the signal of the light emitting signal line EM is a low-level signal in the third phase, otherwise display of different pixel drive circuits is uneven.

In an exemplary implementation mode, the signal of the light emitting signal line EM may be a high-level signal continuously in the fourth phase S4, or may be a periodic pulse signal. When the signal of the light emitting signal line EM is continuously a high-level signal in the fourth phase S4, the light emitting device continuously emits light. When the signal of the light emitting signal line EM is a periodic pulse signal in the fourth phase S4, it may be used for pulse width modulation of light, that is, the light emitting device does not emit light continuously, but lights up and lights off unceasingly.

In an exemplary implementation mode, as shown in FIG. 1, at least one drive circuit includes a first dummy drive circuit, an output drive circuit, and a second dummy drive circuit arranged sequentially along the first direction D1. Herein, an i-th drive circuit GOAi may include a first dummy drive circuit DUGOAi, an output drive circuit SGOAi, and a second dummy drive circuit DDGOAi.

In an exemplary implementation mode, as shown in FIG. 1, a first dummy drive circuit DUGOAj of a j-th drive circuit is located on a side of an output drive circuit SGOAj of the j-th drive circuit close to a (j-1)-th drive circuit, wherein $1<j\leq M$.

In an exemplary implementation mode, the first dummy drive circuit may include a plurality of cascaded first dummy shift registers, the output drive circuit may include a plurality of cascaded output shift registers, and the second dummy drive circuit may include a plurality of cascaded second dummy shift registers, and a first dummy shift register, an output shift register, and a second dummy shift register each includes an input terminal and an output terminal.

In an exemplary implementation mode, for the i-th drive circuit, an input terminal of at least one stage first dummy shift register is electrically connected with an i-th initial signal line, an input terminal of at least one stage output shift register is electrically connected with an output terminal of the at least one stage first dummy shift register, and an output terminal of the at least one stage output shift register is electrically connected with an input terminal of at least one stage second dummy shift register.

In an exemplary implementation mode, for the i-th drive circuit, there is a cascade relationship between the first dummy drive circuit and the output drive circuit, and there is a cascade relationship between the output drive circuit and the second dummy drive circuit.

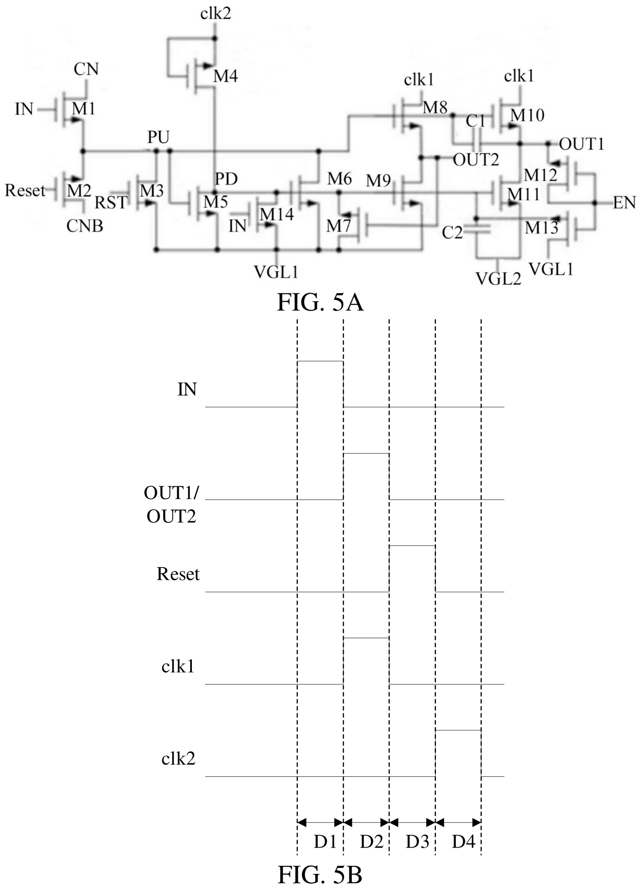

In an exemplary implementation mode, FIG. 5A is an equivalent circuit diagram of a shift register, wherein the shift register may include any one of a first dummy shift register, a second dummy shift register, and an output shift register. As shown in FIG. 5A, the shift register may include a first transistor M1 to a fourteenth transistor M14, a first capacitance C1, and a second capacitance C2. Output terminals include a first output terminal OUT1 and a second output terminal OUT2, the second output terminal OUT2 is also referred to as a cascade output terminal, and the first output terminal OUT1 is also referred to as a present stage output terminal.

In an exemplary implementation mode, as shown in FIG. 5, a control electrode of the first transistor M1 is electrically connected with an input terminal IN, a first electrode of the first transistor M1 is electrically connected with a first signal terminal CN, a second electrode of the first transistor M1 is electrically connected with a pull-up node PU; a control electrode of a second transistor M2 is electrically connected with a reset signal terminal Reset, a first electrode of the second transistor M2 is electrically connected with a second signal terminal CNB, a second electrode of the second transistor M2 is electrically connected with the pull-up node PU; a control electrode of the third transistor M3 is electrically connected with a total reset signal terminal RST, a first electrode of the third transistor M3 is electrically connected with a first low-level power supply terminal VGL1, a second electrode of the third transistor M3 is electrically connected with the pull-up node PU; a control electrode and a first electrode of the fourth transistor M4 is electrically connected with a node clock signal terminal, a second electrode of the fourth transistor M4 is electrically connected with a pull-down node PD; a control electrode of the fifth transistor M5 is electrically connected with the pull-up node PU, a first electrode of the fifth transistor M5 is electrically connected with the first low-level power supply terminal VGL1, a second electrode of the fifth transistor M5 is electrically connected with the pull-down node PD; a control electrode of the sixth transistor M6 is electrically connected with the pull-down node PD, a first electrode of the sixth transistor M6 is electrically connected with the first low-level power supply terminal VGL1, a second electrode of the sixth transistor M6 is electrically connected with the pull-up node PU; a control electrode of the seventh transistor M7 is electrically connected with the second output terminal OUT2, a first electrode of the seventh transistor M7 is electrically connected with the first low-level power supply terminal VGL1, a second electrode of the seventh transistor M7 is electrically connected with the pull-down node PD; a control electrode of the eighth transistor M8 is electrically connected with the pull-up node PU, a first electrode of the eighth transistor M8 is electrically connected with an output clock signal terminal clk1, a second electrode of the eighth transistor M8 is electrically connected with the second output terminal OUT2; a control electrode of the seventh transistor M9 is electrically connected with the pull-down node PD, a first electrode of the seventh transistor M9 is electrically connected with the first low-level power supply terminal VGL1, a second electrode of the seventh transistor M9 is electrically connected with the second output terminal OUT2; a control electrode of the tenth transistor M10 electrically connected with the pull-up node PU, a first electrode of the tenth transistor M10 is electrically connected with the output clock signal terminal clk1, a second electrode of the tenth transistor M10 is electrically connected with the first output terminal OUT1; a control electrode of the eleventh transistor M11 is electrically connected with the pull-down node PD, a first electrode of the eleventh transistor M11 is electrically connected with a second low-level power supply terminal VGL2, a second electrode of the eleventh transistor M11 is electrically connected with the first output terminal OUT1; a control electrode and a second electrode of the twelfth transistor M12 is electrically connected with an enable signal terminal EN, a first electrode of the twelfth transistor M12 is electrically connected with the first output terminal OUT1; a control electrode of the thirteenth transistor M13 is electrically connected with the enable signal terminal EN, a first electrode of the thirteenth transistor M13 is electrically connected with the first low-level power supply terminal VGL1, a second electrode of the thirteenth transistor M13 is electrically connected with the pull-down node PD; a control electrode of the fourteenth transistor M14 is electrically connected with the input terminal IN, a first electrode of the fourteenth transistor M14 is electrically connected with the first low-level power supply terminal VGL1, a second electrode of the fourteenth transistor M14 is electrically connected with the pull-down node PD; one terminal of the first capacitor C1 is electrically connected with the pull-up node PU, and the other terminal of the first capacitor C1 is electrically connected with the first output terminal OUT1; and one terminal of the second capacitor C2 is electrically connected with the pull-down node PD, and the other terminal of the second capacitor C2 is electrically connected with the second low-level power supply terminal VGL2.

In an exemplary implementation mode, transistors of the first transistor M1 to the fourteenth transistor M14 may be N-type transistors.

In an exemplary implementation mode, the first low-level power supply terminal VGL1 and the second low-level power supply terminal VGL2 continuously provide low-level signals.

In an exemplary implementation mode, a signal of the total reset signal terminal RST is a high-level signal between adjacent frames and is configured to enable the third transistor M3 to be turned on and a signal of the pull-up node PU to be pulled down to reset the shift register. A signal of the enable signal terminal EN is a high-level signal in a touch phase, and is configured to enable the twelfth transistor M12 and the thirteenth transistor M13 to be turned on, and a signal of the first output terminal OUT1 to be pulled down to realize touch.

In an exemplary implementation mode, in a display phase within a display frame, a signal of the total reset signal terminal RST and a signal of the enable signal terminal EN are low-level signals, that is, the third transistor M3, the twelfth transistor M12, and the thirteenth transistor M13 are turned off.

FIG. 5B is a working timing diagram of the shift register provided in FIG. 5A. Hereinafter, an exemplary embodiment of the present disclosure will be described through a working process of the shift register illustrated in FIG. 5A in the display phase. FIG. 5B is illustrated by taking an example in which the first transistor M1 to the fourteenth transistor M14 are N-type transistors. In conjunction with FIGs. 5A and 5B, the working process of the pixel drive circuit may include following phases.

In a first phase D1, referred to as an input phase, a signal of the input terminal IN is a high-level signal, a signal of the reset signal terminal Reset is a low-level signal, a signal of the output clock signal terminal clk1 is a low-level signal, and the node clock signal terminal clk2 is a low-level signal. The signal of the input terminal IN is a high-level signal, the first transistor M1 and the fourteenth transistor M14 are turned on, a signal of the first signal terminal CN is transmitted to the pull-up node PU, and a signal of the pull-up node PU is pulled up to be a high-level signal, the fifth transistor M5, the eighth transistor M8, and the tenth transistor M10 are turned on, a signal of the pull-down node PD is pulled down to be a low-level signal by a signal of the first low-level power supply terminal VLG1, and then the sixth transistor T6, the ninth transistor M9, and the eleventh transistor M11 are turned off, and the pull-up node PU is not pulled down by the signal of the first low-level power supply terminal VLG1 and kept as a high-level signal. Since the signal of the output clock signal terminal clk1 is a low-level signal, and signals of the first output terminal OUT1 and the second output terminal OUT2 are low-level signals, the seventh transistor M7 is turned off.

In a second phase D2, referred to as an output phase, a signal of the input terminal IN is a low-level signal, a signal of the reset signal terminal Reset is a low-level signal, a signal of the output clock signal terminal clk1 is a low-level signal, and the node clock signal terminal clk2 is a low-level signal. Under a bootstrap action of the first capacitor C1, the pull-up node PU is kept as a high-level signal, the fifth transistor M5, the eighth transistor M8, and the tenth transistor M10 are turned on, a signal of the pull-down node PD is pulled down to be a low-level signal by a signal of the first low-level power supply terminal VLG1, the sixth transistor T6, the ninth transistor M9, and the eleventh transistor M11 are turned off, the pull-up node PU is not pulled down by the signal of the first low-level power supply terminal VLG1, and kept as a high-level signal. Since the signal of the output clock signal terminal clk1 is a high-level signal, signals of the first output terminal OUT1 and the second output terminal OUT2 are high-level signals, the seventh transistor M7 is turned on, continuously pulling down the signal of the pull-down node PD.

In a third phase D3, referred to as a reset phase, a signal of the input terminal IN is a low-level signal, a signal of the reset signal terminal Reset is a high-level signal, a signal of the output clock signal terminal clk1 is a low-level signal, and the node clock signal terminal clk2 is a low-level signal. The signal of the reset signal terminal Reset is a high-level signal, the second transistor M2 is turned on, a signal of the second signal terminal CNB is written into the pull-up node PU, a signal of the pull-up node PU is pulled down to be a low-level signal, the fifth transistor M5, the eighth transistor M8, and the tenth transistor M10 are turned off, and a signal of the pull-down node PD is kept as a signal in a previous phase.

In a fourth phase D4, referred to as a noise reduction phase, a signal of the input terminal IN is a low-level signal, a signal of the reset signal terminal Reset is a low-level signal, a signal of the output clock signal terminal clk1 is a low-level signal, and the node clock signal terminal clk2 is a high-level signal. The node clock signal terminal clk2 is a high-level signal, the fourth transistor M4 is turned on, a signal of the pull-down node PD is pulled up, the sixth transistor T6, the ninth transistor M9, and the eleventh transistor M11 are turned on, the pull-up node PU, the first output terminal OUT1, and the second output terminal OUT2 are pulled down by a signal of the first low-level power supply terminal VGL1 and a signal of the second low-level power supply terminal VGL2, and kept as low-level signals, the seventh transistor M7 is turned off, so that the pull-down node PD is kept as a high-level signal.

In an exemplary implementation mode, for an i-th drive circuit, a quantity of first dummy shift registers may be Ri, a quantity of output shift registers may be Si, and a quantity of second dummy shift registers may be Ti. Herein, Ri<Si, Ti<Si, Si=2Mi, wherein Mi is a quantity of rows of sub-pixels in an i-th sub-display region.

In an exemplary implementation mode, a quantity of first dummy shift registers is smaller than a quantity of output shift registers, then an area occupied by a first dummy drive circuit may be reduced, and a quantity of second dummy shift registers is smaller than the quantity of output shift registers, then an area occupied by a second dummy drive circuit may be reduced, which is beneficial for realizing a narrow bezel of the display substrate.

In an exemplary implementation mode, a first dummy shift register, an output shift register, and a second dummy shift register include output clock signal terminals configured to provide output signals to output terminals.

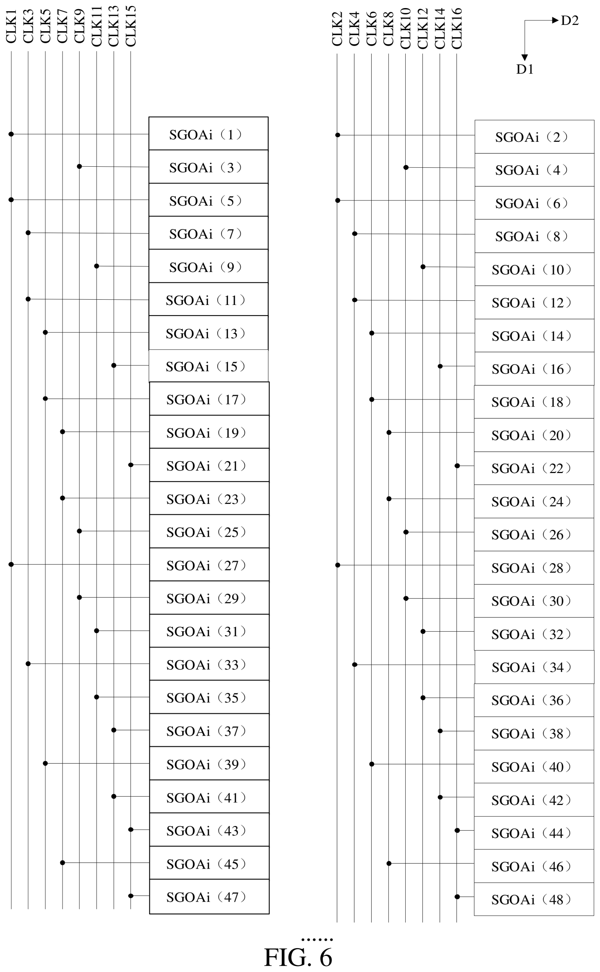

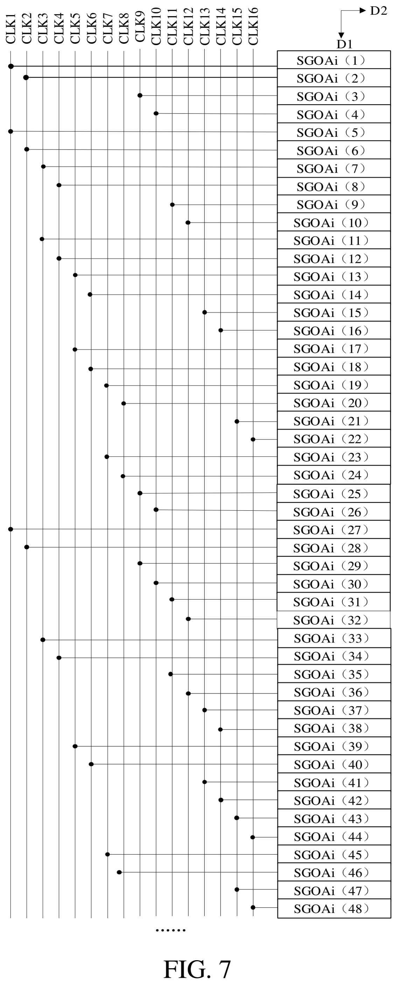

In an exemplary implementation mode, FIG. 6 is a first schematic diagram of a structure of an output drive circuit of an i-th drive circuit, and FIG. 7 is a second schematic diagram of a structure of an output drive circuit of an i-th drive circuit. As shown in FIGs. 6 and 7, for the i-th drive circuit, the output drive circuit includes a first output drive circuit and a second output drive circuit, wherein one on a left side in FIG. 6 is a first output drive circuit, and one on a right side is a second output drive circuit. The first output drive circuit includes odd-numbered stage output shift registers arranged sequentially along a first direction, for example, a first stage output shift register SGOAi(1), a third stage output shift register SGOAi(3), and so on, and output shift registers located in the first output drive circuit are cascaded with each other.

In an exemplary implementation mode, the second output drive circuit includes even-numbered stage output shift registers arranged sequentially along the first direction, for example, a second stage output shift register SGOAi(2), a fourth stage output shift register SGOAi(4), and so on, and output shift registers located in the second output drive circuit are cascaded with each other. Output shift registers in the first output drive circuit and output shift registers in the second output drive circuit in FIG. 7 are alternately disposed.

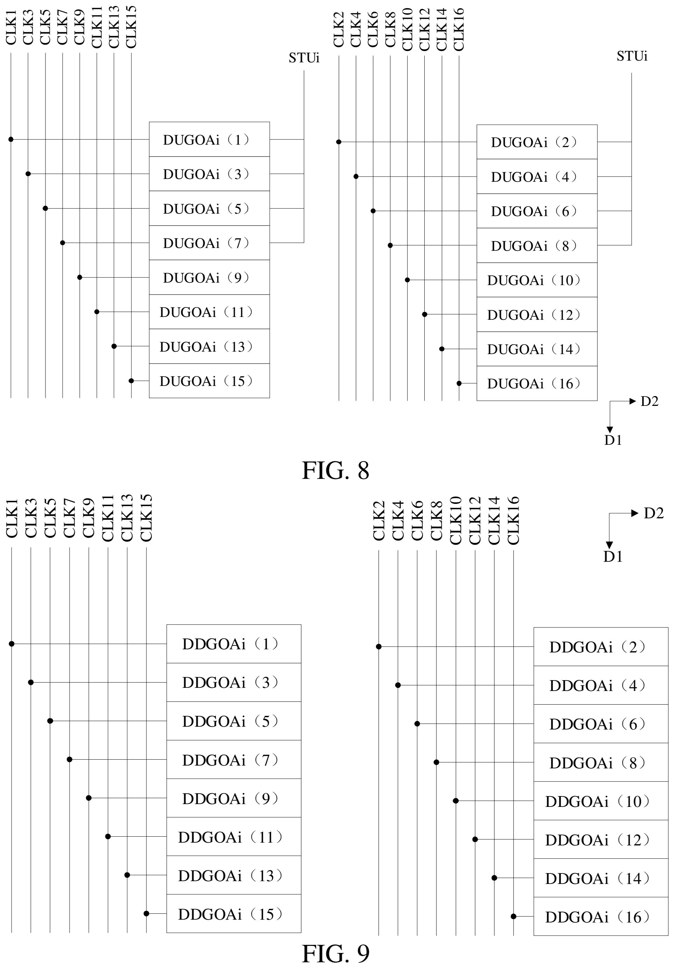

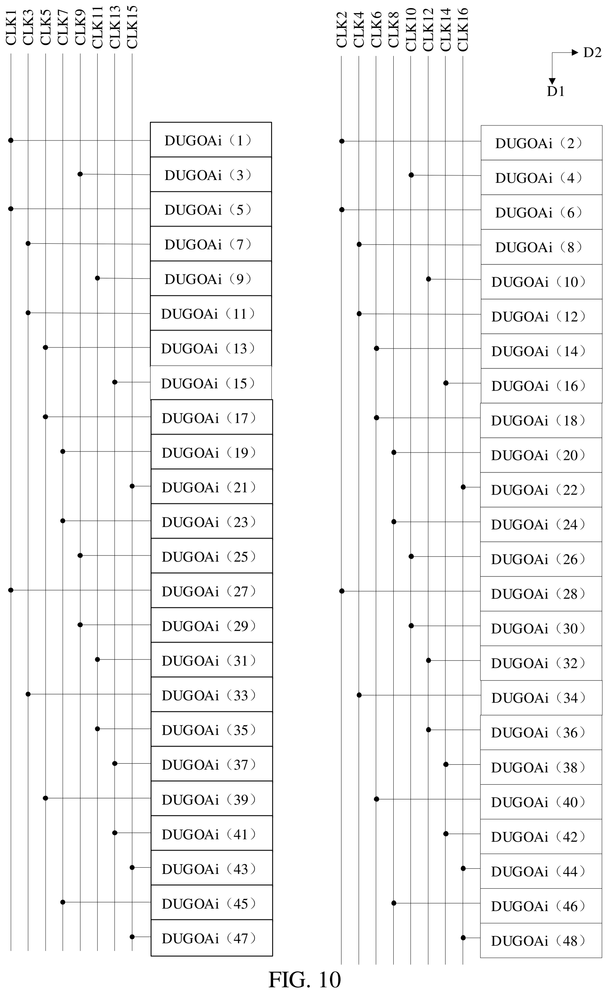

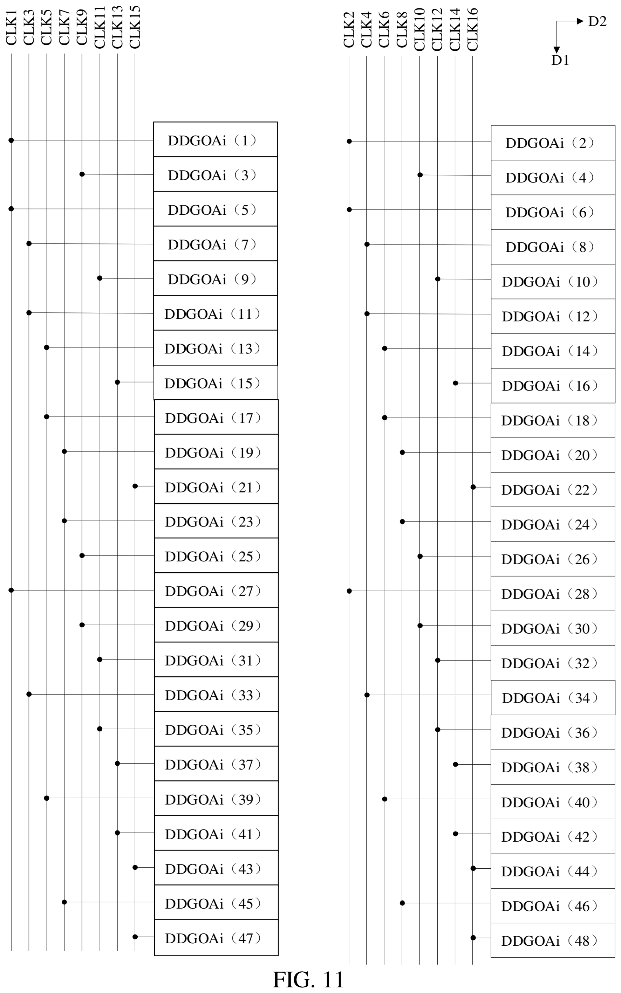

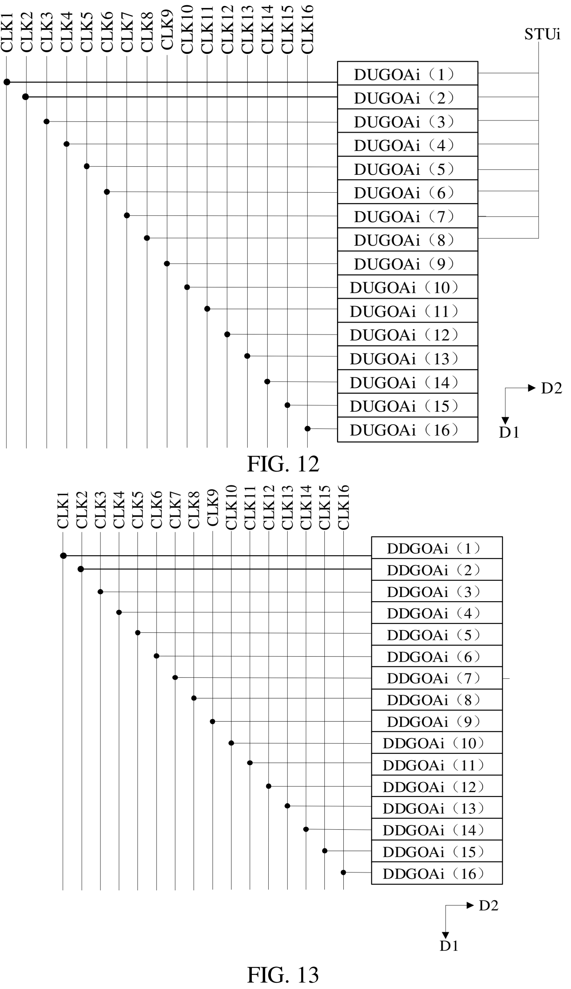

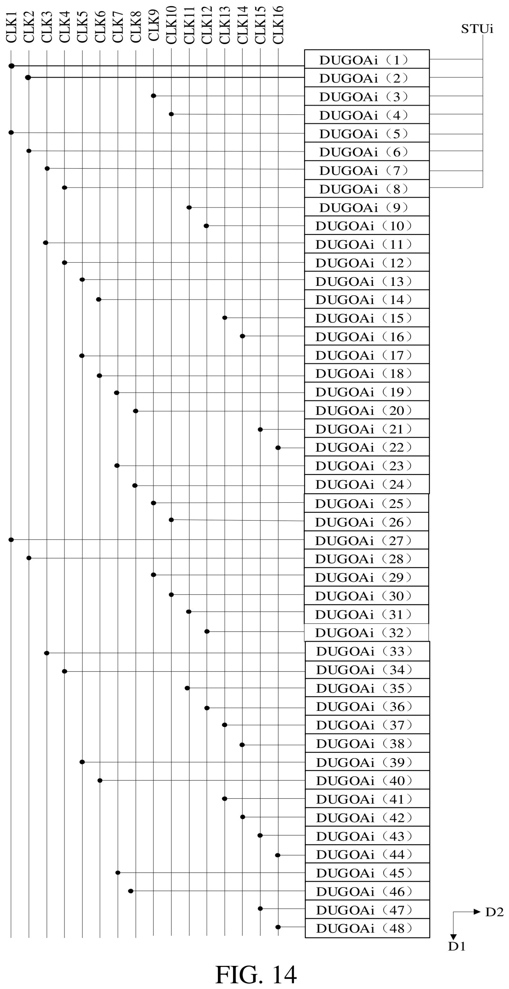

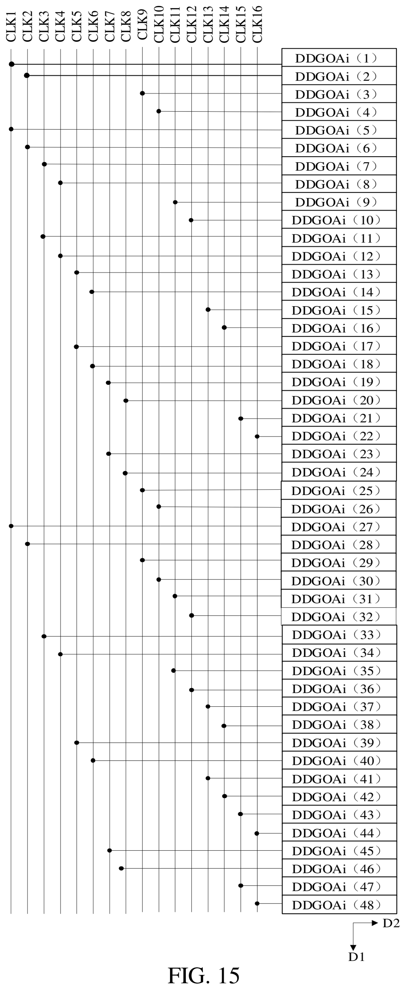

In an exemplary implementation mode, FIG. 8 is a first schematic diagram of a structure of a first dummy drive circuit, FIG. 9 is a first schematic diagram of a structure of a second dummy drive circuit, FIG. 10 is a second schematic diagram of a structure of a first dummy drive circuit, FIG. 11 is a second schematic diagram of a structure of a second dummy drive circuit, FIG. 12 is a third schematic diagram of a structure of a first dummy drive circuit, FIG. 13 is a third schematic diagram of a structure of a second dummy drive circuit, FIG. 14 is a fourth schematic diagram of a structure of a first dummy drive circuit, and FIG. 15 is a fourth schematic diagram of a structure of a second dummy drive circuit. As shown in FIGs. 6 to 15, the display substrate may further include 4K clock signal lines located in a circuit region, the clock signal lines extend along the first direction D1, and the 4K clock signal lines are arranged along the second direction D2. Herein K≥4 and K is an even number. FIGs. 6 to 15 are illustrated by taking an example in which K=4, that is, the display substrate includes sixteen clock signal lines, and when K=6, the display substrate includes twenty four clock signal lines, and the present disclosure is not limited thereto.

In an exemplary implementation mode, Ri=4K or 12K, wherein Ri=4K, that is, a quantity of first dummy shift registers is equal to a quantity of clock signal lines, then an area occupied by the first dummy shift registers may be reduced, and Ri=12K, that is, a quantity of first dummy shift registers is equal to a quantity of output shift registers included in one repeat unit of an output drive circuit, wherein a repeat unit refers to a quantity of output shift registers included in regions with a same layout, and a connection relationship between any two repeat units and 4K clock signal lines is exactly the same. FIGs. 8 and 12 are illustrated by taking an example in which Ri=4K, and FIGs. 10 and 14 are illustrated by taking an example in which Ri=12K.

In an exemplary implementation mode, Ti=4K or 12K, wherein Ti=4K, that is, a quantity of second dummy shift registers is equal to a quantity of clock signal lines, then an area occupied by the second dummy shift registers may be reduced, and Ti=12K, that is, a quantity of second dummy shift registers is equal to a quantity of output shift registers included in one repeat unit of an output drive circuit, wherein a repeat unit refers to a quantity of output shift registers included in regions with a same layout, and a connection relationship between any two repeat units and 4K clock signal lines is exactly the same. FIGs. 9 and 13 are illustrated by taking an example in which Ti=4K, and FIGs. 11 and 15 are illustrated by taking an example in which Ti=12K.

In an exemplary implementation mode, as shown in FIGs. 6 and 7, for the i-th drive circuit, an output clock signal terminal of a (6p+1+4K*L)-th stage output shift register is electrically connected with a (2p+1)-th clock signal line, an output clock signal terminal of a (6p+2+4K*L)-th stage output shift register is electrically connected with a (2p+2)-th clock signal line, an output clock signal terminal of a (6p+3+4K*L)-th stage output shift register is electrically connected with a (2K+2p+1)-th clock signal line or a (2p+1-2K)-th clock signal line, an output clock signal terminal of a (6p+4+4K*L)-th stage output shift register is electrically connected with a (2K+2p+2)-th clock signal line or a (2p+2-2K)-th clock signal line, an output clock signal terminal of a (6p+5+4K*L)-th stage output shift register is electrically connected with a (2p+1)-th clock signal line, an output clock signal terminal of a (6p+6+4K*L)-th stage output shift register is electrically connected with a (2p+2)-th clock signal line, wherein 0≤L≤(Si/4K)-1, and 0≤p≤2K-1.

In an exemplary implementation mode, when 2p+1<2K, the output clock signal terminal of the (6p+3+4K*L)-th stage output shift register is electrically connected with the (2K+2p+1)-th clock signal line, and an output clock signal terminal of a (6p+4)-th stage output shift register is electrically connected with the (2K+2p+2)-th clock signal line; and when 2p+1>2K, an output clock signal terminal of a (6p+3)-th stage output shift register is electrically connected with the (2p+1-2K)-th clock signal line, and an output clock signal terminal of a (6p+4)-th stage output shift register is electrically connected with the (2p+2-2K)-th clock signal line.

Exemplarily, when K=4, p=0, 1, 2, 3, 4, 5, 6, 7. When L=0 and p=0, an output clock signal terminal of a first stage output shift register SGOAi(1) is electrically connected with a first clock signal line CLK1, an output clock signal terminal of a third stage output shift register SGOAi(3) is electrically connected with a ninth clock signal line CLK9, an output clock signal terminal of a fifth stage output shift register SGOAi(5) is electrically connected with the first clock signal line CLK1, an output clock signal terminal of a second stage output shift register SGOAi(2) is electrically connected with a second clock signal line CLK2, an output clock signal terminal of a fourth stage output shift register SGOAi(4) is electrically connected with a tenth clock signal line CLK10, an output clock signal terminal of a sixth stage output shift register SGOAi(6) is electrically connected with the second clock signal line CLK2; when p=1, an output clock signal terminal of a seventh stage output shift register SGOAi(7) is electrically connected with a third clock signal line CLK3, an output clock signal terminal of a ninth stage output shift register SGOAi(9) is electrically connected with an eleventh clock signal line CLK11, an output clock signal terminal of an eleventh stage output shift register SGOAi(11) is electrically connected with the third clock signal line CLK3, an output clock signal terminal of an eighth stage output shift register SGOAi(8) is electrically connected with a fourth clock signal line CLK4, an output clock signal terminal of a tenth stage output shift register SGOAi(10) is electrically connected with a twelfth clock signal line CLK12, and an output clock signal terminal of a twelfth stage output shift register SGOAi(12) is electrically connected with the fourth clock signal line CLK4; when p=2, an output clock signal terminal of a thirteenth stage output shift register SGOAi(13) is electrically connected with a fifth clock signal line CLK5, an output clock signal terminal of a fifteenth stage output shift register SGOAi(15) is electrically connected with a thirteenth clock signal line CLK13, an output clock signal terminal of a seventeenth stage output shift register SGOAi(17) is electrically connected with the fifth clock signal line CLK5, an output clock signal terminal of a fourteenth stage output shift register SGOAi(14) is electrically connected with a sixth clock signal line CLK6, an output clock signal terminal of a sixteenth stage output shift register SGOAi(16) is electrically connected with a fourteenth clock signal line CLK14, an output clock signal terminal of an eighteenth stage output shift register SGOAi(18) is electrically connected with the sixth clock signal line CLK6; when p=3, an output clock signal terminal of a nineteenth stage output shift register SGOAi(19) is electrically connected with a seventh clock signal line CLK7, an output clock signal terminal of a twenty-first stage output shift register SGOAi(21) is electrically connected with a fifteenth clock signal line CLK15, an output clock signal terminal of a twenty-third stage output shift register SGOAi(23) is electrically connected with the seventh clock signal line CLK7, an output clock signal terminal of a twentieth stage output shift register SGOAi(20) is electrically connected with an eighth clock signal line CLK8, an output clock signal terminal of a twenty-second stage output shift register SGOAi(22) is electrically connected with a sixteenth clock signal line CLK16, and an output clock signal terminal of a twenty-fourth stage output shift register SGOAi(24) is electrically connected with the eighth clock signal line CLK8; when p=4, an output clock signal terminal of a twenty-fifth stage output shift register SGOAi(25) is electrically connected with a ninth clock signal line CLK9, an output clock signal terminal of a twenty-seventh stage output shift register SGOAi(27) is electrically connected with the first clock signal line CLK1, an output clock signal terminal of a twenty-ninth stage output shift register SGOAi(29) is electrically connected with the ninth clock signal line CLK9, an output clock signal terminal of a twenty-sixth stage output shift register SGOAi(26) is electrically connected with the tenth clock signal line CLK10, an output clock signal terminal of a twenty-eighth stage output shift register SGOAi(28) is electrically connected with the second clock signal line CLK2, and an output clock signal terminal of a thirtieth stage output shift register SGOAi(30) is electrically connected with the tenth clock signal line CLK10; when p=5, an output clock signal terminal of a thirty-first stage output shift register SGOAi(31) is electrically connected with the eleventh clock signal line CLK11, an output clock signal terminal of a thirty-third stage output shift register SGOAi(33) is electrically connected with the third clock signal line CLK3, an output clock signal terminal of a thirty-fifth stage output shift register SGOAi(35) is electrically connected with the eleventh clock signal line CLK11, an output clock signal terminal of a thirty-second stage output shift register SGOAi(32) is electrically connected with the twelfth clock signal line CLK12, an output clock signal terminal of a thirty-fourth stage output shift register SGOAi(34) is electrically connected with the fourth clock signal line CLK4, an output clock signal terminal of a thirty-sixth stage output shift register SGOAi(36) is electrically connected with the twelfth clock signal line CLK12; when p=6, an output clock signal terminal of a thirty-seventh stage output shift register SGOAi(37) is electrically connected with the thirteenth clock signal line CLK13, an output clock signal terminal of a thirty-ninth stage output shift register SGOAi(39) is electrically connected with the fifth clock signal line CLK5, an output clock signal terminal of a forty-first stage output shift register SGOAi(41) is electrically connected with the thirteenth clock signal line CLK13, an output clock signal terminal of a thirty-eighth stage output shift register SGOAi(38) is electrically connected with the fourteenth clock signal line CLK14, an output clock signal terminal of a fortieth stage output shift register SGOAi(40) is electrically connected with the sixth clock signal line CLK6, an output clock signal terminal of a forty-second stage output shift register SGOAi(42) is electrically connected with the fourteenth clock signal line CLK14; when p=7, an output clock signal terminal of a forty-third stage output shift register SGOAi(43) is electrically connected with the fifteenth clock signal line CLK15, an output clock signal terminal of a forty-fifth stage output shift register SGOAi(45) is electrically connected with the seventh clock signal line CLK7, the output clock signal terminal of the forty-third stage output shift register SGOAi(43) is electrically connected with the fifteenth clock signal line CLK15, an output clock signal terminal of a forty-fourth stage output shift register SGOAi(44) is electrically connected with the sixteenth clock signal line CLK16, an output clock signal terminal of a forty-sixth stage output shift register SGOAi(46) is electrically connected with the eighth clock signal line CLK8, an output clock signal terminal of a forty-eighth stage output shift register SGOAi(48) is electrically connected with the sixteenth clock signal line CLK16, and so on when L is another value.

In an exemplary implementation mode, as shown in FIGs. 8 and 12, when Ri=4K, an output clock signal terminal of an r-th first dummy shift register is electrically connected with an r-th clock signal line, and 1≤r≤4K. Exemplarily, an output clock signal terminal of a first stage first dummy shift register DUGOAi(I) is electrically connected with a first clock signal line CLK1, an output clock signal terminal of a second stage first dummy shift register DUGOAi(2) is electrically connected with a second clock signal line CLK2, an output clock signal terminal of a third stage first dummy shift register DUGOAi(3) is electrically connected with a third clock signal line CLK3, and so on, an output clock signal terminal of a sixteenth stage first dummy shift register DUGOAi(16) is electrically connected with a sixteenth clock signal line CLK16.

In an exemplary implementation mode, as shown in FIGs. 10 and 14, when Ri=12K, an output clock signal terminal of a (6p+1)-th stage first dummy shift register is electrically connected with a (2p+1)-th clock signal line, an output clock signal terminal of a (6p+3)-th stage first dummy shift register is electrically connected with a (2K+2p+1)-th clock signal line or a (2p+1-2K)-th clock signal line, an output clock signal terminal of a (6p+5)-th stage first dummy shift register is electrically connected with the (2p+1)-th clock signal line, an output clock signal terminal of a (6p+2)-th stage first dummy shift register is electrically connected with a (2p+2)-th clock signal line, an output clock signal terminal of a (6p+4)-th stage first dummy shift register is electrically connected with a (2K+2p+2)-th clock signal line or a (2p+2-2K)-th clock signal line, and an output clock signal terminal of a (6p+6)-th stage first dummy shift register is electrically connected with the (2p+2)-th clock signal line; when 2p+1<2K, the output clock signal terminal of the (6p+3)-th stage first dummy shift register is electrically connected with the (2K+2p+1)-th clock signal line, and the output clock signal terminal of the (6p+4)-th stage first dummy shift register is electrically connected with the (2K+2p+2)-th clock signal line; when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

Exemplarily, an output clock signal terminal of a first stage first dummy shift register DUGOAi(1) is electrically connected with the first clock signal line CLK1, an output clock signal terminal of a third stage first dummy shift register DUGOAi(3) is electrically connected with the ninth clock signal line CLK9, an output clock signal terminal of a fifth stage first dummy shift register DUGOAi(5) is electrically connected with the first clock signal line CLK1, an output clock signal terminal of a second stage first dummy shift register DUGOAi(2) is electrically connected with the second clock signal line CLK2, an output clock signal terminal of a fourth stage first dummy shift register DUGOAi(4) is electrically connected with the tenth clock signal line CLK10, an output clock signal terminal of a sixth stage first dummy shift register DUGOAi(6) is electrically connected with the second clock signal line CLK2, an output clock signal terminal of a seventh stage first dummy shift register DUGOAi(7) is electrically connected with the third clock signal line CLK3, an output clock signal terminal of a ninth stage first dummy shift register DUGOAi(9) is electrically connected with the eleventh clock signal line CLK11, an output clock signal terminal of an eleventh stage first dummy shift register DUGOAi(11) is electrically connected with the third clock signal line CLK3, an output clock signal terminal of an eighth stage first dummy shift register DUGOAi(8) is electrically connected with the fourth clock signal line CLK4, an output clock signal terminal of a tenth stage first dummy shift register DUGOAi(10) is electrically connected with the twelfth clock signal line CLK12, an output clock signal terminal of a twelfth stage first dummy shift register DUGOAi(12) is electrically connected with the fourth clock signal line CLK4, an output clock signal terminal of a thirteenth stage first dummy shift register DUGOAi(13) is electrically connected with the fifth clock signal line CLK5, an output clock signal terminal of a fifteenth stage first dummy shift register DUGOAi(15) is electrically connected with the thirteenth clock signal line CLK13, an output clock signal terminal of a seventeenth stage first dummy shift register DUGOAi(17) is electrically connected with the fifth clock signal line CLK5, an output clock signal terminal of a fourteenth stage first dummy shift register DUGOAi(14) is electrically connected with the sixth clock signal line CLK6, an output clock signal terminal of a sixteenth stage first dummy shift register DUGOAi(16) is electrically connected with the fourteenth clock signal line CLK14, an output clock signal terminal of an eighteenth stage first dummy shift register DUGOAi(18) is electrically connected with the sixth clock signal line CLK6, an output clock signal terminal of a nineteenth stage first dummy shift register DUGOAi(19) is electrically connected with the seventh clock signal line CLK7, an output clock signal terminal of a twenty-first stage first dummy shift register DUGOAi(21) is electrically connected with the fifteenth clock signal line CLK15, an output clock signal terminal of a twenty-third stage first dummy shift register DUGOAi(23) is electrically connected with the seventh clock signal line CLK7, an output clock signal terminal of a twentieth stage first dummy shift register DUGOAi(20) is electrically connected with the eighth clock signal line CLK8, an output clock signal terminal of a twenty-second stage first dummy shift register DUGOAi(22) is electrically connected with the sixteenth clock signal line CLK16, an output clock signal terminal of a twenty-fourth stage first dummy shift register DUGOAi(24) is electrically connected with the eighth clock signal line CLK8, an output clock signal terminal of a twenty-fifth stage first dummy shift register DUGOAi(25) is electrically connected with the ninth clock signal line CLK9, an output clock signal terminal of a twenty-seventh stage first dummy shift register DUGOAi(27) is electrically connected with the first clock signal line CLK1, an output clock signal terminal of a twenty-ninth stage first dummy shift register DUGOAi(29) is electrically connected with the ninth clock signal line CLK9, an output clock signal terminal of a twenty-sixth stage first dummy shift register DUGOAi(26) is electrically connected with the tenth clock signal line CLK10, an output clock signal terminal of a twenty-eighth stage first dummy shift register DUGOAi(28) is electrically connected with the second clock signal line CLK2, an output clock signal terminal of a thirtieth stage first dummy shift register DUGOAi(30) is electrically connected with the tenth clock signal line CLK10, an output clock signal terminal of a thirty-first stage first dummy shift register DUGOAi(31) is electrically connected with the eleventh clock signal line CLK11, an output clock signal terminal of a thirty-third stage first dummy shift register DUGOAi(33) is electrically connected with the third clock signal line CLK3, an output clock signal terminal of a thirty-fifth stage first dummy shift register DUGOAi(35) is electrically connected with the eleventh clock signal line CLK11, an output clock signal terminal of a thirty-second stage first dummy shift register DUGOAi(32) is electrically connected with the twelfth clock signal line CLK12, an output clock signal terminal of a thirty-fourth stage first dummy shift register DUGOAi(34) is electrically connected with the fourth clock signal line CLK4, an output clock signal terminal of a thirty-sixth stage first dummy shift register DUGOAi(36) is electrically connected with the twelfth clock signal line CLK12, an output clock signal terminal of a thirty-seventh stage first dummy shift register DUGOAi(37) is electrically connected with the thirteenth clock signal line CLK13, an output clock signal terminal of a thirty-ninth stage first dummy shift register DUGOAi(39) is electrically connected with the fifth clock signal line CLK5, an output clock signal terminal of a forty-first stage first dummy shift register DUGOAi(41) is electrically connected with the thirteenth clock signal line CLK13, an output clock signal terminal of a thirty-eighth stage first dummy shift register DUGOAi(38) is electrically connected with the fourteenth clock signal line CLK14, an output clock signal terminal of a fortieth stage first dummy shift register DUGOAi(40) is electrically connected with the sixth clock signal line CLK6, an output clock signal terminal of a forty-second stage first dummy shift register DUGOAi(42) is electrically connected with the fourteenth clock signal line CLK14, an output clock signal terminal of a forty-third stage first dummy shift register DUGOAi(43) is electrically connected with the fifteenth clock signal line CLK15, an output clock signal terminal of a forty-fifth stage first dummy shift register DUGOAi(45) is electrically connected with the seventh clock signal line CLK7, the output clock signal terminal of the forty-third stage first dummy shift register DUGOAi(43) is electrically connected with the fifteenth clock signal line CLK15, an output clock signal terminal of a forty-fourth stage first dummy shift register DUGOAi(44) is electrically connected with the sixteenth clock signal line CLK16, an output clock signal terminal of a forty-sixth stage first dummy shift register DUGOAi(46) is electrically connected with the eighth clock signal line CLK8, and an output clock signal terminal of a forty-eighth stage first dummy shift register DUGOAi(48) is electrically connected with the sixteenth clock signal line CLK16.

In an exemplary implementation mode, as shown in FIGs. 9 and 13, when Ti=4K, an output clock signal terminal of a t-th stage second dummy shift register is electrically connected with a t-th clock signal line, wherein $1 \leq t \leq 4K$. Exemplarily, an output clock signal terminal of a first stage first dummy shift register DUGOAi(1) is electrically connected with a first clock signal line CLK1, an output clock signal terminal of a second stage first dummy shift register DUGOAi(2) is electrically connected with a second clock signal line CLK2, an output clock signal terminal of a third stage first dummy shift register DUGOAi(3) is electrically connected with a third clock signal line CLK3, and so on, an output clock signal terminal of a sixteenth stage first dummy shift register DUGOAi(16) is electrically connected with a sixteenth clock signal line CLK16.

In an exemplary implementation mode, as shown in FIGs. 11 and 15, when Ti=12K, an output clock signal terminal of a (6p+1)-th stage second dummy shift register is electrically connected with the (2p+1)-th clock signal line, an output clock signal terminal of a (6p+3)-th second dummy shift register is electrically connected with the (2K+2p+1)-th clock signal line or the (2p+1-2K)-th clock signal line, an output clock signal terminal of a (6p+5)-th stage second dummy shift register is electrically connected with the (2p+1)-th clock signal line, an output clock signal terminal of a (6p+2)-th stage second dummy shift register is electrically connected with the (2p+2)-th clock signal line, an output clock signal terminal of a (6p+4)-th second dummy shift register is electrically connected with the (2K+2p+2)-th clock signal line or the (2p+2-2K)-th clock signal line, and an output clock signal terminal of a (6p+6)-th second dummy shift register is electrically connected with the (2p+2)-th clock signal line; when 2p+1<2K, the output clock signal terminal of the (6p+3)-th stage second dummy shift register is electrically connected with the (2K+2p+1)-th clock signal line, and the output clock signal terminal of the (6p+4)-th stage second dummy shift register is electrically connected with the (2K+2p+2)-th clock signal line; when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

Exemplarily, an output clock signal terminal of a first stage second dummy shift register DDGOAi(1) is electrically connected with the first clock signal line CLK1, an output clock signal terminal of a third stage second dummy shift register DDGOAi(3) is electrically connected with the ninth clock signal line CLK9, an output clock signal terminal of a fifth stage second dummy shift register DDGOAi(5) is electrically connected with the first clock signal line CLK1, an output clock signal terminal of a second stage second dummy shift register DDGOAi(2) is electrically connected with the second clock signal line CLK2, an output clock signal terminal of a fourth stage second dummy shift register DDGOAi(4) is electrically connected with the tenth clock signal line CLK10, an output clock signal terminal of a sixth stage second dummy shift register DDGOAi(6) is electrically connected with the second clock signal line CLK2, an output clock signal terminal of a seventh stage second dummy shift register DDGOAi(7) is electrically connected with the third clock signal line CLK3, an output clock signal terminal of a ninth stage second dummy shift register DDGOAi(9) is electrically connected with the eleventh clock signal line CLK11, an output clock signal terminal of an eleventh stage second dummy shift register DDGOAi(11) is electrically connected with the third clock signal line CLK3, an output clock signal terminal of an eighth stage second dummy shift register DDGOAi(8) is electrically connected with the fourth clock signal line CLK4, an output clock signal terminal of a tenth stage second dummy shift register DDGOAi(10) is electrically connected with the twelfth clock signal line CLK12, an output clock signal terminal of a twelfth stage second dummy shift register DDGOAi(12) is electrically connected with the fourth clock signal line CLK4, an output clock signal terminal of a thirteenth stage second dummy shift register DDGOAi(13) is electrically connected with the fifth clock signal line CLK5, an output clock signal terminal of a fifteenth stage second dummy shift register DDGOAi(15) is electrically connected with the thirteenth clock signal line CLK13, an output clock signal terminal of a seventeenth stage second dummy shift register DDGOAi(17) is electrically connected with the fifth clock signal line CLK5, an output clock signal terminal of a fourteenth stage second dummy shift register DDGOAi(14) is electrically connected with the sixth clock signal line CLK6, an output clock signal terminal of a sixteenth stage second dummy shift register DDGOAi(16) is electrically connected with the fourteenth clock signal line CLK14, an output clock signal terminal of an eighteenth stage second dummy shift register DDGOAi(18) is electrically connected with the sixth clock signal line CLK6, an output clock signal terminal of a nineteenth stage second dummy shift register DDGOAi(19) is electrically connected with the seventh clock signal line CLK7, an output clock signal terminal of a twenty-first stage second dummy shift register DDGOAi(21) is electrically connected with the fifteenth clock signal line CLK15, an output clock signal terminal of a twenty-third stage second dummy shift register DDGOAi(23) is electrically connected with the seventh clock signal line CLK7, an output clock signal terminal of a twentieth stage second dummy shift register DDGOAi(20) is electrically connected with the eighth clock signal line CLK8, an output clock signal terminal of a twenty-second stage second dummy shift register DDGOAi(22) is electrically connected with the sixteenth clock signal line CLK16, an output clock signal terminal of a twenty-fourth stage second dummy shift register DDGOAi(24) is electrically connected with the eighth clock signal line CLK8, an output clock signal terminal of a twenty-fifth stage second dummy shift register DDGOAi(25) is electrically connected with the ninth clock signal line CLK9, an output clock signal terminal of a twenty-seventh stage second dummy shift register DDGOAi(27) is electrically connected with the first clock signal line CLK1, an output clock signal terminal of a twenty-ninth stage second dummy shift register DDGOAi(29) is electrically connected with the ninth clock signal line CLK9, an output clock signal terminal of a twenty-sixth stage second dummy shift register DDGOAi(26) is electrically connected with the tenth clock signal line CLK10, an output clock signal terminal of a twenty-eighth stage second dummy shift register DDGOAi(28) is electrically connected with the second clock signal line CLK2, an output clock signal terminal of a thirtieth stage second dummy shift register DDGOAi(30) is electrically connected with the tenth clock signal line CLK10, an output clock signal terminal of a thirty-first stage second dummy shift register DDGOAi(31) is electrically connected with the eleventh clock signal line CLK11, an output clock signal terminal of a thirty-third stage second dummy shift register DDGOAi(33) is electrically connected with the third clock signal line CLK3, an output clock signal terminal of a thirty-fifth stage second dummy shift register DDGOAi(35) is electrically connected with the eleventh clock signal line CLK11, an output clock signal terminal of a thirty-second stage second dummy shift register DDGOAi(32) is electrically connected with the twelfth clock signal line CLK12, an output clock signal terminal of a thirty-fourth stage second dummy shift register DDGOAi(34) is electrically connected with the fourth clock signal line CLK4, an output clock signal terminal of a thirty-sixth stage second dummy shift register DDGOAi(36) is electrically connected with the twelfth clock signal line CLK12, an output clock signal terminal of a thirty-seventh stage second dummy shift register DDGOAi(37) is electrically connected with the thirteenth clock signal line CLK13, an output clock signal terminal of a thirty-ninth stage second dummy shift register DDGOAi(39) is electrically connected with the fifth clock signal line CLK5, an output clock signal terminal of a forty-first stage second dummy shift register DDGOAi(41) is electrically connected with the thirteenth clock signal line CLK13, an output clock signal terminal of a thirty-eighth stage second dummy shift register DDGOAi(38) is electrically connected with the fourteenth clock signal line CLK14, an output clock signal terminal of a fortieth stage second dummy shift register DDGOAi(40) is electrically connected with the sixth clock signal line CLK6, an output clock signal terminal of a forty-second stage second dummy shift register DDGOAi(42) is electrically connected with the fourteenth clock signal line CLK14, an output clock signal terminal of a forty-third stage second dummy shift register DDGOAi(43) is electrically connected with the fifteenth clock signal line CLK15, an output clock signal terminal of a forty-fifth stage second dummy shift register DDGOAi(45) is electrically connected with the seventh clock signal line CLK7, the output clock signal terminal of the forty-third stage second dummy shift register DDGOAi(43) is electrically connected with the fifteenth clock signal line CLK15, an output clock signal terminal of a forty-fourth stage second dummy shift register DDGOAi(44) is electrically connected with the sixteenth clock signal line CLK16, an output clock signal terminal of a forty-sixth stage second dummy shift register DDGOAi(46) is electrically connected with the eighth clock signal line CLK8, and an output clock signal terminal of a forty-eighth stage second dummy shift register DDGOAi(48) is electrically connected with the sixteenth clock signal line CLK16.

In an exemplary implementation mode, as shown in FIGs. 7, 12, 13, 14, and 15, for the i-th drive circuit, the first stage output shift register to an Si-th output shift register are sequentially arranged along the first direction D1, the first stage first dummy shift register to an Ri-th first dummy shift register are sequentially arranged along the first direction D1, the first stage second dummy shift register to a Ti-th second dummy shift register are sequentially arranged along the first direction D1, and the first clock signal line to a 4K-th shift register are sequentially arranged along the second direction D2, and are located on a side of the drive circuit away from the display region. FIGs. 12 and 14 are schematic diagrams of two structures of the first dummy drive circuit when the output drive circuit is shown as FIG. 7, and a difference is that quantities of first dummy shift registers are different. FIGs. 13 and 15 are schematic diagrams of two structures of the second dummy drive circuit when the output drive circuit is shown as FIG. 7, and a difference is that quantities of second dummy shift registers are different. Structures provided in FIGs. 7, 12, 13, 14, and 15 are suitable for a display product with a high Pixel Per Inch (PPI) and limited space of a non-display region.

In an exemplary implementation mode, as shown in FIGs. 6, 8, 9, 10, and 11, for the i-th drive circuit, an odd-numbered clock signal line is located on a side of the first output drive circuit away from the display region, and an even-numbered clock signal line is located on a side of the second output drive circuit away from the display region; when the first output drive circuit is located on the side of the second output drive circuit away from the display region, the even-numbered clock signal line is located between the first output drive circuit and the second output drive circuit; and when the second output drive circuit is located on a side of the first output drive circuit away from the display region, the odd-numbered clock signal line is located between the first output drive circuit and the second output drive circuit. Structures provided in FIGs. 6, 8, 9, 10, and 11 are suitable for a display product with a low PPI and relatively large space of a non-display region.

Table 1 shows connection relationships between signal terminals of partial shift registers when K=4, Ri=16, and Ti=16. As shown in Table 1, an output clock signal terminal of a first stage first dummy shift register is electrically connected with a first clock signal line, a node clock signal terminal of the first stage first dummy shift register is electrically connected with a ninth clock signal line, an input terminal of the first stage first dummy shift register is electrically connected with an i-th initial signal line, a reset signal terminal of the first stage first dummy shift register is electrically connected with an output terminal of a ninth stage first dummy shift register, and so on, an output clock signal terminal of a first stage output shift register is electrically connected with the first clock signal line, a node clock signal terminal of the first stage output shift register is electrically connected with the ninth clock signal line, an input terminal of the first stage output shift register is electrically connected with the output terminal of the ninth stage first dummy shift register, a reset signal terminal of the first stage output shift register is electrically connected with an output terminal of a ninth stage output shift register, and so on, an output clock signal terminal of a first stage second dummy shift register is electrically connected with the first clock signal line, a node clock signal terminal of the first stage second dummy shift register is electrically connected with the ninth clock signal line, an input terminal of the first stage second dummy shift register is electrically connected with an output terminal of a 1421-th stage output shift register, a reset signal terminal of the first stage second dummy shift register is electrically connected with an output terminal of a ninth stage second dummy shift register. In Table 1, the first stage output shift register to a forty-seventh stage output shift register form one repeat unit, and subsequent output shift registers of every 24 stages form one repeat unit. A connection relationship between output shift registers in any two repeat units is the same. Table 1 should include 30 repeat units, but only one repeat unit is shown. In the present disclosure, repeat units and a quantity of the repeat units may be determined by looking up Table 1.

Table 1

|  | clk1 | clk2 | IN | Reset | OUT1/OUT2 |
|---|---|---|---|---|---|
| DUGOAi ( 1 ) | CLK1 | CLK9 | STUi | DUOUT9 | DUOUT1 |
| DUGOAi ( 3 ) | CLK3 | CLK11 | STUi | DUOUT11 | DUOUT3 |
| DUGOAi ( 5 ) | CLK5 | CLK13 | STUi | DUOUT13 | DUOUT5 |
| DUGOAi ( 7 ) | CLK7 | CLK15 | STUi | DUOUT15 | DUOUT7 |
| DUGOAi ( 9 ) | CLK9 | CLK1 | DUOUT1 | SGOA1 | DUOUT9 |
| DUGOAi ( 11 ) | CLK11 | CLK3 | DUOUT3 | SGOA7 | DUOUT11 |
| DUGOAi ( 13 ) | CLK13 | CLK5 | DUOUT5 | SGOA13 | DUOUT13 |
| DUGOAi ( 15 ) | CLK15 | CLK7 | DUOUT7 | SGOA19 | DUOUT15 |
| SGOAi ( 1 ) | CLK1 | CLK9 | DUOUT9 | SOUT9 | SOUT1 |
| SGOAi ( 3 ) | CLK9 | CLK1 | SOUT1 | SOUT17 | SOUT9 |
| SGOAi ( 5 ) | CLK1 | CLK9 | SOUT9 | SOUT25 | SOUT17 |
| SGOAi ( 7 ) | CLK3 | CLK11 | DUOUT11 | SOUT11 | SOUT3 |
| SGOAi ( 9 ) | CLK11 | CLK3 | SOUT3 | SGOA19 | SOUT11 |
| SGOAi ( 11 ) | CLK3 | CLK11 | SOUT11 | SGOA27 | SOUT19 |
| SGOAi ( 13 ) | CLK5 | CLK13 | DUOUT13 | SGOA13 | SOUT5 |
| SGOAi ( 15 ) | CLK13 | CLK5 | SOUT5 | SGOA21 | SOUT13 |
| SGOAi ( 17 ) | CLK5 | CLK13 | SOUT13 | SOUT29 | SOUT21 |
| SGOAi ( 19 ) | CLK7 | CLK15 | DUOUT15 | SOUT15 | SOUT7 |
| SGOAi ( 21 ) | CLK15 | CLK7 | SOUT7 | SOUT23 | SOUT15 |
| SGOAi ( 23 ) | CLK7 | CLK15 | SOUT15 | SOUT31 | SOUT23 |
| SGOAi ( 25 ) | CLK9 | CLK7 | SOUT17 | SOUT33 | SOUT25 |
| SGOAi ( 27 ) | CLK1 | CLK9 | SOUT25 | SOUT41 | SOUT33 |
| SGOAi ( 29 ) | CLK9 | CLK1 | SOUT33 | SOUT49 | SOUT41 |
| SGOAi ( 31 ) | CLK11 | CLK3 | SOUT19 | SOUT35 | SOUT27 |
| SGOAi ( 33 ) | CLK3 | CLK11 | SOUT27 | SOUT43 | SOUT35 |
| SGOAi ( 35 ) | CLK11 | CLK3 | SOUT35 | SOUT65 | SOUT43 |
| SGOAi ( 37 ) | CLK13 | CLK5 | SOUT21 | SOUT37 | SOUT29 |
| SGOAi ( 39 ) | CLK5 | CLK13 | SOUT29 | SOUT45 | SOUT37 |
| SGOAi ( 41 ) | CLK13 | CLK5 | SOUT37 | SOUT53 | SOUT45 |
| SGOAi ( 43 ) | CLK15 | CLK7 | SOUT23 | SOUT39 | SOUT31 |
| SGOAi ( 45 ) | CLK7 | CLK15 | SOUT31 | SOUT47 | SOUT39 |
| SGOAi ( 47 ) | CLK15 | CLK7 | SOUT39 | SOUT55 | SOUT47 |
| SGOAi ( 49 ) ~SGOAi ( 1439 ) | | | | | |
| DDGOAi ( 1 ) | CLK1 | CLK9 | SOUT1413 | DDOUT9 | DDOUT1 |
| DDGOAi ( 3 ) | CLK3 | CLK11 | SOUT1419 | DDOUT11 | DDOUT3 |
| DDGOAi ( 5 ) | CLK5 | CLK13 | SOUT1417 | DDOUT13 | DDOUT5 |
| DDGOAi ( 7 ) | CLK7 | CLK15 | SOUT1439 | DDOUT15 | DDOUT7 |
| DDGOAi ( 9 ) | CLK9 | CLK1 | DDOUT1 |  | DDOUT9 |
| DDGOAi ( 11 ) | CLK11 | CLK3 | DDOUT3 |  | DDOUT11 |

(continued)

| SGOAi ( 49 ) ~SGOAi ( 1439 ) | | | | | |
|---|---|---|---|---|---|
| DDGOAi ( 13 ) | CLK13 | CLK5 | DDOUT5 | | DDOUT13 |
| DDGOAi ( 15 ) | CLK15 | CLK7 | DDOUT7 | | DDOUT15 |

In an exemplary implementation mode, a display mode of a sub-display region includes a first display mode, a second display mode, and a third display mode, wherein a resolution of the first display mode is greater than a resolution of the second display mode, and the resolution of the second display mode is greater than a resolution of the third display mode. Here, the first display mode may be referred to as a high-definition display mode, the second display mode may be referred to as a medium-definition display mode, and the third display mode may be referred to as a low-definition display mode.

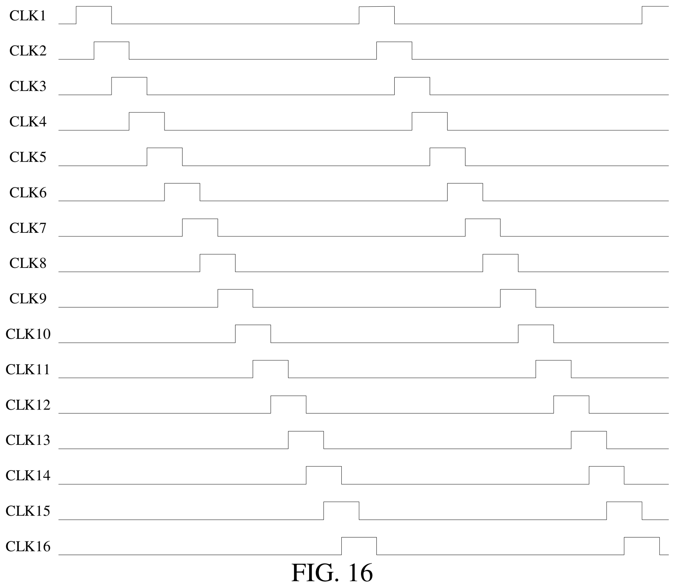

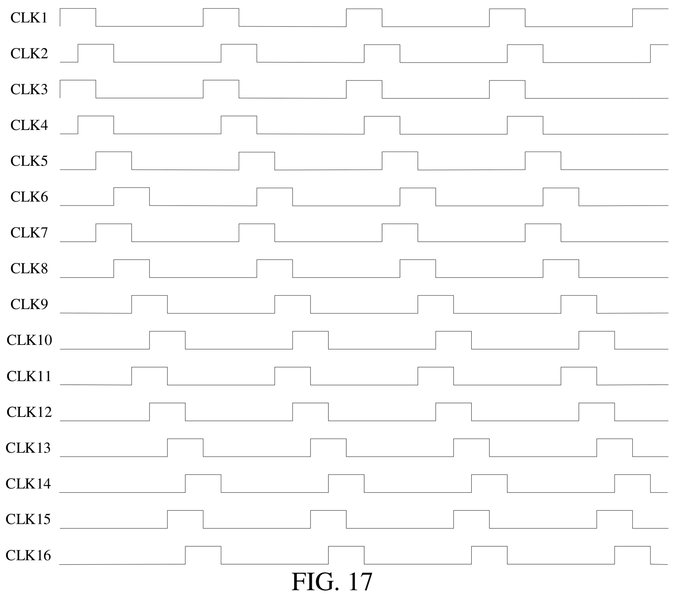

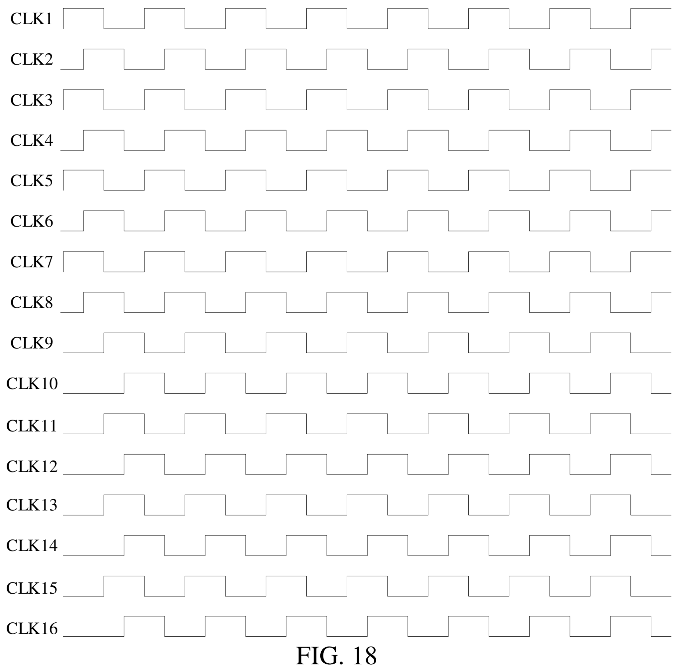

FIG. 16 is a schematic diagram of signals of a plurality of clock signal lines in a sub-display region in a first display mode, FIG. 17 is a schematic diagram of signals of a plurality of clock signal lines in a sub-display region in a second display mode, and FIG. 18 is a schematic diagram of signals of a plurality of clock signal lines in a sub-display region in a third display mode. As shown in FIGs. 16 to 18, a clock signal of any one clock signal line includes a plurality of pulse signals, durations of pulse signals of any two clock signal lines are the same, periods of pulse signals of any two clock signal lines are the same, and an occurrence time period of a pulse signal of a k-th clock signal line is overlapped with an occurrence time period of a pulse signal of a (k+1)-th clock signal line, wherein $1 \leq k \leq 4K$. Exemplarily, an occurrence time period of a pulse signal of the first clock signal line CLK1 is overlapped with an occurrence time periods of a pulse signal of the second clock signal line CLK2, and an overlapping time may be half of a duration of a pulse signal of either clock signal line. FIGs. 16 to 18 are illustrated by taking an example in which K=4.

In the exemplary implementation mode, as shown in FIG. 16, when the display mode of the sub-display region is the first display mode, there is no overlap between occurrence time periods of pulse signals of any two clock signal lines of all odd-numbered clock signal lines located on a side of a (2K+1)-th clock signal line away from the display region, there is no overlap between occurrence time periods of pulse signals of any two clock signal lines of all odd-numbered clock signal lines located on a side of a (2K-1)-th clock signal line close to the display region, there is no overlap between occurrence time periods of pulse signals of any two clock signal lines of all even-numbered clock signal lines located on a side of a (2K+2)-th clock signal line away from the display region, and there is no overlap between occurrence time periods of pulse signals of any two clock signal lines of all even-numbered clock signal lines located on a side of a 2K-th clock signal line close to the display region. Exemplarily, when K=4, the all odd-numbered clock signal lines located on the side of the (2K+1)-th clock signal line away from the display region include a first clock signal line CLK1, a third clock signal line CLK3, a fifth clock signal line CLK5, and a seventh clock signal line CLK7, and in the first display mode, there is no overlap between occurrence time periods of pulse signals of any two of the first clock signal line CLK1, the third clock signal line CLK3, the fifth clock signal line CLK5, and the seventh clock signal line CLK7. The all odd-numbered clock signal lines located on the side of the (2K-1)-th clock signal line close to the display region include a ninth clock signal line CLK9, an eleventh clock signal line CLK11, a thirteenth clock signal line CLK13, and a fifteenth clock signal line CLK15, and there is no overlap between occurrence time periods of pulse signals of any two of the ninth clock signal line CLK9, the eleventh clock signal line CLK11, the thirteenth clock signal line CLK13, and the fifteenth clock signal line CLK15. The all even-numbered clock signal lines located on the side of the (2K+2)-th clock signal line away from the display region include a second clock signal line CLK2, a fourth clock signal line CLK4, a sixth clock signal line CLK6, and an eighth clock signal line CLK8, and there is no overlap between occurrence time periods of pulse signals of any two of the second clock signal line CLK2, the fourth clock signal line CLK4, the sixth clock signal line CLK6, and the eighth clock signal line CLK8. The all even-numbered clock signal lines located on the side of the 2K-th clock signal line close to the display region include a tenth clock signal line CLK10, a twelfth clock signal line CLK12, a fourteenth clock signal line CLK14, and a sixteenth clock signal line CLK16, and there is no overlap between occurrence time periods of pulse signals of any two of the tenth clock signal line CLK10, the twelfth clock signal line CLK12, the fourteenth clock signal line CLK14, and the sixteenth clock signal line CLK16.

In the exemplary implementation mode, as shown in FIG. 17, when the display mode of the sub-display region is the second display mode, occurrence time periods of pulse signals of first K/2 clock signal lines of the all odd-numbered clock signal lines located on the side of the (2K+1)-th clock signal line away from the display region coincide, occurrence time periods of pulse signals of last K/2 clock signal lines of the all odd-numbered clock signal lines located on the side of the (2K+1)-th clock signal line away from the display region coincide, there is no overlap between occurrence time periods of pulse signals of a first clock signal line and a (K+1)-th clock signal line, occurrence time periods of pulse signals of first K/2 clock signal lines of the all odd-numbered clock signal lines located on the side of the (2K-1)-th clock signal line close to the display region coincide, occurrence time periods of pulse signals of last K/2 clock signal lines of the all odd-numbered clock signal lines located on the side of the (2K-1)-th clock signal line close to the display region coincide, there is no overlap between occurrence time periods of pulse signals of the (2K+1)-th clock signal line and a (3K+1)-th clock signal line, occurrence time periods of pulse signals of first K/2 clock signal lines of the all even-numbered clock signal lines located on the side of the (2K+2)-th clock signal line away from the display region coincide, occurrence time periods of pulse signals of last K/2 clock signal lines of the all even-numbered clock signal lines located on the side of the (2K+2)-th clock signal line away from the display region coincide, there is no overlap between occurrence time periods of pulse signals of a second clock signal line and a (K+2)-th clock signal line, and occurrence time periods of pulse signals of first K/2 clock signal lines of the all even-numbered clock signal lines located on the side of the 2K-th clock signal line close to the display region coincide, occurrence time periods of pulse signals of last K/2 clock signal lines of the all even-numbered clock signal lines located on the side of the (2K+2)-th clock signal line away from the display region coincide, there is no overlap between occurrence time periods of pulse signals of the (2K+2)-th clock signal line and a (3K+2)-th clock signal line. Exemplarily, when K=4, the first K/2 clock signal lines of the all odd-numbered clock signal lines located on the side of the (2K+1)-th clock signal line away from the display region include the first clock signal line CLK1 and the third clock signal line CLK3, and occurrence time periods of pulse signals of the first clock signal line CLK1 and the third clock signal line CLK3 coincide. The last K/2 clock signal lines of the all odd-numbered clock signal lines located on the side of the (2K+1)-th clock signal line away from the display region include the fifth clock signal line CLK5 and the seventh clock signal line CLK7, and occurrence time periods of pulse signals of the fifth clock signal line CLK5 and the seventh clock signal line CLK7 coincide. The first K/2 clock signal lines of the all odd-numbered clock signal lines located on the side of the (2K-1)-th clock signal lines close to the display region include the ninth clock signal line CLK9 and the eleventh clock signal line CLK11, occurrence time periods of pulse signals of the ninth clock signal line CLK9 and the eleventh clock signal line CLK11 coincide. The last K/2 clock signal lines of the all odd-numbered clock signal lines located on the side of the (2K-1)-th clock signal line close to the display region include the thirteenth clock signal line CLK13 and the fifteenth clock signal line CLK15, and occurrence time periods of pulse signals of the thirteenth clock signal line CLK13 and the fifteenth clock signal line CLK15 coincide. The first K/2 clock signal lines of the all even-numbered clock signal lines located on the side of the (2K+2)-th clock signal line away from the display region include the second clock signal line CLK2 and the fourth clock signal line CLK4, and occurrence time periods of pulse signals of the second clock signal line CLK2 and the fourth clock signal line CLK4 coincide. The last K/2 clock signal lines of the all even-numbered clock signal lines located on the side of the (2K+2)-th clock signal line away from the display region include the sixth clock signal line CLK6 and the eighth clock signal line CLK8, and occurrence time periods of pulse signals of the sixth clock signal line CLK6 and the eighth clock signal line CLK8 coincide. The first K/2 clock signal lines of the all even-numbered clock signal lines located on the side of the 2K-th clock signal lines close to the display region include the tenth clock signal line CLK10 and the twelfth clock signal line CLK12, occurrence time periods of pulse signals of the tenth clock signal line CLK10 and the twelfth clock signal line CLK12 coincide. The last K/2 clock signal lines of the all even-numbered clock signal lines located on the side of the 2K-th clock signal line close to the display region include the fourteenth clock signal line CLK14 and the sixteenth clock signal line CLK16, and occurrence time periods of pulse signals of the fourteenth clock signal line CLK14 and the sixteenth clock signal line CLK16 coincide.

In the exemplary implementation mode, as shown in FIG. 18, when the display mode of the sub-display region is the third display mode, occurrence time periods of pulse signals of any two of the all odd-numbered clock signal lines located on the side of the (2K+1)-th clock signal line away from the display region coincide, occurrence time periods of pulse signals of any two of the all odd-numbered clock signal lines located on the side of the (2K-1)-th clock signal line close to the display region coincide, occurrence time periods of pulse signals of any two of the all even-numbered clock signal lines located on the side of the (2K+2)-th clock signal line away from the display region coincide, occurrence time periods of pulse signals of any two of the all even-numbered clock signal lines located on the side of the 2K-th clock signal line close to the display region coincide, and there is no overlap between an occurrence time period of a pulse signal of a y-th clock signal line and an occurrence time period of a pulse signal of a (2K+y)-th clock signal line, wherein $1 \leq y \leq 2K$. Exemplarily, when K=4, the all odd-numbered clock signal lines located on the side of the (2K+1)-th clock signal line away from the display region include the first clock signal line CLK1, the third clock signal line CLK3, the fifth clock signal line CLK5, and the seventh clock signal line CLK7, and occurrence time periods of pulse signals of any two of the first clock signal lines CLK1, the third clock signal line CLK3, the fifth clock signal line CLK5, and the seventh clock signal line CLK7 coincide. Any two of the all odd-numbered clock signal lines located on the side of the (2K-1)-th clock signal line close to the display region include the ninth clock signal line CLK9, the eleventh clock signal line CLK11, the thirteenth clock signal line CLK13, and the fifteenth clock signal line CLK15, and occurrence time periods of pulse signals of any two of the ninth clock signal line CLK9, the eleventh clock signal line CLK11, the thirteenth clock signal line CLK13, and the fifteenth clock signal line CLK15 coincide. The all even-numbered clock signal lines located on the side of the (2K+2)-th clock signal line away from the display region include the second clock signal line CLK2, the fourth clock signal line CLK4, the sixth clock signal line CLK6, and the eighth clock signal line CLK8, and occurrence time periods of pulse signals of any two of the second clock signal lines CLK2, the fourth clock signal line CLK4, the sixth clock signal line CLK6, and the eighth clock signal line CLK8 coincide. The all even-numbered clock signal lines located on the side of the 2K-th clock signal line close to the display region include the tenth clock signal line CLK10, the twelfth clock signal line CLK12, the fourteenth clock signal line CLK14,

and the sixteenth clock signal line CLK16, and occurrence time periods of pulse signals of any two of the tenth clock signal lines CLK10, the twelfth clock signal line CLK12, the fourteenth clock signal line CLK14, and the sixteenth clock signal line CLK16 coincide. There is no overlap between an occurrence time period of a pulse signal of the first clock signal line and an occurrence time period of a pulse signal of the ninth clock signal line, and there is no overlap between an occurrence time period of a pulse signal of the second clock signal line and an occurrence time period of a pulse signal of the tenth clock signal line.

In an exemplary implementation mode, quantities of rows of sub-pixels included in any two sub-display regions are the same, that is, the display substrate is uniformly divided.

In an exemplary implementation mode, when display modes of an i-th sub-display region and an (i+1)-th sub-display region are both the first display mode, a start time $STU_i$ of a signal of an i-th initial signal line and a start time $STU_{i+1}$ of a signal of an (i+1)-th initial signal line satisfy a following relational expression.

$$STU_{i+1} = STU_i + (N/M)*T*ovl$$

In an exemplary implementation mode, when the display modes of the i-th sub-display region and the (i+1)-th sub-display region are both the second display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/(M*A/B))*T*ovl$$

In an exemplary implementation mode, when the display modes of the i-th sub-display region and the (i+1)-th sub-display region are both the third display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/(M*A/C))*T*ovl$$

In an exemplary implementation mode, when a display mode of the i-th sub-display region is the first display mode and a display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/M)*T*ovl + (T1-T2)$$

In an exemplary implementation mode, when the display mode of the i-th sub-display region is the first display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/M)*T*ovl + (T1-T3)$$

In an exemplary implementation mode, when the display mode of the i-th sub-display region is the second display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/(M*A/B))*T*ovl - (T1-T2)$$

In an exemplary implementation mode, when the display mode of the i-th sub-display region is the second display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression.

$$STU_{i+1} = STU_i + (N/(M*A/B))*T*ovl + (T2-T3)$$

In an exemplary implementation mode, when the display mode of the i-th sub-display region is the third display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression.

$$STU_{i+1}= STU_i+(N/(M*A/C))*T*ovl-(T1-T3)$$

In an exemplary implementation mode, when the display mode of the i-th sub-display region is the third display mode and the display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression.

$$STU_{i+1}= STU_i+(N/(M*A/C))*T*ovl-(T2-T3)$$

Herein, T is a duration of a pulse signal of any one clock signal line, ovl is an overlapping time of pulse signals of two adjacent clock signal lines, A is a quantity of clock signal lines with different signals in the first display mode, B is a quantity of clock signal lines with different signals in the second display mode, B<A, C is a quantity of clock signal lines with different signals in the third display mode, C<A, T1 is a period of a pulse signal of any one clock signal line in the first display mode, T2 is a period of a pulse signal of any one clock signal line in the second display mode, and T3 is a period of a pulse signal of any one clock signal line in the third display mode.

In an exemplary implementation mode, when the display mode of the i-th sub-display region is the first display mode, and the display mode of the (i+1)-th sub-display region is the first display mode, STUi+1=STUi+2880H, wherein H is a time for scanning a row of sub-pixels. When the display mode of the i-th sub-display region is the second display mode, and the display mode of the (i+1)-th sub-display region is the second display mode, STUi+1=STUi+1440H. When the display mode of the i-th sub-display region is the third display mode, and the display mode of the (i+1)-th sub-display region is the third display mode, STUi+1=STUi+720H. When the display mode of the i-th sub-display region is the first display mode, and the display mode of the (i+1)-th sub-display region is the third display mode, STUi+1=STUi+2904H. When the display mode of the i-th sub-display region is the third display mode, and the display mode of the (i+1)-th sub-display region is the first display mode, STUi+1=STUi+696H. When the display mode of the i-th sub-display region is the first display mode, and the display mode of the (i+1)-th sub-display region is the second display mode, STUi+1=STUi+2896H. When the display mode of the i-th sub-display region is the second display mode, and the display mode of the (i+1)-th sub-display region is the first display mode, STUi+1=STUi+1424H.

In an exemplary implementation mode, a relational expression satisfied by the start time $STU_i$ of the signal of the i-th initial signal line and the start time $STU_{i+1}$ of the signal of the (i+1)-th initial signal line may ensure that cascade at a junction of adjacent sub-display regions is normal, so that the adjacent sub-display regions are not interrupted, and a display effect of the display substrate may be improved.

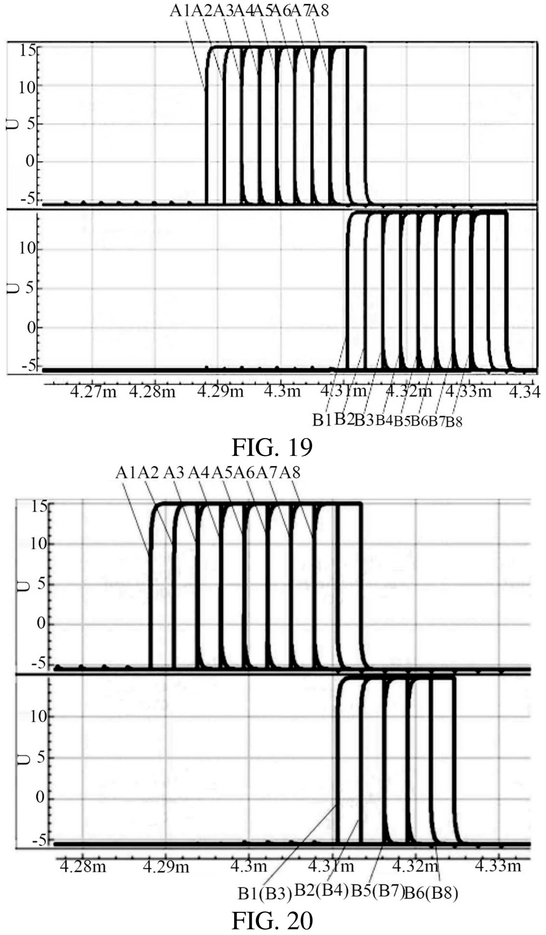

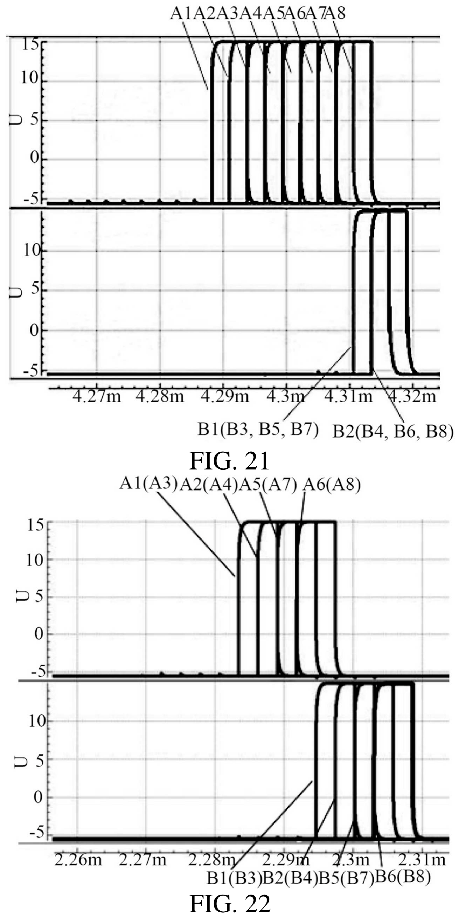

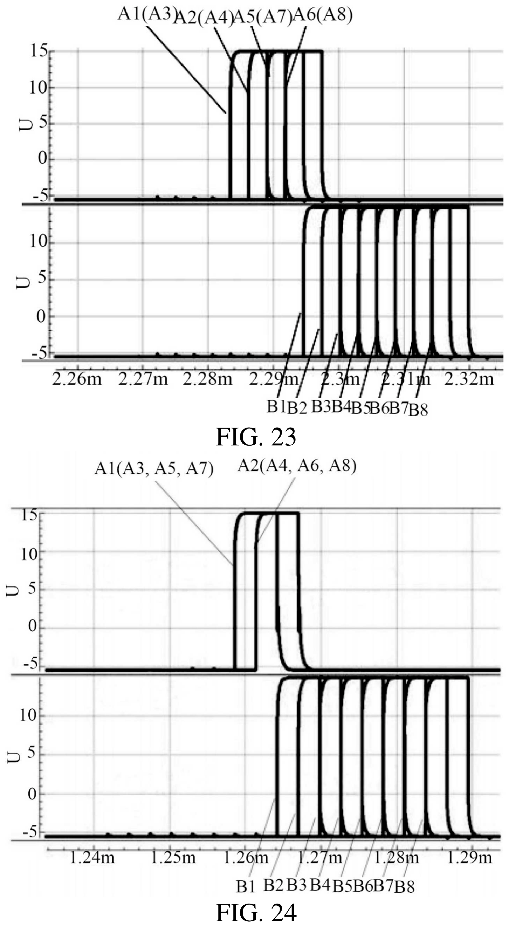

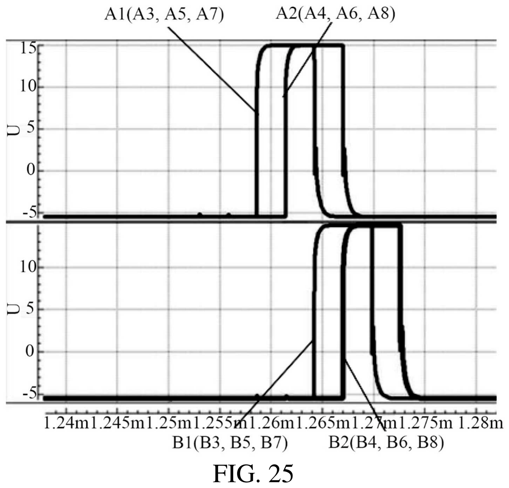

**In** an exemplary implementation mode, FIG. 19 is a first schematic diagram of comparison between output signals of output shift registers connected with last eight rows of sub-pixels in the i-th sub-display region and output signals of output shift registers connected with first eight rows of sub-pixels in the (i+1)-th sub-display region, FIG. 20 is a second schematic diagram of comparison between the output signals of output shift registers connected with the last eight rows of sub-pixels in the i-th sub-display region and the output signals of output shift registers connected with the first eight rows of sub-pixels in the (i+1)-th sub-display region, FIG. 21 is a third schematic diagram of comparison between the output signals of output shift registers connected with the last eight rows of sub-pixels in the i-th sub-display region and the output signals of output shift registers connected with the first eight rows of sub-pixels in the (i+1)-th sub-display region, FIG. 22 is a fourth schematic diagram of comparison between the output signals of output shift registers connected with the last eight rows of sub-pixels in the i-th sub-display region and the output signals of output shift registers connected with the first eight rows of sub-pixels in the (i+1)-th sub-display region, FIG. 23 is a fifth schematic diagram of comparison between the output signals of output shift registers connected with the last eight rows of sub-pixels in the i-th sub-display region and the output signals of output shift registers connected with the first eight rows of sub-pixels in the (i+1)-th sub-display region, FIG. 24 is a sixth schematic diagram of comparison between the output signals of output shift registers connected with the last eight rows of sub-pixels in the i-th sub-display region and the output signals of output shift registers connected with the first eight rows of sub-pixels in the (i+1)-th sub-display region, and FIG. 25 is a seventh schematic diagram of comparison between the output signals of output shift registers connected with the last eight rows of sub-pixels in the i-th sub-display region and the output signals of output shift registers connected with the first eight rows of sub-pixels in the (i+1)-th sub-display region. Herein, FIG. 19 is illustrated by taking an example in which the display mode of the i-th sub-display region is the first display mode and the display mode of the (i+1)-th sub-display region is the first display mode, FIG. 20 is illustrated by taking an example in which the display mode of the i-th sub-display region is the first display mode and the display mode of the (i+1)-th sub-display region is the second display mode, FIG. 21 is illustrated by taking an example in which the display mode of the i-th sub-display region is the first display mode and the display mode of the (i+1)-th sub-display region is the third display mode, FIG. 22 is illustrated by taking an example in which the display mode of the i-th sub-display region is the second display mode and the display mode of the (i+1)-th sub-display region is the second display mode, FIG. 23 is illustrated by taking an example in which the display mode of the i-th sub-display region is the second display mode and the display mode of the (i+1)-th sub-display region is the first display mode, FIG. 24 is illustrated by taking an example in which the display mode of the i-th sub-display region is the third display mode and the display mode of the (i+1)-th sub-display region is the first display mode, and FIG. 25 is illustrated by taking an example in which the display mode of the i-th sub-display region is the third display mode and the display mode of the (i+1)-th sub-display region is the third display mode. Herein, A1 is an output signal of an output shift register connected with an eighth row of sub-pixels counted from the bottom in the i-th sub-display region, A2 is an output signal of an output shift register connected with a seventh row of sub-pixels counted from the bottom in the i-th sub-display region, A3 is an output signal of an output shift register connected with a sixth row of sub-pixels counted from the bottom in the i-th sub-display region, A4 is an output signal of an output shift register connected with a fifth row of sub-pixels counted from the bottom in the i-th sub-display region, A5 is an output signal of an output shift register connected with a fourth row of sub-pixels counted from the bottom in the i-th sub-display region, A6 is an output signal of an output shift register connected with a third row of sub-pixels counted from the bottom in the i-th sub-display region, A7 is an output signal of an output shift register connected with a second row of sub-pixels counted from the bottom in the i-th sub-display region, A8 is an output signal of an output shift register connected with a first row of sub-pixels counted from the bottom in the i-th sub-display region, B1 is an output signal of an output shift register connected with a first row of sub-pixels in the (i+1)-th sub-display region, B2 is an output signal of an output shift register connected with a second row of sub-pixels in the (i+1)-th sub-display region, B3 is an output signal of an output shift register connected with a third row of sub-pixels in the (i+1)-th sub-display region, B4 is an output signal of an output shift register connected with a fourth row of sub-pixels in the (i+1)-th sub-display region, B5 is an output signal of an output shift register connected with a fifth row of sub-pixels in the (i+1)-th sub-display region, B6 is an output signal of an output shift register connected with a sixth row of sub-pixels in the (i+1)-th sub-display region, B7 is an output signal of an output shift register connected with a seventh row of sub-pixels in the (i+1)-th sub-display region, and B8 is an output signal of an output shift register connected with an eighth row of sub-pixels in the (i+1)-th sub-display region.

In an exemplary implementation mode, as shown in FIGs. 19 to 25, an occurrence time of an output signal of an output shift register connected with a last row of sub-pixels in the i-th sub-display region is overlapped with an occurrence time of an output signal of an output shift register connected with the first row of sub-pixels in the (i+1)-th sub-display region, and an overlapping time is half of an occurrence time period of the output signal of the output shift register connected with the last row of sub-pixels in the i-th sub-display region.

In an exemplary implementation mode, the first signal line includes a light emitting signal line configured to provide a drive current to a light emitting device.

In an exemplary implementation mode, for a same sub-display region, when u is a constant value, occurrence times when light emitting signal lines connected with pixel drive circuits of K rows of sub-pixels, in which K satisfies $3(u+l)$ +1, have effective level signals coincide, wherein u is an integer multiple of K, and $0 \leq l \leq K-1$. Exemplarily, $l=0, 1, 2, 3$, and when u=0, occurrence times when light emitting signal lines connected with pixel drive circuits of a first row of sub-pixels, a fourth row of sub-pixels, a seventh row of sub-pixels, and a tenth row of sub-pixels have effective level signals coincide, that is, the first row of sub-pixels, the fourth row of sub-pixels, the seventh row of sub-pixels, and the tenth row of sub-pixels simultaneously emit light.

In the present disclosure, for a same sub-display region, the occurrence times when the light emitting signal lines connected with the pixel drive circuits of the K rows of sub-pixels, in which K satisfies $3(u+l)+1$, have effective level signals coincide, so that K rows of sub-pixels of a same color may be simultaneously lit, and power consumption of the display substrate may be reduced.

In the exemplary implementation mode, when u is a constant value, occurrence times when light emitting signal lines connected with pixel drive circuits of K rows of sub-pixels, in which K satisfies $3(u+l)+2$, have effective level signals coincide. Exemplarily, $l=0, 1, 2, 3$, and when u=0, occurrence times when light emitting signal lines connected with pixel drive circuits of a second row of sub-pixels, a fifth row of sub-pixels, an eighth row of sub-pixels, and an eleventh row of sub-pixels have effective level signals coincide, that is, the second row of sub-pixels, the fifth row of sub-pixels, the eighth row of sub-pixels, and the eleventh row of sub-pixels simultaneously emit light.

In the present disclosure, for a same sub-display region, the occurrence times when the light emitting signal lines connected with the pixel drive circuits of the K rows of sub-pixels, in which K satisfies $3(u+l)+2$, have effective level signals coincide, so that K rows of sub-pixels of a same color may be simultaneously lit, and power consumption of the display substrate may be reduced.

In the exemplary implementation mode, when u is a constant value, occurrence times when light emitting signal lines connected with pixel drive circuits of K rows of sub-pixels, in which K satisfies $3(u+l)+3$, have effective level signals coincide. Exemplarily, $l=0, 1, 2, 3$, and when u=0, occurrence times when light emitting signal lines connected with pixel drive circuits of a third row of sub-pixels, a sixth row of sub-pixels, a ninth row of sub-pixels, and a twelfth row of sub-pixels have effective level signals coincide, that is, the third row of sub-pixels, the sixth row of sub-pixels, the ninth row of sub-pixels, and the twelfth row of sub-pixels simultaneously emit light.

In the present disclosure, for a same sub-display region, the occurrence times when the light emitting signal lines connected with the pixel drive circuits of the K rows of sub-pixels, in which K satisfies 3(u+*l*)+3, have effective level signals coincide, so that K rows of sub-pixels of a same color may be simultaneously lit, and power consumption of the display substrate may be reduced.

In an exemplary implementation mode, an occurrence time when a light emitting signal line connected with a pixel drive circuit of a sub-pixel in a (3u+1)-th row has an effective level signal is earlier than an occurrence time when a light emitting signal line connected with a pixel drive circuit of a sub-pixel in a (3u+2)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3)-th row has an effective level signal, the occurrence time when the light emitting signal line connected with the pixel drive circuit of the sub-pixel in the (3u+1)-th row has the effective level signal is earlier than an occurrence time when a light emitting signal line connected with a pixel drive circuit of a sub-pixel in a (3u+3K+1)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3K+2)-th row has an effective level signal, and the occurrence time when the light emitting signal line connected with the pixel drive circuit of the sub-pixel in the (3u+3)-th row has the effective level signal is earlier than an occurrence time when a light emitting signal line connected with a pixel drive circuit of a sub-pixel in a (3u+3K+3)-th row has an effective level signal.

In an exemplary implementation mode, configuration of signals of clock signal lines and light emitting signal lines in the present disclosure may realize that data signals are first provided to pixel drive circuits of K rows of sub-pixels of the first color, so that the K rows of sub-pixels of the first color emit light simultaneously, and then data signals are provided to pixel drive circuits of K rows of sub-pixels of the second color, so that the K rows of sub-pixels of the second color emit light simultaneously, and then data signals are provided to pixel drive circuits of K rows of sub-pixels of the third color, so that the K rows of sub-pixels of the third color emit light simultaneously. In the first display mode, data signals are sequentially provided to the pixel drive circuits of the K rows of sub-pixels of the first color, in the second display mode, data signals are sequentially provided to pixel drive circuits of first K/2 rows and last K/2 rows of sub-pixels of the first color, and in the third display mode, data signals are simultaneously provided to the pixel drive circuits of the K rows of sub-pixels of the first color.

Since colors of sub-pixels in a same row in the present disclosure are the same, and sub-pixels of different colors are sequentially arranged along a column square, a writing error of a data signal causes by inconsistency of Resistor-Capacitor (RC) loads due to different crossing lines when output signal lines of a drive circuit are connected with sub-pixels of different colors may be avoided, and reliability of the display substrate may be improved.

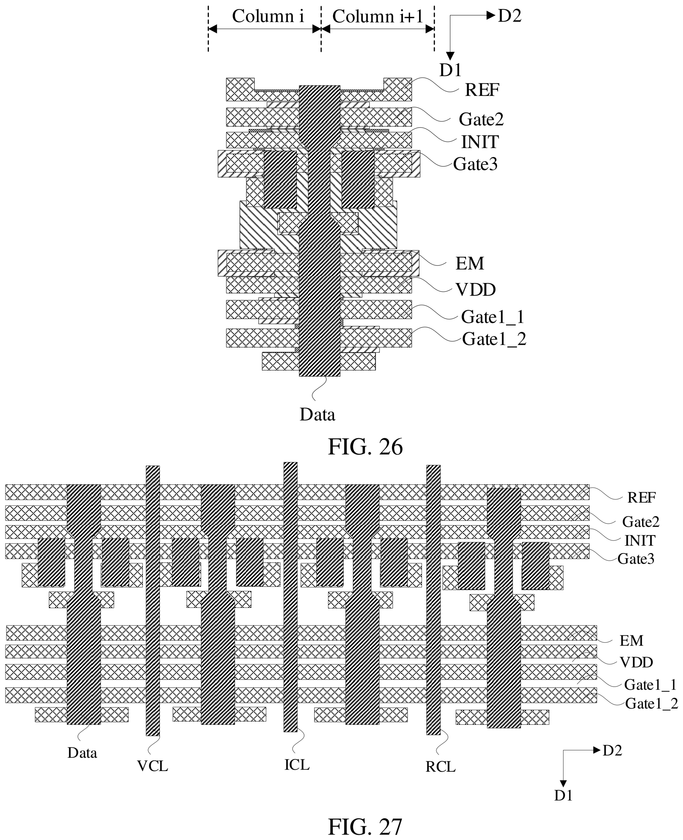

In an exemplary implementation mode, FIG. 26 is a first partial schematic diagram of a display region, and FIG. 27 is a schematic diagram of a part of a film layer of the display region. FIG. 26 shows two sub-pixels. As shown in FIG. 26, a first signal line may include a first scan signal line G1, a second scan signal line G2, a third scan signal line G3, and a light emitting signal line EM.

In an exemplary implementation mode, as shown in FIGs. 26 and 27, pixel drive circuits of sub-pixels located in a same row are connected with a same second scan signal line, a same third scan signal line, and a same light emitting signal line, and the pixel drive circuits of the sub-pixels located in the same row are electrically connected with two first scan signal lines.

In the exemplary implementation mode, as shown in FIG. 26, a pixel drive circuit of a sub-pixel located in an n-th row and an s-th column is connected with a first first scan signal line G1_1, a pixel drive circuit of a sub-pixel located in the n-th row and an (s+1)-th column is connected with a second first scan signal line G1_2, an odd-number-th stage output shift register is electrically connected with a first scan signal line, and an even-number-th stage output shift register is electrically connected with a second first scan signal line. Exemplarily, a first stage output shift register is electrically connected with a first first scan signal line connected with a sub-pixel in a first row, and a second stage output shift register is electrically connected with a second first scan signal line connected with a sub-pixel in the first row, wherein 1≤n≤N, 1≤s≤S, and S is a total number of columns of sub-pixels in the display region.

In an exemplary implementation mode, as shown in FIGs. 26 and 27, the display substrate may further include a reference signal line REF, an initial signal line INIT, and a first power supply line VDD at least partially located in the display region, wherein the reference signal line REF, the initial signal line INIT, and the first power supply line VDD extend along the second direction D2, and are electrically connected with first electrodes or second electrodes of some transistors in a pixel drive circuit.

In the exemplary implementation mode, as shown in FIGs. 26 and 27, for a sub-pixel in an n-th row, a reference signal line REF, a second scan signal line Gate2, an initial signal line INIT, a third scan signal line Gate3, a light emitting signal line EM, a first power supply line VDD, a first scan signal line Gate1_1, and a second first scan signal line Gate1_2 are sequentially arranged along the first direction D1, and the reference signal line REF is located on a side of the second scan signal line Gate2 close to a sub-pixel in an (n-1)-th row.

In an exemplary implementation mode, as shown in FIGs. 26 and 27, the display substrate may further include a second signal line electrically connected with a pixel drive circuit, and the second signal line extends along the first direction.

In an exemplary implementation mode, as shown in FIG. 26, the second signal line includes a data signal line Data, a power supply connection line VCL electrically connected with the first power supply line VDD, a reference connection line RCL electrically connected with the reference signal line REF, and an initial connection line ICL electrically connected with the initial signal line INIT.

In the present disclosure, an arrangement of the power supply connection line VCL may form a mesh structure with the first power supply line VDD, and display uniformity of the display substrate may be improved. Similarly, an arrangement of the reference connection line RCL may form a mesh structure with the reference signal line REF, and display uniformity of the display substrate may be improved. And an arrangement of the initial connection line ICL may form a mesh structure with the initial signal line INIT, and display uniformity of the display substrate may be improved.

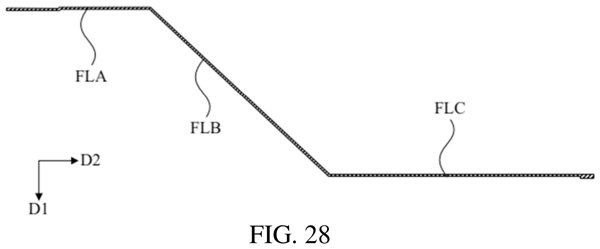

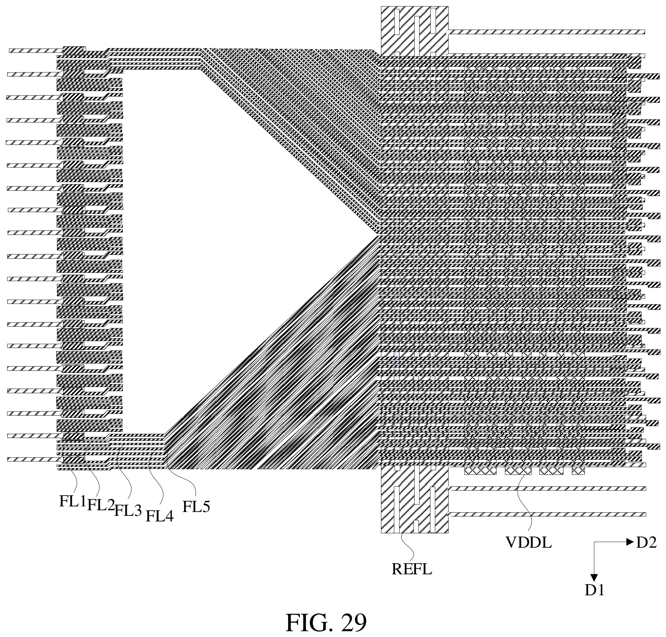

In an exemplary implementation mode, FIG. 28 is a schematic diagram of a structure of a fanout trace, and FIG. 29 is a schematic diagram of a structure of a non-display region. As shown in FIGs. 28 and 29, at least one fanout trace includes: a first fanout connection portion FLA, a second fanout connection portion FLB, and a third fanout connection portion FLC; wherein the first fanout connection portion FLA, the second fanout connection portion FLB, and the third fanout connection portion FLC are sequentially arranged along the second direction D2, and the first fanout connection portion FLA and the third fanout connection portion FLC extend along the second direction D2.

For an i-th sub-fanout region, the first fanout connection portion FLA is respectively electrically connected with an output terminal of an output drive circuit of an i-th drive circuit and the second fanout connection portion FLB, and the third fanout connection portion FLC is respectively electrically connected with a first signal line of an i-th sub-display region and the second fanout connection portion FLB. At least one sub-fanout region includes a first region and a second region arranged sequentially along the first direction, and an extension direction of a second fanout connection portion of a fanout trace located in the first region intersects with an extension direction of a second fanout connection portion of a fanout trace located in the second region.

In an exemplary implementation mode, as shown in FIG. 29, the fanout trace includes a first fanout trace FL1, a second fanout trace FL2, a third fanout trace FL3, a fourth fanout trace FL4, and a fifth fanout trace FL5. Herein, the first fanout trace FL1 is electrically connected with a first first scan signal line, the second fanout trace FL2 is electrically connected with a second first scan signal line, the third fanout trace FL3 is electrically connected with a second scan signal line, the fourth fanout trace FL4 is electrically connected with a third scan signal line, and the fifth fanout trace FL5 is electrically connected with a light emitting signal line.

In an exemplary implementation mode, as shown in FIG. 29, the display substrate may further include a reference signal electrical power supply line REFL and a first power source electrical power supply line VDDL located in the fanout region, wherein the first power source electrical power supply line VDDL is located on a side of the reference signal electrical power supply line REFL close to the display region, and the reference signal electrical power supply line REFL and the first power source electrical power supply line VDDL extend along the first direction D1. The reference signal electrical power supply line REFL is electrically connected with a reference signal line, and the first power source electrical power supply line VDDL is electrically connected with a first power supply line.

In an exemplary implementation mode, as shown in FIG. 29, an orthographic projection of the reference signal electrical power supply line REFL on the base substrate is at least partially overlapped with an orthographic projection of a third fanout connection portion of at least one fanout trace on the base substrate, and an orthographic projection of the first power source electrical power supply line REFL on the base substrate is at least partially overlapped with the orthographic projection of the third fanout connection portion of the at least one fanout trace on the base substrate. In the present disclosure, the reference signal electrical power supply line REFL and the first power source electrical power supply line REFL are orthogonal to the fanout trace, respectively, and an RC load of the fanout trace may be ensured to be consistent.

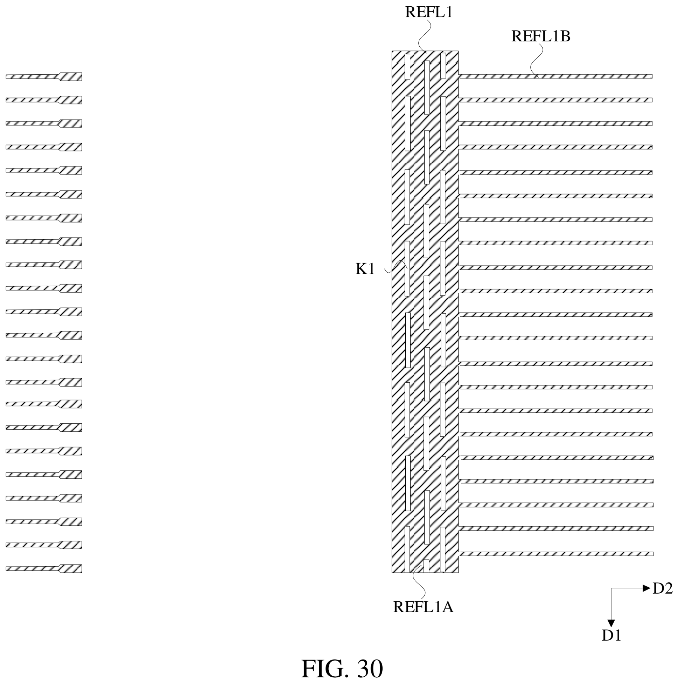

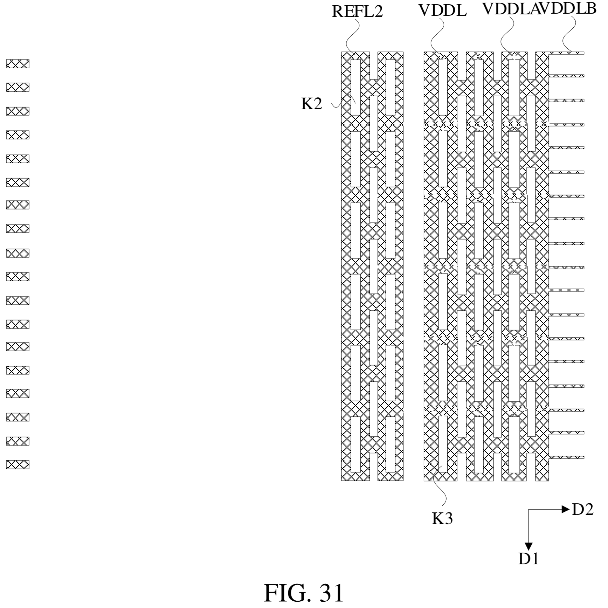

In an exemplary implementation mode, FIG. 30 is a first schematic diagram of a part of a film layer of a non-display region, and FIG. 31 is a second schematic diagram of a part of a film layer of a non-display region. As shown in FIGs. 29 to 31, a reference signal electrical power supply line may include a first sub-reference signal electrical power supply line REFL1 and a second sub-reference signal electrical power supply line REFL2 disposed in different layers and electrically connected with each other. The second sub-reference signal electrical power supply line REFL2 extends along the first direction D1, and an orthographic projection of the first sub-reference signal electrical power supply line REFL1 on the base substrate is at least partially overlapped with an orthographic projection of the second sub-reference signal electrical power supply line REFL2 on the base substrate.

In an exemplary implementation mode, as illustrated in FIG. 30, the first sub-reference signal electrical power supply line REFL1 includes a first signal main body line REFLA extending along the first direction D1 and a plurality of first signal connection lines REFLB extending along the second direction D2. The plurality of first signal connection lines REFLB extending along the second direction D2 are electrically connected with the first signal main body line REFLA.

In an exemplary implementation mode, as illustrated in FIG. 31, the first power source electrical power supply line VDDL includes a second signal main body line VDDLA extending along the first direction D1 and a plurality of second signal connection lines VDDLB extending along the second direction D2. The plurality of second signal connection lines VDDLB extending along the second direction D2 are electrically connected with the second signal main body line VDDLA.

In an exemplary implementation mode, as shown in FIG. 30, the first sub-reference signal electrical power supply line REFL1 is provided with a plurality of first openings K1 disposed in the first signal main body line REFLA of the first sub-reference signal electrical power supply line REFL1.

In an exemplary implementation mode, as shown in FIG. 31, the second sub-reference signal electrical power supply line REFL2 is provided with a plurality of second openings K2.

In an exemplary implementation mode, as shown in FIG. 31, the first power source electrical power supply line VDDL is provided with a plurality of third openings K3.

In an exemplary implementation mode, as shown in FIGs. 29 to 31, an orthographic projection of at least one of a first opening K1 and a second opening K2 on the base substrate is at least partially overlapped with an orthographic projection of a third fanout connection portion on the base substrate, and an orthographic projection of a third opening K3 on the base substrate is at least partially overlapped with the orthographic projection of the third fanout connection portion on the base substrate.

In an exemplary implementation mode, an arrangement of the first opening K1, the second opening K2, and the third opening K3 may reduce capacitance between the reference signal electrical power supply line REFL and the fanout trace and capacitance between the first power source electrical power supply line VDDL and the fanout trace.

In an exemplary implementation mode, the display substrate further includes: a circuit structure layer disposed on the base substrate, the circuit structure layer includes a first conductive layer, a second conductive layer, a third conductive layer, and a fourth conductive layer, wherein the pixel drive circuit further includes a capacitor, and the capacitor includes a first electrode plate and a second electrode plate; the first conductive layer includes gate electrodes of a plurality of transistors and the first electrode plate of the capacitor; the second conductive layer includes the second electrode plate of the capacitor and a first sub-reference electrical power supply line; the third conductive layer includes a first scan signal line, a second scan signal line, a third scan signal line, a light emitting signal line, an initial signal line, a reference signal line, a first power supply line, a second sub-reference electrical power supply line, and a first power source electrical power supply line; the fourth conductive layer includes at least a data signal line, a fanout trace, a power supply connection line, a reference connection line, and an initial connection line.

In an exemplary implementation mode, the circuit structure layer further includes a semiconductor layer located on a side of the first conductive layer close to the base substrate. The semiconductor layer at least includes active layers of the plurality of transistors.

Exemplary description is made below through a preparation process of a display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition. Coating may be any one or more of spray coating, spin coating, and inkjet printing. A "thin film" refers to a layer of thin film made of a certain material on a base substrate using deposition, coating, or other processes. If the "thin film" does not need to be processed through a patterning process in an entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are disposed in a same layer" in the present disclosure means that A and B are formed simultaneously through a same patterning process, and a "thickness" of a film layer is a dimension of the film layer in a direction perpendicular to a display substrate. In an exemplary implementation mode of the present disclosure, "an orthographic projection of B is located within a range of an orthographic projection of A" or "an orthographic projection of A contains an orthographic projection of B" refers to that a boundary of the orthographic projection of B falls within a range of a boundary of the orthographic projection of A, or the boundary of the orthographic projection of A is overlapped with the boundary of the orthographic projection of B.

A preparation process of a display substrate according to an exemplary embodiment may include following acts.

(1) Forming a pattern of a semiconductor layer. In an exemplary implementation mode, forming a pattern of a semiconductor layer may include: sequentially depositing a first insulation thin film and a semiconductor thin film on a base substrate, and patterning the semiconductor thin film through a patterning process to form a first insulation layer that covers the base substrate, and a pattern of a semiconductor layer located on the first insulation layer,

In an exemplary implementation mode, the pattern of the semiconductor layer may include at least an active layer of a first transistor and an active layer of a fifth transistor located in at least one sub-pixel.

(2) Forming a pattern of a first conductive layer. In an exemplary implementation mode, forming a pattern of a first conductive layer may include: sequentially depositing a second insulation thin film and a first conductive thin film on the base substrate on which the aforementioned pattern is formed, and patterning the first conductive thin film through a patterning process to form a second insulation layer that covers the pattern of the semiconductor layer and the pattern of the first conductive layer disposed on the second insulation layer. In an exemplary implementation mode, the first conductive layer may be referred to as a first gate metal (GATE1) layer.

In an exemplary implementation mode, the pattern of the first conductive layer may include at least a gate electrode of a first transistor, a gate electrode of a second transistor, a gate electrode of a third transistor, a gate electrode of a fourth transistor, a gate electrode of a fifth transistor, and a first electrode plate of a capacitor located in at least one sub-pixel.

In an exemplary implementation mode, after the pattern of the first conductive layer is formed, a conductive treatment may be performed on the semiconductor layer by using the first conductive layer as a shield. The semiconductor layer, in a region which is shielded by the first conductive layer, forms a channel region of an active layer of the first transistor to a channel region of an active layer of the fifth transistor, and the semiconductor layer, in a region which is not shielded by the first conductive layer, is made to be conductive.

(3) Forming a pattern of a second conductive layer, includes: sequentially depositing a third insulation thin film and a second conductive thin film on the base substrate on which the aforementioned patterns are formed, and patterning the third insulation thin film and the second conductive thin film through a patterning process, to form the third insulation layer and the pattern of the second conductive layer located on the third insulation layer. In an exemplary implementation mode, the second conductive layer may be referred to as a second gate metal (GATE2) layer.

In an exemplary implementation mode, the pattern of the second conductive layer may include at least a second electrode plate of a capacitor located in at least one sub-pixel and a first sub-reference electrical power supply line.

(4) Forming a pattern of a fourth insulation layer, includes: depositing a fourth insulation thin film on the base substrate on which the aforementioned patterns are formed, and patterning the fourth insulation thin film through a patterning process, to form the pattern of the fourth insulation layer that covers the aforementioned patterns, wherein the fourth insulation layer is provided with patterns of a plurality of via.

(5) Forming a pattern of a third conductive layer, includes: depositing a third conductive thin film on the base substrate on which the aforementioned patterns are formed, and patterning the third conductive thin film through a patterning process to form the pattern of the third conductive layer located on the fourth insulation layer. In an exemplary implementation mode, the third conductive layer may be referred to as a first source-drain metal (SD1) layer.

In an exemplary implementation mode, the pattern of the third conductive layer may include at least a first scan signal line, a second scan signal line, a third scan signal line, a light emitting signal line, a reference signal line, a first power supply line, an initial signal line, a second sub-reference electrical power supply line, and a first power source electrical power supply line, and a second electrode of a first transistor, a second electrode of a second transistor, a second electrode of a third transistor, and a first electrode and a second electrode of a fourth transistor located in at least one sub-pixel.

In an exemplary implementation mode, the first scan signal line, the second scan signal line, the third scan signal line, the light emitting signal line, the reference signal line, the first power supply line, and the initial signal line may be designed with an equal width or may be designed with non-equal widths, may be straight lines, or may be polylines, which may not only facilitate a layout of a pixel structure, but also reduce parasitic capacitance between signal lines, and the present disclosure is not limited thereto.

(6) Forming a pattern of a fifth insulation layer, includes: coating a first planarization thin film on the base substrate on which the aforementioned patterns are formed, patterning the first planarization thin film through a patterning process to form a first planarization layer, depositing a fifth insulation thin film on the first planarization layer, and patterning the fifth insulation thin film through a patterning process to form the pattern of the fifth insulation layer that covers the aforementioned patterns, wherein the pattern of the fifth insulation layer is provided with patterns of a plurality of via.

(7) Form a pattern of a fourth conductive layer, includes: depositing a fourth conductive thin film on the base substrate on which the aforementioned patterns are formed, and patterning the fourth conductive thin film through a patterning process to form the pattern of the fourth conductive layer. In an exemplary implementation mode, the fourth conductive layer may be referred to as a second source-drain metal (SD2) layer.

In an exemplary implementation mode, the pattern of the fourth conductive layer may include at least a data signal line, a fanout trace, a power supply connection line, an initial connection line, and a reference connection line.

(8) Forming a pattern of a second planarization layer, includes: depositing a sixth insulation thin film on the base substrate on which the aforementioned patterns are formed, patterning the sixth insulation thin film through a patterning process to form a sixth insulation layer that covers the aforementioned patterns, coating a second planarization thin film on the sixth insulation layer, and patterning the second planarization thin film through a patterning process to form the pattern of the second planarization layer that covers the aforementioned patterns.

So far, a drive structure layer has been prepared on the base substrate. **In** a plane parallel to the display substrate, the drive structure layer may include a plurality of pixel drive circuits, and a pixel drive circuit is connected with a first scan signal line, a second scan signal line, a third scan signal line, a light emitting signal line, a reference signal line, an initial signal line, a data signal line, and a first power supply line. The drive structure layer may be disposed on the base substrate. The drive structure layer may include a first insulation layer, a semiconductor layer, a second insulation layer, a first conductive layer, a third insulation layer, a second conductive layer, a fourth insulation layer, a third conductive layer, a first planarization layer, a fifth insulation layer, a fourth conductive layer, a sixth insulation layer, and a second planarization layer, which are disposed sequentially on the base substrate.

In an exemplary implementation mode, the semiconductor layer may be an amorphous silicon layer, a polycrystalline silicon layer, or a metal oxide layer. Herein, the metal oxide layer may be an oxide including indium and tin, an oxide including tungsten and indium, an oxide including tungsten, indium, and zinc, an oxide including titanium and indium, an oxide including titanium, indium, and tin, an oxide including indium and zinc, an oxide including silicon, indium, and tin, or an oxide including indium or gallium and zinc. The metal oxide layer may be a single layer, a double-layer, or a multi-layer.

In an exemplary implementation mode, the first conductive layer, the second conductive layer, the third conductive layer, and the fourth conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo.

In an exemplary implementation mode, the first insulation layer, the second insulation layer, the third insulation layer, the fourth insulation layer, the fifth insulation layer, and the sixth insulation layer may be made of any one or more of Silicon Oxide (SiOx), Silicon Nitride (SiNx), and Silicon Oxynitride (SiON), and may be a single layer, a multi-layer, or a composite layer.

In an exemplary implementation mode, the first planarization layer and the second planarization layer may be made of an organic material, such as a resin.

In an exemplary implementation mode, after preparation of the drive structure layer is completed, a light emitting structure layer is prepared on the drive structure layer, and a preparation process of the light emitting structure layer may include following operations.

(9) Forming a pattern of a fifth conductive layer. In an exemplary implementation mode, forming the pattern of the fifth conductive layer may include: depositing a fifth conductive thin film on the base substrate on which the aforementioned patterns are formed, and patterning the fifth conductive thin film through a patterning process to form a fifth conductive layer disposed on the second planarization layer, wherein the fifth conductive layer at least includes patterns of a plurality of first electrodes.

In an exemplary implementation mode, for the fifth conductive layer, a single-layer structure is adopted, such as Indium Tin Oxide (ITO) or Indium Zinc Oxide (IZO), or a multi-layer composite structure may be adopted, such as ITO/Ag/ITO.

(10) Forming a pattern of a sixth conductive layer. In an exemplary implementation mode, forming the sixth conductive layer may include: coating a pixel definition thin film on the base substrate on which the aforementioned patterns are formed, depositing the pixel definition thin film on the base substrate on which the aforementioned patterns are formed, patterning the pixel definition thin film through a patterning process to form a pattern of a pixel definition layer exposing the pattern of the fifth conductive layer, coating an organic light emitting material on the base substrate on which the pattern of the pixel definition layer is formed, patterning the organic light emitting material through a patterning process to form a pattern of an organic structure layer, depositing a sixth conductive thin film on the base substrate on which the pattern of the organic material layer is formed, and patterning the sixth conductive thin film through a patterning process to form the sixth conductive layer.

In an exemplary implementation mode, a subsequent preparation process may include: forming an encapsulation structure layer on the sixth conductive layer, wherein the encapsulation structure layer may include a first encapsulation layer, a second encapsulation layer, and a third encapsulation layer which are stacked. The first encapsulation layer and the third encapsulation layer may be made of an inorganic material, the second encapsulation layer may be made of an organic material, and the second encapsulation layer is disposed between the first encapsulation layer and the third encapsulation layer, which may ensure that external water vapor cannot enter the light emitting structure layer.

In an exemplary implementation mode, the organic structure layer may at least include: an organic emitting layer of a light emitting device.

In an exemplary implementation mode, the sixth conductive layer may at least include: second electrodes (cathodes) of a plurality of light emitting devices.

In an exemplary implementation mode, the sixth conductive layer may be made of a metal material, such as any one or more of Argentum (Ag), Copper (Cu), Aluminum (Al), and Molybdenum (Mo), or a conductive alloy material described above, such as an Aluminum Neodymium alloy (AlNd) or a Molybdenum Niobium alloy (MoNb), and may be of a single-layer structure or a multi-layer composite structure, such as Mo/Cu/Mo.. Exemplarily, the fourth conductive layer may be of a three-layer stacked structure formed of titanium, aluminum, and titanium.

The display substrate according to the embodiment of the present disclosure may be applied to a display product with any resolution.

An embodiment of the present disclosure also provides a display apparatus including a display substrate.

The display substrate is the display substrate according to any of the aforementioned embodiments, and has a similar implementation principle and implementation effect, which will not be repeated here.

In an exemplary implementation mode, the display apparatus may be any product or component with a display function, such as a liquid crystal panel, electronic paper, an OLED panel, an Active-Matrix Organic Light Emitting Diode (AMOLED) panel, a mobile phone, a tablet computer, a television, a display, a notebook computer, a digital photo frame, or a navigator.

The accompanying drawings of the present disclosure only involve structures involved in the embodiments of the present disclosure, and other structures may be referred to usual designs.

For the sake of clarity, a thickness and a size of a layer or a micro structure are enlarged in the accompanying drawings used for describing the embodiments of the present disclosure. It may be understood that when an element such as a layer, film, region, or substrate is described as being "on" or "under" another element, the element may be "directly" located "on" or "under" the another element, or there may be an intermediate element.

Although implementation modes of the present disclosure are disclosed above, contents described are only implementation modes used for ease of understanding of the present disclosure, but not intended to limit the present disclosure. Any of those skilled in the art of the present disclosure may make any modification and variation in forms and details of implementation without departing from the spirit and scope of the present disclosure. However, the scope of patent protection of the present disclosure should still be subject to the scope defined in the appended claims.

## Claims

1. A display substrate, comprising: a base substrate, wherein the base substrate comprises: a display region and a non-display region located on at least one side of the display region, the display region comprises M sub-display regions, a first sub-display region to an M-th sub-display region are arranged sequentially along a first direction, and the non-display region comprises a circuit region and a fanout region which are arranged along a second direction, the circuit region is located on a side of the fanout region away from the display region, the fanout region comprises M sub-fanout regions, a first sub-fanout region to an M-th sub-fanout region are arranged sequentially along the first direction, the first direction intersects with the second direction, and M>1;

   the display substrate further comprises: a plurality of sub-pixels and a first signal line which are located in the display region, a gate drive circuit and M initial signal lines which are located in the circuit region, and a fanout trace located in the fanout region, wherein the gate drive circuit comprises M drive circuits, a first drive circuit to an M-th drive circuit are arranged sequentially along the first direction, the first signal line extends along the second direction, the initial signal lines extend along the first direction, and the fanout trace extends at least partially along the second direction;
   a sub-pixel comprises: a pixel drive circuit comprising a plurality of transistors, and the first signal line is electrically connected with gate electrodes of at least some transistors;
   an i-th drive circuit is respectively electrically connected with an i-th initial signal line and a fanout trace located in an i-th sub-fanout region, and the fanout trace located in the i-th sub-fanout region is electrically connected with a first signal line located in an i-th sub-display region, wherein $1 \leq i \leq M$.

2. The display substrate according to claim 1, wherein the sub-pixel comprises: a first color sub-pixel, a second color sub-pixel, and a third color sub-pixel;
   wherein a sub-pixel in a (3m-2)-th row is a first color sub-pixel, a sub-pixel in a (3m-1)-th row is a second color sub-pixel, a sub-pixel in a 3m-th row is a third color sub-pixel, $1 \leq m \leq N/3$, and N is a total number of rows of sub-pixels in the display region.

3. The display substrate according to claim 1 or 2, wherein at least one drive circuit comprises: a first dummy drive circuit, an output drive circuit, and a second dummy drive circuit arranged sequentially along the first direction;
   a first dummy drive circuit of a j-th drive circuit is located on a side of an output drive circuit of the j-th drive circuit close to a (j-1)-th drive circuit, wherein 1<j≤M.

4. The display substrate according to claim 3, wherein the first dummy drive circuit comprises a plurality of cascaded first dummy shift registers, the output drive circuit comprises a plurality of cascaded output shift registers, and the second dummy drive circuit comprises a plurality of cascaded second dummy shift registers, and a first dummy shift register, an output shift register, and a second dummy shift register each comprises an input terminal and an output terminal; for the i-th drive circuit, an input terminal of at least one stage first dummy shift register is electrically connected with the i-th initial signal line, an input terminal of at least one stage output shift register is electrically connected with an output terminal of the at least one stage first dummy shift register, and an output terminal of the at least one stage output shift register is electrically connected with an input terminal of at least one stage second dummy shift register.

5. The display substrate according to claim 4, wherein for the i-th drive circuit, a quantity of the first dummy shift registers is Ri, a quantity of the output shift registers is Si, and a quantity of the second dummy shift registers is Ti; Ri<Si, Ti<Si, Si=2Mi, wherein Mi is a quantity of rows of sub-pixels in the i-th sub-display region.

6. The display substrate according to claim 5, further comprising: 4K clock signal lines located in the circuit region, wherein K≥4 and K is an even number; the clock signal lines extend along the first direction, and the 4K clock signal lines are arranged along the second direction;

$$Ri=4K \text{ or } 12K, Ti=4K \text{ or } 12K.$$

7. The display substrate according to claim 6, wherein for the i-th drive circuit, an output clock signal terminal of a (6p+1+4K*L)-th stage output shift register is electrically connected with a (2p+1)-th clock signal line, an output clock signal terminal of a (6p+3+4K*L)-th stage output shift register is electrically connected with a (2K+2p+1)-th clock signal line or a (2p+1-2K)-th clock signal line, an output clock signal terminal of a (6p+5+4K*L)-th stage output shift register is electrically connected with the (2p+1)-th clock signal line, an output clock signal terminal of a (6p+2+4K*L)-th stage output shift register is electrically connected with a (2p+2)-th clock signal line, an output clock signal terminal of a (6p+4+4K*L)-th stage output shift register is electrically connected with a (2K+2p+2)-th clock signal line or a (2p+2-2K)-th clock signal line, an output clock signal terminal of a (6p+6+4K*L)-th stage output shift register is electrically connected with the (2p+2)-th clock signal line, wherein 0≤L≤(Si/4K)-1, and 0≤p≤2K-1;

when 2p+1<2K, the output clock signal terminal of the (6p+3+4K*L)-th stage output shift register is electrically connected with the (2K+2p+1)-th clock signal line, and an output clock signal terminal of a (6p+4)-th stage output shift register is electrically connected with the (2K+2p+2)-th clock signal line; and
when 2p+1>2K, an output clock signal terminal of a (6p+3)-th stage output shift register is electrically connected with the (2p+1-2K)-th clock signal line, and an output clock signal terminal of a (6p+4)-th stage output shift register is electrically connected with the (2p+2-2K)-th clock signal line.

8. The display substrate according to claim 7, wherein when Ri=4K, an output clock signal terminal of an r-th stage first dummy shift register is electrically connected with an r-th clock signal line, wherein 1≤r≤4K;

when Ri=12K, an output clock signal terminal of a (6p+1)-th stage first dummy shift register is electrically connected with the (2p+1)-th clock signal line, an output clock signal terminal of a (6p+3)-th stage first dummy shift register is electrically connected with the (2K+2p+1)-th clock signal line or the (2p+1-2K)-th clock signal line, an output clock signal terminal of a (6p+5)-th stage first dummy shift register is electrically connected with the (2p+1)-th clock signal line, an output clock signal terminal of a (6p+2)-th stage first dummy shift register is electrically connected with the (2p+2)-th clock signal line, an output clock signal terminal of a (6p+4)-th stage first dummy shift register is electrically connected with the (2K+2p+2)-th clock signal line or the (2p+2-2K)-th clock signal line, and an output clock signal terminal of a (6p+6)-th stage first dummy shift register is electrically connected with the (2p+2)-th clock signal line;
when 2p+1<2K, the output clock signal terminal of the (6p+3)-th stage first dummy shift register is electrically connected with the (2K+2p+1)-th clock signal line, and the output clock signal terminal of the (6p+4)-th stage first dummy shift register is electrically connected with the (2K+2p+2)-th clock signal line;
when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

9. The display substrate according to claim 7 or 8, wherein when Ti=4K, an output clock signal terminal of a t-th second dummy shift register is electrically connected with a t-th clock signal line, wherein 1≤t≤4K;

when Ti=12K, an output clock signal terminal of a (6p+1)-th stage second dummy shift register is electrically connected with the (2p+1)-th clock signal line, an output clock signal terminal of a (6p+3)-th second dummy shift register is electrically connected with the (2K+2p+1)-th clock signal line or the (2p+1-2K)-th clock signal line, an output clock signal terminal of a (6p+5)-th stage second dummy shift register is electrically connected with the (2p+1)-th clock signal line, an output clock signal terminal of a (6p+2)-th stage second dummy shift register is electrically connected with the (2p+2)-th clock signal line, an output clock signal terminal of a (6p+4)-th second dummy shift register is electrically connected with the (2K+2p+2)-th clock signal line or the (2p+2-2K)-th clock signal line, and an output clock signal terminal of a (6p+6)-th second dummy shift register is electrically connected with the (2p+2)-th clock signal line;

when 2p+1<2K, the output clock signal terminal of the (6p+3)-th stage second dummy shift register is electrically connected with the (2K+2p+1)-th clock signal line, and the output clock signal terminal of the (6p+4)-th stage second dummy shift register is electrically connected with the (2K+2p+2)-th clock signal line;

when 2p+2>2K, the output clock signal terminal of the (6p+3)-th stage first dummy shift register is electrically connected with the (2p+1-2K)-th clock signal line, and the output clock signal terminal of the (6p+4)-th stage first dummy shift register is electrically connected with the (2p+2-2K)-th clock signal line.

10. The display substrate according to claim 5 or 6, wherein the first dummy shift register, the output shift register, and the second dummy shift register further comprises an output clock signal terminal, the output clock signal terminal is configured to provide an output signal to the output terminal, and for the i-th drive circuit, the output drive circuit comprises a first output drive circuit and a second output drive circuit;

the first output drive circuit comprises odd-numbered output shift registers arranged sequentially along the first direction, and output shift registers located in the first output drive circuit are cascaded with each other;

the second output drive circuit comprises even-numbered output shift registers arranged sequentially along the first direction, and output shift registers located in the second output drive circuit are cascaded with each other.

11. The display substrate according to claim 10, wherein for the i-th drive circuit, a first stage output shift register to an Si-th output shift register are sequentially arranged along the first direction, a first stage first dummy shift register to an Ri-th first dummy shift register are sequentially arranged along the first direction, a first stage second dummy shift register to a Ti-th second dummy shift register are sequentially arranged along the first direction, and a first clock signal line to a 4K-th shift register are sequentially arranged along the second direction and are located on a side of the drive circuit away from the display region.

12. The display substrate according to claim 10, wherein for the i-th drive circuit, an odd-number-th clock signal line is located on a side of the first output drive circuit away from the display region, and an even-number-th clock signal line is located on a side of the second output drive circuit away from the display region;

when the first output drive circuit is located on the side of the second output drive circuit away from the display region, the even-number-th clock signal line is located between the first output drive circuit and the second output drive circuit; and

when the second output drive circuit is located on the side of the first output drive circuit away from the display region, the odd-number-th clock signal line is located between the first output drive circuit and the second output drive circuit.

13. The display substrate according to claim 11 or 12, wherein a display mode of a sub-display region comprises a first display mode, a second display mode, and a third display mode, wherein a resolution of the first display mode is greater than a resolution of the second display mode, and the resolution of the second display mode is greater than a resolution of the third display mode;
a clock signal of any one clock signal line comprises a plurality of pulse signals, durations of pulse signals of any two clock signal lines are the same, periods of clock signals of any two clock signal lines are the same, and an occurrence time period of a pulse signal of a k-th clock signal line is overlapped with an occurrence time period of a pulse signal of a (k+1)-th clock signal line, wherein $1 \leq k \leq 4K$.

14. The display substrate according to claim 13, wherein when the display mode of the sub-display region is the first display mode, there is no overlap between occurrence time periods of pulse signals of any two clock signal lines of all odd-numbered clock signal lines located on a side of a (2K+1)-th clock signal line away from the display region, there is no overlap between occurrence time periods of pulse signals of any two clock signal lines of all odd-numbered clock signal lines located on a side of a (2K-1)-th clock signal line close to the display region, there is no overlap between occurrence time periods of pulse signals of any two clock signal lines of all even-numbered clock signal lines located on a side of a (2K+2)-th clock signal line away from the display region, and there is no overlap between occurrence time periods of pulse signals of any two clock signal lines of all even-numbered clock signal lines located on a side of a 2K-th clock signal line close to the display region;

when the display mode of the sub-display region is the second display mode, occurrence time periods of pulse signals of first K/2 clock signal lines of the all odd-numbered clock signal lines located on the side of the (2K+1)-th clock signal line away from the display region coincide, occurrence time periods of pulse signals of last K/2 clock signal lines of the all odd-numbered clock signal lines located on the side of the (2K+1)-th clock signal line away from the display region coincide, there is no overlap between occurrence time periods of pulse signals of a first clock signal line and a (K+1)-th clock signal line, occurrence time periods of pulse signals of first K/2 clock signal lines of the all odd-numbered clock signal lines located on the side of the (2K-1)-th clock signal line close to the display region coincide, occurrence time periods of pulse signals of last K/2 clock signal lines of the all odd-numbered clock signal lines located on the side of the (2K-1)-th clock signal line close to the display region coincide, there is no overlap between occurrence time periods of pulse signals of the (2K+1)-th clock signal line and a (3K+1)-th clock signal line, occurrence time periods of pulse signals of first K/2 clock signal lines of the all even-numbered clock signal lines located on the side of the (2K+2)-th clock signal line away from the display region coincide, occurrence time periods of pulse signals of last K/2 clock signal lines of the all even-numbered clock signal lines located on the side of the (2K+2)-th clock signal line away from the display region coincide, there is no overlap between occurrence time periods of pulse signals of a second clock signal line and a (K+2)-th clock signal line, and occurrence time periods of pulse signals of first K/2 clock signal lines of the all even-numbered clock signal lines located on the side of the 2K-th clock signal line close to the display region coincide, occurrence time periods of pulse signals of last K/2 clock signal lines of the all even-numbered clock signal lines located on the side of the 2K-th clock signal line close to the display region coincide, there is no overlap between occurrence time periods of pulse signals of the (2K+2)-th clock signal line and a (3K+2)-th clock signal line;
when the display mode of the sub-display region is the third display mode, occurrence time periods of pulse signals of any two clock signal lines of the all odd-numbered clock signal lines located on the side of the (2K+1)-th clock signal line away from the display region coincide, occurrence time periods of pulse signals of any two clock signal lines of the all odd-numbered clock signal lines located on the side of the (2K-1)-th clock signal line close to the display region coincide, occurrence time periods of pulse signals of any two clock signal lines of the all even-numbered clock signal lines located on the side of the (2K+2)-th clock signal line away from the display region coincide, occurrence time periods of pulse signals of any two clock signal lines of the all even-numbered clock signal lines located on the side of the 2K-th clock signal line close to the display region coincide, and there is no overlap between an occurrence time period of a pulse signal of a y-th clock signal line and an occurrence time period of a pulse signal of a (2K+y)-th clock signal line, wherein $1 \leq y \leq 2K$.

15. The display substrate according to claim 14, wherein quantities of rows of sub-pixels comprised in any two sub-display regions are the same;

when display modes of the i-th sub-display region and an (i+1)-th sub-display region are both the first display mode, a start time $STU_i$ of a signal of an i-th initial signal line and a start time $STU_{i+1}$ of a signal of an (i+1)-th initial signal line satisfy a following relational expression:

$$STU_{i+1} = STU_i + (N/M)*T*ovl$$

when the display modes of the i-th sub-display region and the (i+1)-th sub-display region are both the second display mode, the start time $STU_i$ of the signal of the i-th initial signal line and the start time $STU_{i+1}$ of the signal of the (i+1)-th initial signal line satisfy a following relational expression:

$$STU_{i+1} = STU_i + (N/(M*A/B))*T*ovl$$

when the display modes of the i-th sub-display region and the (i+1)-th sub-display region are both the third display mode, the start time $STU_i$ of the signal of the i-th initial signal line and the start time $STU_{i+1}$ of the signal of the (i+1)-th initial signal line satisfy a following relational expression:

$$STU_{i+1} = STU_i + (N/(M*A/C))*T*ovl$$

when a display mode of the i-th sub-display region is the first display mode and a display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/M)*T*ovl+(T1-T2)$$

when the display mode of the i-th sub-display region is the first display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/M)*T*ovl+(T1-T3)$$

when the display mode of the i-th sub-display region is the second display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/(M*A/B))*T*ovl-(T1-T2)$$

when the display mode of the i-th sub-display region is the second display mode and the display mode of the (i+1)-th sub-display region is the third display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/(M*A/B))*T*ovl+(T2-T3)$$

when the display mode of the i-th sub-display region is the third display mode and the display mode of the (i+1)-th sub-display region is the first display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/(M*A/C))*T*ovl-(T1-T3)$$

when the display mode of the i-th sub-display region is the third display mode and the display mode of the (i+1)-th sub-display region is the second display mode, the start time $STU_i$ of the signal of the i-th initial signal line and the start time $STU_{i+1}$ of the signal of the (i+1)-th initial signal line satisfy a following relational expression:

$$STU_{i+1}= STU_i+(N/(M*A/C))*T*ovl-(T2-T3)$$

wherein T is a duration of a pulse signal of any one clock signal line, ovl is an overlapping time of pulse signals of two adjacent clock signal lines, A is a quantity of clock signal lines with different signals in the first display mode, B is a quantity of clock signal lines with different signals in the second display mode, B<A, C is a quantity of clock signal lines with different signals in the third display mode, C<A, T1 is a period of a pulse signal of any one clock signal line in the first display mode, T2 is a period of a pulse signal of any one clock signal line in the second display mode, and T3 is a period of a pulse signal of any one clock signal line in the third display mode.

16. The display substrate according to claim 15, wherein an occurrence time of an output signal of an output shift register connected with a last row of sub-pixels in the i-th sub-display region is overlapped with an occurrence time of an output signal of an output shift register connected with a first row of sub-pixels in the (i+1)-th sub-display region, and an overlapping time is half of a duration of the output signal of the output shift register connected with the last row of sub-pixels in the i-th sub-display region.

17. The display substrate according to claim 16, wherein the first signal line comprises a light emitting signal line, and for a same sub-display region, when u is a constant value, occurrence times when light emitting signal lines connected with pixel drive circuits of K rows of sub-pixels, in which K satisfies $3(u+l)+1$, have effective level signals coincide, wherein u is an integer multiple of K, and $0 \le l \le K-1$;

when u is a constant value, occurrence times when light emitting signal lines connected with pixel drive circuits of K rows of sub-pixels, in which K satisfies 3(u+*l*)+2, have effective level signals coincide;

when u is a constant value, occurrence times when light emitting signal lines connected with pixel drive circuits of K rows of sub-pixels, in which K satisfies 3(u+*l*)+3, have effective level signals coincide;

an occurrence time when a light emitting signal line connected with a pixel drive circuit of a sub-pixel in a (3u+1)-th row has an effective level signal is earlier than an occurrence time when a light emitting signal line connected with a pixel drive circuit of a sub-pixel in a (3u+2)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3)-th row has an effective level signal, the occurrence time when the light emitting signal line connected with the pixel drive circuit of the sub-pixel in the (3u+1)-th row has the effective level signal is earlier than an occurrence time when a light emitting signal line connected with a pixel drive circuit of a sub-pixel in a (3u+3K+1)-th row has an effective level signal, the occurrence time when the light emitting signal line connected with the pixel drive circuit of the sub-pixel in the (3u+2)-th row has the effective level signal is earlier than an occurrence time when a light emitting signal line connected with a pixel drive circuit of a sub-pixel in a (3u+3K+2)-th row has an effective level signal, and the occurrence time when the light emitting signal line connected with the pixel drive circuit of the sub-pixel in the (3u+3)-th row has the effective level signal is earlier than an occurrence time when a light emitting signal line connected with a pixel drive circuit of a sub-pixel in a (3u+3K+3)-th row has an effective level signal.

18. The display substrate according to claim 1, wherein the first signal line comprises a first scan signal line, a second scan signal line, and a third scan signal line;

pixel drive circuits of sub-pixels located in a same row are connected with a same second scan signal line, a same third scan signal line, and a same light emitting signal line, and the pixel drive circuits of the sub-pixels located in the same row are electrically connected with two first scan signal lines, a pixel drive circuit of a sub-pixel located in an n-th row and an s-th column is connected with a first first scan signal line, a pixel drive circuit of a sub-pixel located in the n-th row and an (s+1)-th column is connected with a second first scan signal line, an odd-number-th stage output shift register is electrically connected with the first scan signal line, and an even-number-th stage output shift register is electrically connected with the second first scan signal line, wherein $1 \leq n \leq N$, $1 \leq s \leq S$, and S is a total number of columns of sub-pixels in the display region.

19. The display substrate according to claim 18, further comprising: a reference signal line, an initial signal line, and a first power supply line at least partially located in the display region, wherein the reference signal line, the initial signal line, and the first power supply line extend along the second direction, and are electrically connected with first electrodes or second electrodes of some transistors in the pixel drive circuit;

for a sub-pixel in an n-th row, a reference signal line, a second scan signal line, an initial signal line, a third scan signal line, a light emitting signal line, a first power supply line, a first scan signal line, and a second first scan signal line are sequentially arranged along the first direction, and the reference signal line is located on a side of the second scan signal line close to a sub-pixel in an (n-1)-th row.

20. The display substrate according to claim 19, further comprising: a second signal line electrically connected with the pixel drive circuit, wherein the second signal line extends along the first direction;

the second signal line comprises a data signal line, a power supply connection line, a reference connection line, and an initial connection line, wherein the power supply connection line is electrically connected with the first power supply line, the reference connection line is electrically connected with the reference signal line, and the initial connection line is electrically connected with the initial signal line.

21. The display substrate according to claim 20, wherein at least one fanout trace comprises a first fanout connection portion, a second fanout connection portion, and a third fanout connection portion; wherein the first fanout connection portion, the second fanout connection portion, and the third fanout connection portion are sequentially arranged along the second direction, and the first fanout connection portion and the third fanout connection portion extend along the second direction;

for an i-th sub-fanout region, the first fanout connection portion is respectively electrically connected with an output terminal of an output drive circuit of the i-th drive circuit and the second fanout connection portion, and the third fanout connection portion is respectively electrically connected with the first signal line of the i-th sub-display region and the second fanout connection portion; at least one sub-fanout region comprises a first region and a second region arranged sequentially along the first direction, and an extension direction of a second fanout connection portion of a fanout trace located in the first region intersects with an extension direction of a second fanout connection portion of a fanout trace located in the second region;

the fanout trace comprises a first fanout trace, a second fanout trace, a third fanout trace, a fourth fanout trace, and a fifth fanout trace arranged along the first direction;

the first fanout trace is electrically connected with a first first scan signal line, the second fanout trace is electrically connected with a second first scan signal line, the third fanout trace is electrically connected with a second scan signal line, the fourth fanout trace is electrically connected with a third scan signal line, and the fifth fanout trace is electrically connected with a light emitting signal line.

22. The display substrate according to claim 21, further comprising: a reference signal electrical power supply line and a first power source electrical power supply line located in the fanout region, wherein the first power source electrical power supply line is located on a side of the reference signal electrical power supply line close to the display region, the reference signal electrical power supply line and the first power source electrical power supply line extend along the first direction, the reference signal electrical power supply line is electrically connected with the reference signal line, and the first power source electrical power supply line is electrically connected with the first power supply line;

an orthographic projection of the reference signal electrical power supply line on the base substrate is at least partially overlapped with an orthographic projection of the third fanout connection portion of the at least one fanout trace on the base substrate, and an orthographic projection of the first power source electrical power supply line on the base substrate is at least partially overlapped with the orthographic projection of the third fanout connection portion of the at least one fanout trace on the base substrate.

23. The display substrate according to claim 22, wherein the reference signal electrical power supply line comprises: a first sub-reference signal electrical power supply line and a second sub-reference signal electrical power supply line disposed in different layers and electrically connected with each other; an orthographic projection of the first sub-reference signal electrical power supply line on the base substrate is at least partially overlapped with an orthographic projection of the second sub-reference signal electrical power supply line on the base substrate;

the first sub-reference signal electrical power supply line is provided with a plurality of first openings, the second sub-reference signal electrical power supply line is provided with a plurality of second openings, and the first power source electrical power supply line is provided with a plurality of third openings;

an orthographic projection of at least one of a first opening and a second opening on the base substrate is at least partially overlapped with the orthographic projection of the third fanout connection portion on the base substrate, and an orthographic projection of a third opening on the base substrate is at least partially overlapped with the orthographic projection of the third fanout connection portion on the base substrate.

24. The display substrate according to claim 23, further comprising: a circuit structure layer disposed on the base substrate, wherein the circuit structure layer comprises a first conductive layer, a second conductive layer, a third conductive layer, and a fourth conductive layer, wherein the pixel drive circuit further comprises a capacitor, and the capacitor comprises a first electrode plate and a second electrode plate;

the first conductive layer at least comprises gate electrodes of the plurality of transistors and the first electrode plate of the capacitor;

the second conductive layer at least comprises the second electrode plate of the capacitor and the first sub-reference electrical power supply line;

the third conductive layer at least comprises the first scan signal line, the second scan signal line, the third scan signal line, the light emitting signal line, the initial signal line, the reference signal line, the first power supply line, the second sub-reference electrical power supply line, and the first power source electrical power supply line;

the fourth conductive layer at least comprises the data signal line, the fanout trace, the power supply connection line, the reference connection line, and the initial connection line.

25. A display apparatus, comprising: a display substrate according to any one of claims 1 to 24.

FIG. 1

| | 200 | | | 100 | | | 200 | |

| | GOA1 | Fanout1 | AA1 | Fanout1 | GOA1 | |
| | GOA2 | Fanout2 | AA2 | Fanout2 | GOA2 | |
| | GOA3 | Fanout3 | AA3 | Fanout3 | GOA3 | |
| | GOA4 | Fanout4 | AA4 | Fanout4 | GOA4 | |
| | GOA5 | Fanout5 | AA5 | Fanout5 | GOA5 | |
| | GOA6 | Fanout6 | AA6 | Fanout6 | GOA6 | |
| | GOA7 | Fanout7 | AA7 | Fanout7 | GOA7 | |
| | GOA8 | Fanout8 | AA8 | Fanout8 | GOA8 | |
| | GOA9 | Fanout9 | AA9 | Fanout9 | GOA9 | |

FIG. 2

FIG. 3

FIG. 4A

FIG. 4B

FIG. 5A

FIG. 5B

FIG. 6

FIG. 7

FIG. 8

FIG. 9

CLK1 CLK3 CLK5 CLK7 CLK9 CLK11 CLK13 CLK15

CLK2 CLK4 CLK6 CLK8 CLK10 CLK12 CLK14 CLK16

D2

D1

| DUGOAi（1） |
| DUGOAi（3） |
| DUGOAi（5） |
| DUGOAi（7） |
| DUGOAi（9） |
| DUGOAi（11） |
| DUGOAi（13） |
| DUGOAi（15） |
| DUGOAi（17） |
| DUGOAi（19） |
| DUGOAi（21） |
| DUGOAi（23） |
| DUGOAi（25） |
| DUGOAi（27） |
| DUGOAi（29） |
| DUGOAi（31） |
| DUGOAi（33） |
| DUGOAi（35） |
| DUGOAi（37） |
| DUGOAi（39） |
| DUGOAi（41） |
| DUGOAi（43） |
| DUGOAi（45） |
| DUGOAi（47） |

| DUGOAi（2） |
| DUGOAi（4） |
| DUGOAi（6） |
| DUGOAi（8） |
| DUGOAi（10） |
| DUGOAi（12） |
| DUGOAi（14） |
| DUGOAi（16） |
| DUGOAi（18） |
| DUGOAi（20） |
| DUGOAi（22） |
| DUGOAi（24） |
| DUGOAi（26） |
| DUGOAi（28） |
| DUGOAi（30） |
| DUGOAi（32） |
| DUGOAi（34） |
| DUGOAi（36） |
| DUGOAi（38） |
| DUGOAi（40） |
| DUGOAi（42） |
| DUGOAi（44） |
| DUGOAi（46） |
| DUGOAi（48） |

FIG. 10

CLK1 CLK3 CLK5 CLK7 CLK9 CLK11 CLK13 CLK15

CLK2 CLK4 CLK6 CLK8 CLK10 CLK12 CLK14 CLK16

D2
D1

| DDGOAi（1） | DDGOAi（2） |
| DDGOAi（3） | DDGOAi（4） |
| DDGOAi（5） | DDGOAi（6） |
| DDGOAi（7） | DDGOAi（8） |
| DDGOAi（9） | DDGOAi（10） |
| DDGOAi（11） | DDGOAi（12） |
| DDGOAi（13） | DDGOAi（14） |
| DDGOAi（15） | DDGOAi（16） |
| DDGOAi（17） | DDGOAi（18） |
| DDGOAi（19） | DDGOAi（20） |
| DDGOAi（21） | DDGOAi（22） |
| DDGOAi（23） | DDGOAi（24） |
| DDGOAi（25） | DDGOAi（26） |
| DDGOAi（27） | DDGOAi（28） |
| DDGOAi（29） | DDGOAi（30） |
| DDGOAi（31） | DDGOAi（32） |
| DDGOAi（33） | DDGOAi（34） |
| DDGOAi（35） | DDGOAi（36） |
| DDGOAi（37） | DDGOAi（38） |
| DDGOAi（39） | DDGOAi（40） |
| DDGOAi（41） | DDGOAi（42） |
| DDGOAi（43） | DDGOAi（44） |
| DDGOAi（45） | DDGOAi（46） |
| DDGOAi（47） | DDGOAi（48） |

FIG. 11

CLK1 CLK2 CLK3 CLK4 CLK5 CLK6 CLK7 CLK8 CLK9 CLK10 CLK11 CLK12 CLK13 CLK14 CLK15 CLK16

STUi

| DUGOAi（1） |
| DUGOAi（2） |
| DUGOAi（3） |
| DUGOAi（4） |
| DUGOAi（5） |
| DUGOAi（6） |
| DUGOAi（7） |
| DUGOAi（8） |
| DUGOAi（9） |
| DUGOAi（10） |
| DUGOAi（11） |
| DUGOAi（12） |
| DUGOAi（13） |
| DUGOAi（14） |
| DUGOAi（15） |
| DUGOAi（16） |

D2

D1

## FIG. 12

CLK1 CLK2 CLK3 CLK4 CLK5 CLK6 CLK7 CLK8 CLK9 CLK10 CLK11 CLK12 CLK13 CLK14 CLK15 CLK16

| DDGOAi（1） |
| DDGOAi（2） |
| DDGOAi（3） |
| DDGOAi（4） |
| DDGOAi（5） |
| DDGOAi（6） |
| DDGOAi（7） |
| DDGOAi（8） |
| DDGOAi（9） |
| DDGOAi（10） |
| DDGOAi（11） |
| DDGOAi（12） |
| DDGOAi（13） |
| DDGOAi（14） |
| DDGOAi（15） |
| DDGOAi（16） |

D2

D1

## FIG. 13

FIG. 14

CLK1 CLK2 CLK3 CLK4 CLK5 CLK6 CLK7 CLK8 CLK9 CLK10 CLK11 CLK12 CLK13 CLK14 CLK15 CLK16

| DDGOAi (1) |
| DDGOAi (2) |
| DDGOAi (3) |
| DDGOAi (4) |
| DDGOAi (5) |
| DDGOAi (6) |
| DDGOAi (7) |
| DDGOAi (8) |
| DDGOAi (9) |
| DDGOAi (10) |
| DDGOAi (11) |
| DDGOAi (12) |
| DDGOAi (13) |
| DDGOAi (14) |
| DDGOAi (15) |
| DDGOAi (16) |
| DDGOAi (17) |
| DDGOAi (18) |
| DDGOAi (19) |
| DDGOAi (20) |
| DDGOAi (21) |
| DDGOAi (22) |
| DDGOAi (23) |
| DDGOAi (24) |
| DDGOAi (25) |
| DDGOAi (26) |
| DDGOAi (27) |
| DDGOAi (28) |
| DDGOAi (29) |
| DDGOAi (30) |
| DDGOAi (31) |
| DDGOAi (32) |
| DDGOAi (33) |
| DDGOAi (34) |
| DDGOAi (35) |
| DDGOAi (36) |
| DDGOAi (37) |
| DDGOAi (38) |
| DDGOAi (39) |
| DDGOAi (40) |
| DDGOAi (41) |
| DDGOAi (42) |
| DDGOAi (43) |
| DDGOAi (44) |
| DDGOAi (45) |
| DDGOAi (46) |
| DDGOAi (47) |
| DDGOAi (48) |

D2

D1

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FLA

FLB

FLC

D2

D1

FIG. 28

FIG. 29

REFL1

REFL1B

K1

REFL1A

D2

D1

FIG. 30

REFL2  VDDL  VDDLAVDDLB

K2

K3

D2

D1

FIG. 31

## INTERNATIONAL SEARCH REPORT

| International application No. |
| --- |
| **PCT/CN2024/088817** |

| A. | CLASSIFICATION OF SUBJECT MATTER |
| --- | --- |
| | G09G3/3225(2016.01)i |

According to International Patent Classification (IPC) or to both national classification and IPC

| B. | FIELDS SEARCHED |
| --- | --- |

Minimum documentation searched (classification system followed by classification symbols)

    IPC:G09G

Documentation searched other than minimum documentation to the extent that such documents are included in the fields searched

Electronic data base consulted during the international search (name of data base and, where practicable, search terms used)

    CNABS: CNTXT; CNKI; VEN; WOTXT; EPTXT; USTXT: 京东方, 显示基板, 基底, 衬底, 栅极驱动电路, 栅极驱动器, 扫描驱动器, 扫描驱动电路, 扇出区, 走线区, 布线区, 子显示区, 虚拟移位寄存器, 虚设移位寄存器, display, substrate, sub? area, gate driv+, GOA, fanout, dummy shift register

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 108919578 A (HKC CO., LTD. et al.) 30 November 2018 (2018-11-30)<br>description, paragraphs [0038]-[0075], and figures 1a-6 | 1-4, 18-25 |
| Y | WO 2022160160 A1 (BOE TECHNOLOGY GROUP CO., LTD.) 04 August 2022 (2022-08-04)<br>description, page 15 paragraph 5-page 41 paragraph 4, and figures 1-3 and 10-23 | 1-4, 18-25 |
| Y | CN 105719593 A (SHANGHAI AVIC OPTOELECTRONICS CO., LTD. et al.) 29 June 2016 (2016-06-29)<br>description, paragraphs [0039]-[0078], and figures 2-6 | 3, 4, 25 |
| A | CN 102637401 A (INNOCOM TECHNOLOGY (SHENZHEN) LTD. et al.) 15 August 2012 (2012-08-15)<br>entire document | 1-25 |
| A | CN 107561799 A (XIAMEN TIANMA MICRO-ELECTRONICS CO., LTD.) 09 January 2018 (2018-01-09)<br>entire document | 1-25 |

| ☑ Further documents are listed in the continuation of Box C. | ☑ See patent family annex. |
| --- | --- |

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 June 2024** | **09 July 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2024/088817** |

### C. DOCUMENTS CONSIDERED TO BE RELEVANT

| Category* | Citation of document, with indication, where appropriate, of the relevant passages | Relevant to claim No. |
| --- | --- | --- |
| A | CN 111812902 A (SHANGHAI AVIC OPTOELECTRONICS CO., LTD.) 23 October 2020 (2020-10-23) entire document | 1-25 |
| A | CN 114120905 A (HEFEI BOE ZHUOYIN TECHNOLOGY CO., LTD. et al.) 01 March 2022 (2022-03-01) entire document | 1-25 |
| A | CN 116137130 A (BOE TECHNOLOGY GROUP CO., LTD.) 19 May 2023 (2023-05-19) entire document | 1-25 |

Form PCT/ISA/210 (second sheet) (July 2022)

## INTERNATIONAL SEARCH REPORT
### Information on patent family members

| International application No. |
| --- |
| **PCT/CN2024/088817** |

| Patent document cited in search report | | | Publication date (day/month/year) | Patent family member(s) | | | Publication date (day/month/year) |
| --- | --- | --- | --- | --- | --- | --- | --- |
| CN | 108919578 | A | 30 November 2018 | None | | | |
| WO | 2022160160 | A1 | 04 August 2022 | None | | | |
| CN | 105719593 | A | 29 June 2016 | None | | | |
| CN | 102637401 | A | 15 August 2012 | CN | 102637401 | B | 24 June 2015 |
| CN | 107561799 | A | 09 January 2018 | None | | | |
| CN | 111812902 | A | 23 October 2020 | None | | | |
| CN | 114120905 | A | 01 March 2022 | None | | | |
| CN | 116137130 | A | 19 May 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310582804